(19) Europäisches Patentamt / European Patent Office / Office européen des brevets

(11) **EP 4 152 422 B1**

(12) **EUROPEAN PATENT SPECIFICATION**

(45) Date of publication and mention of the grant of the patent:
**22.04.2026 Bulletin 2026/17**

(21) Application number: **21197679.0**

(22) Date of filing: **20.09.2021**

(51) International Patent Classification (IPC):
***H10K 85/30*** *(2023.01)* *H10K 50/17* *(2023.01)*
*H10K 50/818* *(2023.01)* *H10K 101/00* *(2023.01)*
*H10K 102/10* *(2023.01)*

(52) Cooperative Patent Classification (CPC):
**H10K 85/30; H10K 50/818; H10K 85/331; H10K 85/371;** H10K 50/17; H10K 2101/00; H10K 2102/103; Y02E 10/549

(54) **AN ORGANIC ELECTRONIC DEVICE COMPRISING AN ANODE LAYER, A CATHODE LAYER, AT LEAST ONE PHOTOACTIVE LAYER, AND A SEMICONDUCTOR LAYER THAT COMPRISES A METAL COMPLEX**

ORGANISCHE ELEKTRONISCHE VORRICHTUNG MIT EINER ANODENSCHICHT, EINER KATHODENSCHICHT, MINDESTENS EINER PHOTOAKTIVEN SCHICHT UND EINER HALBLEITERSCHICHT MIT EINEM METALLKOMPLEX

DISPOSITIF ÉLECTRONIQUE ORGANIQUE COMPRENANT UNE COUCHE D'ANODE, UNE COUCHE DE CATHODE, AU MOINS UNE COUCHE PHOTOACTIVE ET UNE COUCHE SEMI-CONDUCTRICE QUI COMPREND UN COMPLEXE MÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.03.2023 Bulletin 2023/12**

(73) Proprietor: **Novaled GmbH**
**01099 Dresden (DE)**

(72) Inventors:
- **UVAROV, Vladimir**
  **01099 Dresden (DE)**
- **FURNO, Mauro**
  **01099 Dresden (DE)**

(74) Representative: **Michalski Hüttermann & Partner Patentanwälte mbB**
**Kaistraße 16A**
**40221 Düsseldorf (DE)**

(56) References cited:

| | |
|---|---|
| **EP-A1- 3 133 663** | **EP-A1- 3 883 003** |
| **EP-A1- 3 945 090** | **EP-A1- 3 945 125** |
| **DE-A1- 102015 121 844** | **US-A1- 2011 031 876** |

- **CINZIA FINAZZO ET AL: "Matrix effects on copper(ii)phthalocyanine complexes. A combined continuous wave and pulse EPR and DFT study", PHYSICAL CHEMISTRY CHEMICAL PHYSICS, vol. 8, no. 16, 1 January 2006 (2006-01-01), pages 1942, XP055754582, ISSN: 1463-9076, DOI: 10.1039/b516184c**
- **"Photoelectron Spectrophotometer in air. Surface Analyzer. Model AC-3", 11 June 2012 (2012-06-11), pages 1 - 6, XP055029420, Retrieved from the Internet <URL:http://www.rkiinstruments.com/pdf/AC3.pdf> [retrieved on 20120611]**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 152 422 B1

## Description

### Technical Field

The present invention relates an organic electronic device comprising an anode layer, a cathode layer, at least one photoactive layer, and a semiconductor layer that comprises a metal complex.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the organic semiconductor layers, such as the hole injection layer, and among them, may be affected by characteristics of the compounds contained in the organic semiconductor layer, such as hole transport compounds and metal complexes.

There remains a need to improve performance of organic electronic devices by providing organic semiconductor layers with improved performance, in particular to achieve improved operating voltage, higher external quantum efficiency and/or higher current efficiency.

EP 3 945 090 A1, published after the present application, discloses metal compounds as semiconductors for use in electronic devices, wherein the metal compound are represented by Formula I:

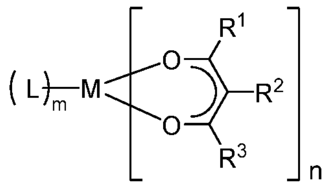
(I),

wherein

M is a metal;
L is a charge-neutral ligand, which coordinates to the metal M;
n is an integer selected from 1 to 4, which corresponds to the oxidation number of M;
m is an integer selected from 0 to 2;
$R^1$, $R^2$ and $R^3$ are independently selected from H, D, substituted or unsubstituted $C_1$ to $C_{12}$ alkyl, substituted or unsubstituted $C_1$ to $C_{12}$ alkoxy, substituted or unsubstituted $C_6$ to $C_{24}$ aryl, and substituted or unsubstituted $C_2$ to $C_{24}$ heteroaryl group, wherein
the at least one substituent is selected from halogen, F, Cl, CN, substituted or unsubstituted $C_1$ to $C_6$ alkyl, partially or fully fluorinated $C_1$ to $C_6$ alkyl, substituted or unsubstituted $C_1$ to $C_6$ alkoxy, partially or fully fluorinated $C_1$ to $C_6$ alkoxy, substituted or unsubstituted $C_6$ to $C_{18}$ aryl, and substituted or unsubstituted $C_2$ to $C_{18}$ heteroaryl, wherein
the substituents are selected from halogen, F, Cl, CN, $C_1$ to $C_6$ alkyl, $CF_3$, $OCH_3$ and $OCF_3$;
wherein
at least one $R^1$, $R^2$ and/or $R^3$ is selected from a substituted $C_2$ to $C_{24}$ heteroaryl group, wherein at least one substituent is selected from halogen, F, Cl, CN, partially or fully fluorinated $C_1$ to $C_6$ alkyl, partially or fully fluorinated $C_1$ to $C_6$ alkoxy.

EP 3 945 125 A1, published after the present application, discloses metal compounds as semiconductors for use in electronic devices, wherein the metal compound are represented by Formula I:

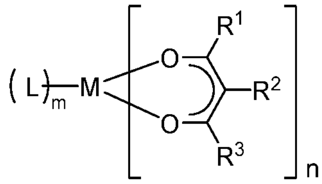 (I),

wherein

M is a metal;
L is a charge-neutral ligand, which coordinates to the metal M;
n is an integer selected from 1 to 4, which corresponds to the oxidation number of M;
m is an integer selected from 0 to 2;
$R^1$, $R^2$ and $R^3$ are independently selected from H, D, substituted or unsubstituted $C_1$ to $C_{12}$ alkyl, substituted or unsubstituted $C_1$ to $C_{12}$ alkoxy, substituted or unsubstituted $C_6$ to $C_{24}$ aryl, and substituted or unsubstituted $C_2$ to $C_{24}$ heteroaryl group, wherein
at least one substituent is selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl, wherein
the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, $CF_3$, $OCH_3$, $OCF_3$;
wherein
at least one $R^1$, $R^2$ and/or $R^3$ is selected from a substituted $C_6$ to $C_{24}$ aryl group, wherein at least one substituent of the substituted $C_6$ to $C_{24}$ aryl group is selected from CN and partially or fully fluorinated $C_1$ to $C_{12}$ alkyl.

EP 3 883 003 A1, published after the present application, relates to an organic electronic device comprising a substrate, an anode layer, a cathode layer, at least one first emission layer, and a hole injection layer, wherein

- the hole injection layer comprises a metal complex, wherein- the metal complex comprises at least one electropositive metal atom having an electro-negativity value according to Allen of less than 2.4, and- the metal complex comprises at least one anionic ligand comprising at least 4 covalently bound atoms;
- the anode layer comprises a first anode sub-layer 121 and a second anode sub-layer, wherein- the first anode sub-layer comprises a first metal having a work function in the range of ≥ 4 and ≤ 6 eV, and
- the second anode sub-layer comprises a transparent conductive oxide;
  wherein
- the hole injection layer is arranged between the first emission layer and the anode layer,-the first anode sub-layer is arranged closer to the substrate, and

the second anode sub-layer is arranged closer to the hole injection layer.

EP 4 064 379 A1, published after the present application, relates to an organic electronic device comprising an anode, a cathode, at least one photoactive layer, and at least one semiconductor layer; wherein the at least one semiconductor layer is arranged between the anode and at least one photoactive layer, wherein the at least one semiconductor layer comprises a compound comprising a metal M and at least one ligand L represented by the following formula

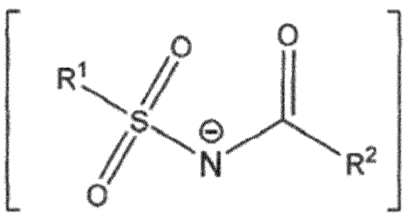,

wherein

$R^1$ is independently selected from a substituted or unsubstituted C1 to C20 alkyl, a substituted or unsubstituted C3 to

C20 carbocyclyl, a substituted or unsubstituted C2 to C20 heterocyclyl, a substituted or unsubstituted C6 to C20 aryl, or a substituted or unsubstituted C2 to C20 heteroaryl;
$R^2$ is independently selected from a substituted or unsubstituted C1 to C20 alkyl, a substituted or unsubstituted C3 to C20 carbocyclyl, a substituted or unsubstituted C2 to C20 heterocyclyl, a substituted or unsubstituted C6 to C20 aryl, or a substituted or unsubstituted C2 to C20 heteroaryl;
$R^1$ and $R^2$ can be connected via a direct bond; and
$R^1$ and/or $R^2$ taken together with the neighboring sulfur, nitrogen or carbon atom can form a ring, and the ring may be a substituted or unsubstituted ring or a substituted or unsubstituted polycyclic ring or substituted or unsubstituted condensed rings.

Document US 2011/031876 A1 discloses an organic optoelectronic device comprising an anode formed of ITO/Ag/ITO and a hole injection layer comprising copper phthalocyanine.

**DISCLOSURE**

An aspect of the present invention provides an organic electronic device comprising an anode layer, a cathode layer, at least one photoactive layer, and a semiconductor layer,

wherein the photoactive layer and the semiconductor layer are arranged between the anode layer and the cathode layer, wherein the semiconductor layer is arranged between the photoactive layer and the anode layer;
wherein the anode layer comprises a first anode sub-layer and a second anode sub-layer, wherein the first anode sub-layer comprises a first metal having a work function in the range of ≥ 4 and ≤ 6 eV, and the second anode sub-layer comprises a transparent conductive oxide (TCO);
wherein the second anode sub-layer is arranged closer to the semiconductor layer than the first anode sub layer;
wherein the semiconductor layer comprises at least one metal complex, wherein the metal complex comprises a metal cation and at least one anionic ligand, wherein the anionic ligand comprises at least four covalently bound atoms, and wherein the semiconductor layer comprises the metal complex in a range of ≥31 percent by weight to <100 percent by weight, based on the total weight of the semiconductor layer;
wherein the semiconductor layer is free of copper phthalocyanine.

It should be noted that throughout the application and the claims any $A^n$, $B^n$ , $R^n$, $Ar^n$, $X^n$, L, M, Q etc. always refer to the same moieties, unless otherwise noted.
In the present specification, when a definition is not otherwise provided, "partially fluorinated" refers to a $C_1$ to $C_8$ alkyl group in which only part of the hydrogen atoms are replaced by fluorine atoms.
In the present specification, when a definition is not otherwise provided, "perfluorinated" refers to a $C_1$ to $C_8$ alkyl group in which all hydrogen atoms are replaced by fluorine atoms.
In the present specification, when a definition is not otherwise provided, "substituted" refers to one substituted with a deuterium, $C_1$ to $C_{12}$ alkyl and $C_1$ to $C_{12}$ alkoxy.
In the present specification, when a definition is not otherwise provided, a substituted aryl group with at least 6 C-ring atoms can be substituted with 1, 2, 3, 4 or 5 substituents. For example a substituted $C_6$ aryl group may have 1, 2, 3, 4 or 5 phenyl substituents.
However, in the present specification "aryl substituted" refers to a substitution with one or more aryl groups, which themselves may be substituted with one or more aryl and/or heteroaryl groups.
Correspondingly, in the present specification "heteroaryl substituted" refers to a substitution with one or more heteroaryl groups, which themselves may be substituted with one or more aryl and/or heteroaryl groups.
In the present specification, when a definition is not otherwise provided, a substituted heteroaryl group with at least 2 C-ring atoms can be substituted with one or more substituents. For example a substituted $C_2$ heteroaryl group may have 1 or 2 substituents.
In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.
Specific examples of the alkyl group may be a methyl group, an ethyl group, a propyl group, an isopropyl group, a butyl group, an iso-butyl group, a sec-butyl group, a tert-butyl group, a pentyl group, a hexyl group.
The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

The term "charge-neutral" means that the corresponding group is overall electrically neutral.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, $C_1$ to $C_{12}$ alkyl, unsubstituted $C_6$ to $C_{18}$ aryl, and unsubstituted $C_3$ to $C_{18}$ heteroaryl.

In the present specification, when a substituent is not named, the substituent can be a H.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

As used herein, "percent by weight", "weight percent", "wt.-%", "% by weight", and variations thereof refer to a composition, component, substance or agent as the weight of that composition, component, substance or agent of the respective layer divided by the total weight of the composition thereof and multiplied by 100. It is understood that the total weight percent amount of all components, substances or agents of the respective are selected such that it does not exceed 100 wt.-%.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The term "at least two anode sub-layers" is understood to mean two or more anode sub-layers, for example two or three anode sub-layers.

The terms "cathode", "cathode layer" and "cathode electrode" are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the compound of formula (I) or the hole injection layer comprising a compound of formula (I), to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the context of the present invention, the term "sublimation " may refer to a transfer from solid state to gas phase or from liquid state to gas phase.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and

that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi [fluorene]-2,2',7,7'-tetraamine is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "- "symbol. According to one embodiment of the present invention, the HOMO level of the matrix compound of the hole injection layer may be calculated by quantum mechanical methods.

The work function of the first metal is measured in eV (electron volt). Tabulated values of work functions can be found for example in CRC Handbook of Chemistry and Physics version 2008, p. 12-114. Further, tabulated values of work functions can be found for example at https://en.wikipedia.org/wiki/Work_function#cite_note-12.

**Advantageous Effects**

Surprisingly, it was found that the organic electronic device of the present invention solves the problem underlying the present invention by enabling devices in various aspects superior over the organic electronic devices known in the art, in particular with respect to improved operating voltage, improved voltage stability over time and/or higher current efficiency

According to one embodiment of the present invention, the semiconductor layer comprises the metal complex in a range of ≥31 percent by weight to ≤90 percent by weight, based on the total weight of the semiconductor layer, preferably ≥31 percent by weight to ≤85 percent by weight, more preferably ≥31 percent by weight to ≤80 percent by weight, even more preferably ≥31 percent by weight to ≤75 percent by weight.

According to the claimed invention, the semiconductor layer is free of of metal phthalocyanine (Pc) or CuPc. According to one embodiment of the invention the layers of the organic electronic device are free of metal phthalocyanine or CuPc. Preferably, the semiconductor layer is free of ionic liquids, metal phthalocyanine, CuPc, HAT-CN, Pyrazino[2,3-f][1,10]phenanthroline-2,3-dicarbonitrile, $F_4$TCNQ, metal fluoride and/or metal oxides, wherein the metal in the metal oxide is selected from Re and/or Mo. More preferably, the semiconductor layer is free of free of ionic liquids, metal phthalocyanine, CuPc, HAT-CN, Pyrazino[2,3-f][1,10]phenanthroline-2,3-dicarbonitrile, $F_4$TCNQ, Tris(8-hydroxyquinolinato) aluminium, Molybdenum tris(1,2-bis(trifluoromethyl)ethane-1,2-dithiolene), metal fluoride and/or metal oxides, wherein the metal in the metal oxide is selected from Re and/or Mo.

According to one embodiment of the present invention, the metal complex is represented by formula (I)

$$Q_rM^{s\oplus}\ (L^{\ominus})_s \qquad (I)$$

wherein

M is a metal cation,
s is the valency of M;
L is an anionic ligand comprising at least 4 covalently bound atoms, wherein the anionic ligand comprises at least two atoms selected from carbon atoms,
s is an integer from 1 to 4;
Q is a charge-neutral ligand which coordinates to the metal cation M,
r is an integer selected from 0 to 2.

According to one embodiment of the present invention, r in formula (I) is an integer selected from 0 or 1, preferably 0.

According to one embodiment of the present invention, the metal complex is represented by formula (II)

$$M^{s\oplus}\ (L^{\ominus})_s \qquad (II)$$

wherein

M is a metal cation,

s is the valency of M,

L is an anionic ligand comprising at least 4 covalently bound atoms, wherein the anionic ligand comprises at least two atoms selected from carbon atoms,

s is an integer from 1 to 4.

According to one embodiment of the present invention, the charge neutral form of M has an electronegativity value according to Allen of less than 2.4.

According to one embodiment of the present invention, the metal cation M is selected from selected from alkali, alkaline earth, transition, rare earth metal or group III to V metal, preferably the metal cation M is selected from transition or group III to V metal; preferably the metal M is selected from Li(I), Na(I), K(I), Cs(I), Mg(II), Ca(II), Sr(II), Ba(II), Sc(III), Y(III), Ti(IV), V(III-V), Cr(III-VI), Mn(II), Mn(III), Fe(II), Fe(III), Co(II), Co(III), Ni(II), Cu(I), Cu(II), Zn(II), Ag(I), Au(I), Au(III), Al(III), Ga(III), In(III), Sn(II), Sn(IV), or Pb(II); preferably M is selected from Cu(II), Fe(III), Co(III), Mn(III), Ir(III), Bi(III); and more preferred M is selected from Fe(III) and Cu(II).

According to one embodiment of the present invention, the charge neutral ligand Q is selected from the group comprising $H_2O$, $C_2$ to $C_{40}$ mono- or multi-dentate ethers and $C_2$ to $C_{40}$ thioethers, $C_2$ to $C_{40}$ amines, $C_2$ to $C_{40}$ phosphine, $C_2$ to $C_{20}$ alkyl nitrile or $C_2$ to $C_{40}$ aryl nitrile, or a compound according to formula (II);

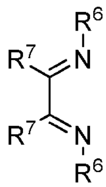
(II),

wherein $R^6$ and $R^7$ are independently selected from $C_1$ to $C_{20}$ alkyl, $C_1$ to $C_{20}$ heteroalkyl, $C_6$ to $C_{20}$ aryl, heteroaryl with 5 to 20 ring-forming atoms, halogenated or perhalogenated $C_1$ to $C_{20}$ alkyl, halogenated or perhalogenated $C_1$ to $C_{20}$ heteroalkyl, halogenated or perhalogenated $C_6$ to $C_{20}$ aryl, halogenated or perhalogenated heteroaryl with 5 to 20 ring-forming atoms, or at least one $R^6$ and $R^7$ are bridged and form a 5 to 20 member ring, or the two $R^6$ and/or the two $R^7$ are bridged and form a 5 to 40 member ring or form a 5 to 40 member ring comprising an unsubstituted or $C_1$ to $C_{12}$ substituted phenanthroline.

According to one embodiment of the present invention, the charge neutral ligand Q is selected from a group comprising:

- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted $C_1$ to $C_6$ alkyl, substituted or unsubstituted $C_1$ to $C_6$ alkoxy, alternatively two or more groups selected from halogen, F, CN, substituted or unsubstituted $C_1$ to $C_6$ alkyl, substituted or unsubstituted $C_1$ to $C_6$ alkoxy, at least one or more groups selected from halogen, F, CN, substituted $C_1$ to $C_6$ alkyl, substituted $C_1$ to $C_6$ alkoxy, alternatively two or more groups selected from halogen, F, CN, perfluorinated $C_1$ to $C_6$ alkyl, perfluorinated $C_1$ to $C_6$ alkoxy, one or more groups selected from substituted or unsubstituted $C_1$ to $C_6$ alkyl, substituted or unsubstituted $C_6$ to $C_{12}$ aryl, and/or substituted or unsubstituted $C_3$ to $C_{12}$ heteroaryl,

wherein the substituents are selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^3$, $COOR^3$, halogen, F or CN;

wherein $R^3$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy

According to one embodiment of the present invention, the anionic ligand L is a monoanionic ligand.

According to one embodiment of the present invention, the anionic ligand L is selected from formula (III)

$$(R^1)_a(A^1)_m\!-\!Z\!-\!(A^2)_n(R^2)_b \quad \text{(III)}$$

wherein

m, and n are independently selected from 0, 1;
m+n≥1;
a, and b are independently selected from 0, 1;
a+b≥1;
Z is selected from $CR^3$, N, or O;
if Z is O then a is 0 when m is 0 or b is o when n is 0;
$A^1$ and $A^2$ are independently selected from C=O, C-O, SO, or $SO_2$;
$A^1$ and $A^2$ together can form a cycle with Z;
$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for the case that $A^1$ and $A^2$ are selected from C=O or C-O, $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl;
wherein the substituents on $R^3$ is selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the anionic ligand L is selected from formula (III)

$$(R^1)_a(A^1)_m\!-\!Z\!-\!(A^2)_n(R^2)_b \quad \text{(III)}$$

wherein

m, and n are independently selected from 0, 1;
m+n≥1;
a, and b are independently selected from 0, 1;
a+b≥1;
Z is selected from $CR^3$, N, or O;
if Z is O then a is 0 when m is 0 or b is o when n is 0;
$A^1$ and $A^2$ are independently selected from C=O, C-O, SO, or $SO_2$;
$A^1$ and $A^2$ together can form a cycle with Z;
$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein the substituents on $R^1$ or $R^2$ are independently selected from halogen, F, Cl, CN, substituted or unsubstituted

$C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl;

wherein the substituents on $R^3$ is selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, if Z=N then a+b=2 and m+n=2.

According to one embodiment, Z is selected from $CR^3$ or N.

According to one embodiment, Z is selected from $CR^3$ or N, and wherein if Z=N then a+b=2 and m+n=2.

According to one embodiment of the present invention, the metal complex according to formula (I) is selected from one of the formulae (IVa) to (IVd):

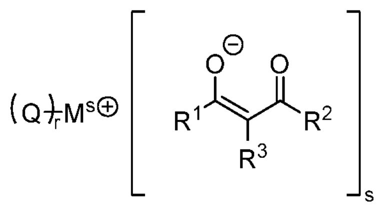 (IVa)

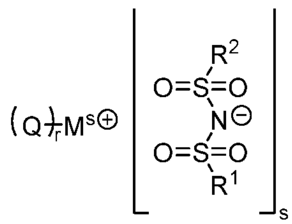 (IVb)

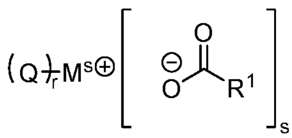 (IVc)

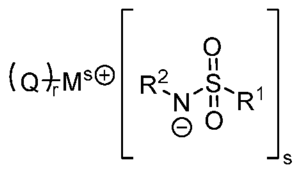 (IVd)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,

wherein for formula (IVa) $R^1$ and $R^2$ may also be selected from D or H,

wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or

substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (IVa) to (IVd):

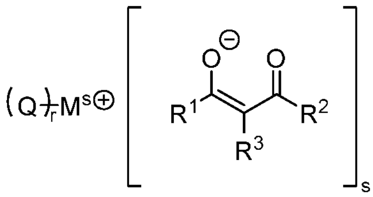 (IVa)

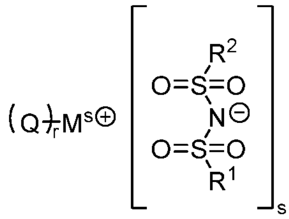 (IVb)

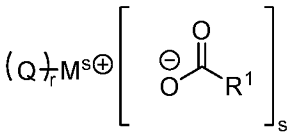 (IVc)

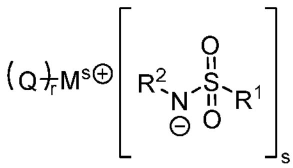 (IVd)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,

wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (IVa) to (IVc):

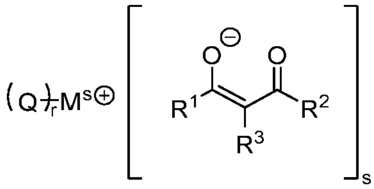 (IVa) 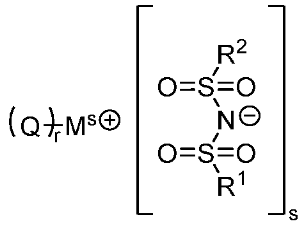 (IVb)

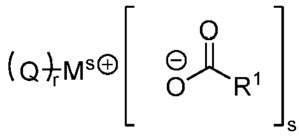 (IVc).

According to one embodiment of the present invention, the metal complex according to formula (I) is selected from one of the formulae (IVa) or (IVb):

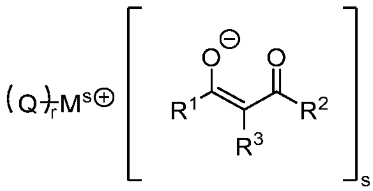 (IVa) 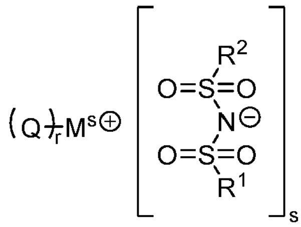 (IVb).

According to one embodiment of the present invention, the metal complex according to formula (I) is selected from formula (IVa):

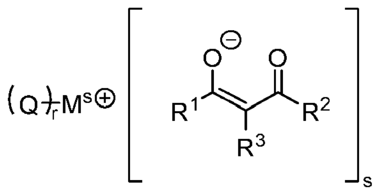 (IVa).

According to one embodiment of the present invention, r in formulae (IVa) to (IVd) is an integer selected from 0 or 1, preferably 0.

According to one embodiment of the present invention, the metal complex according to formula (I) is selected from one of the formulae (Va) to (Vd):

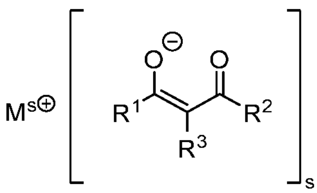 (Va) 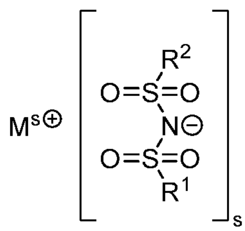 (Vb)

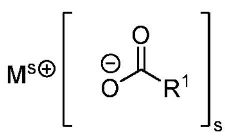 (Vc) 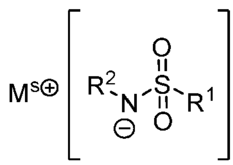 (Vd)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for formula (Va) $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (Va) to (Vd):

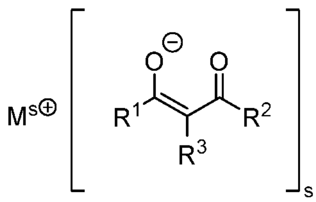
(Va)

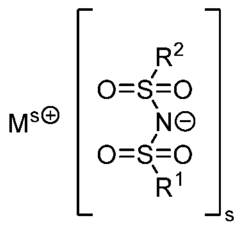
(Vb)

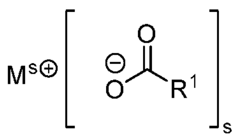
(Vc)

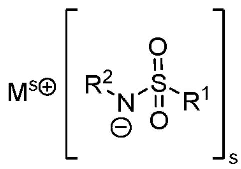
(Vd)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl, and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (Va) to (Vc):

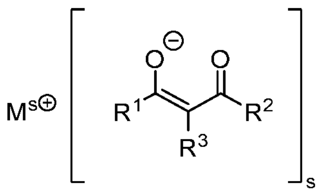 (Va) 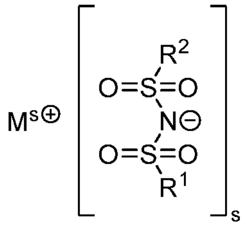 (Vb)

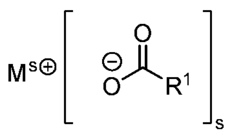 (Vc).

According to one embodiment of the present invention, the metal complex according to formula (I) is selected from one of the formulae (Va) or (Vb):

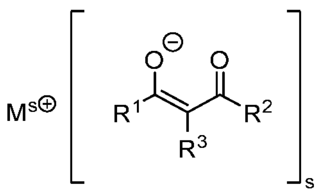 (Va) 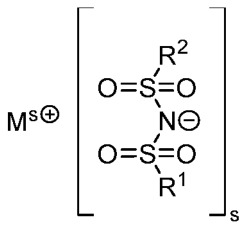 (Vb).

According to one embodiment of the present invention, the metal complex according to formula (I) is selected from formula (Va):

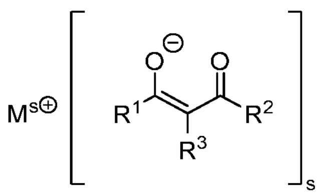 (Va).

According to one embodiment of the present invention, the anionic ligand L is selected from formula (VIa) to VId):

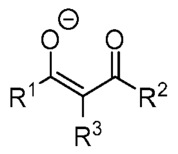 (VIa)

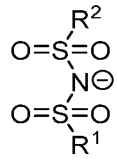 (VIb)

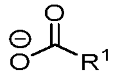 (VIc)

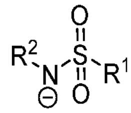 (VId)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for formula (VIa) $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the anionic ligand L is selected from formula (VIa) to VId):

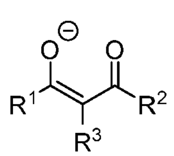 (VIa)

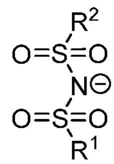 (VIb)

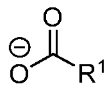 (VIc)

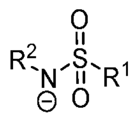 (VId)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein the substituents on $R^1$ or $R^2$ are independently selected from halogen, F, Cl, CN, substituted or unsubstituted

$C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the anionic ligand L is selected from formula (VIa) to VIc):

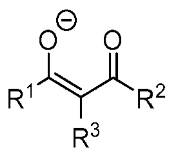 (VIa)

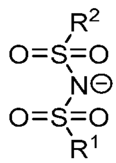 (VIb)

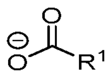 (VIc).

According to one embodiment of the present invention, the anionic ligand L is selected from formula (VIa) or VIb):

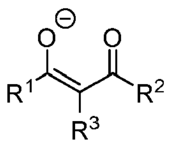 (VIa)

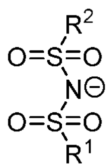 (VIb).

According to one embodiment of the present invention, the anionic ligand L is selected from formula (VIa):

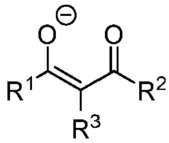 (VIa).

According to one embodiment of the present invention, the anionic ligand L is selected from one of the following formulae G1 to G140:

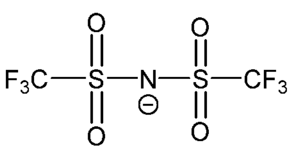 ,

(G1)

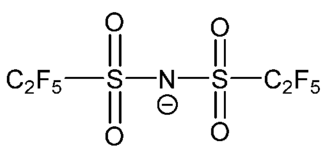 ,

(G2)

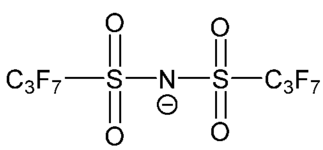 ,

(G3)

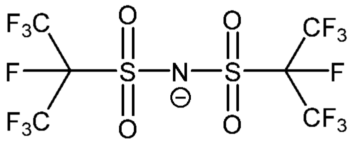,
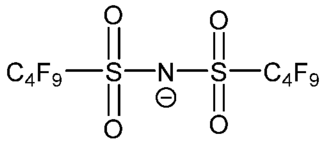,
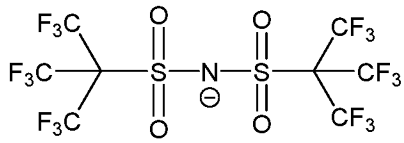,

(G4) (G5) (G6)

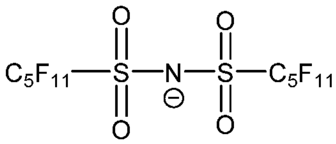,
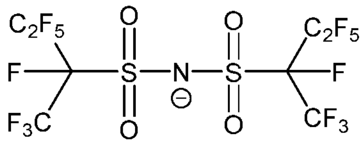,
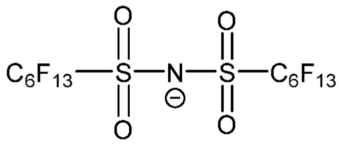,

(G7) (G8) (G9)

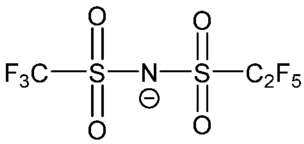,
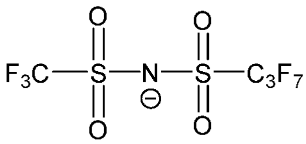,
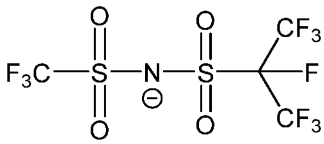,

(G10) (G11) (G12)

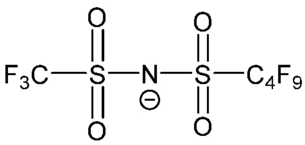,
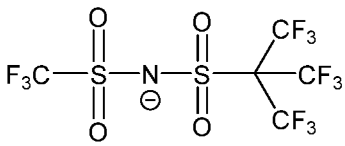,
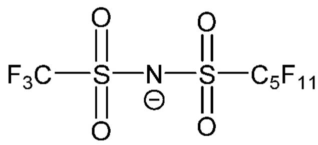,

(G13) (G14) (G15)

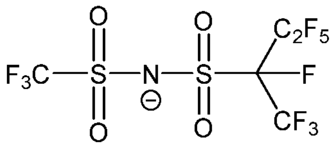,
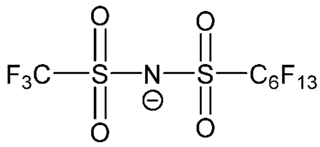,

(G16) (G17)

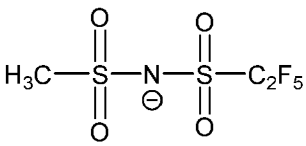,
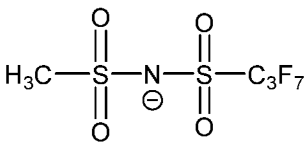,
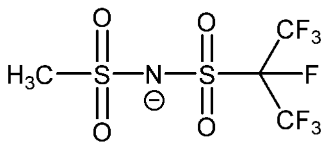,

(G18) (G19) (G20)

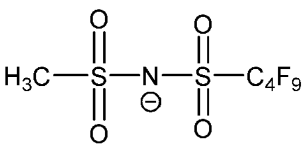,
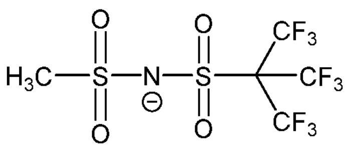,
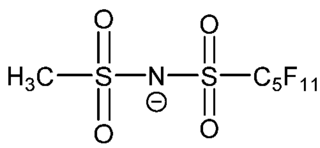,

(G21) (G22) (G23)

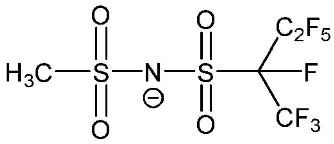,
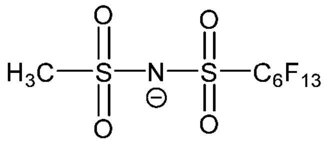,

(G24) (G25)

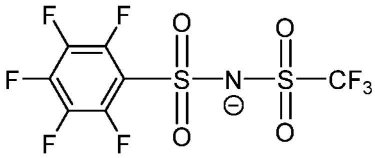,
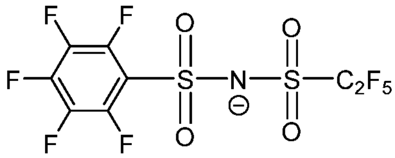,

(G26) (G27)

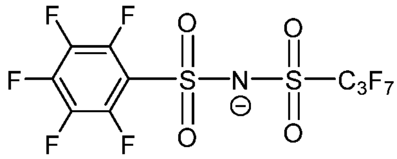,

(G28)

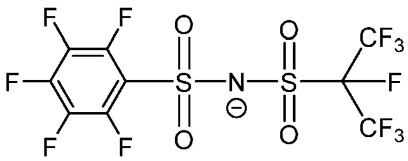,
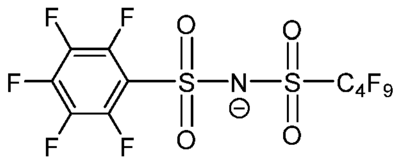,

(G29) (G30)

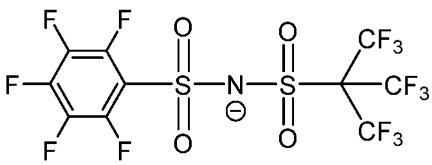,
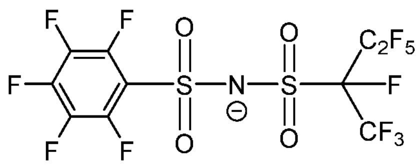,

(G31) (G32)

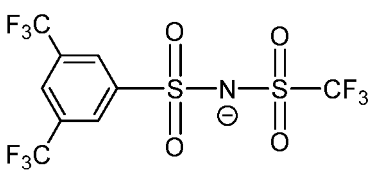,
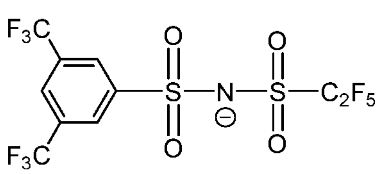,
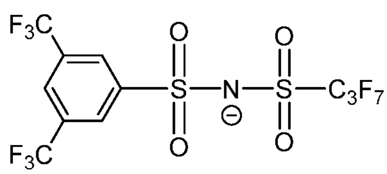,

(G33) (G34) (G35)

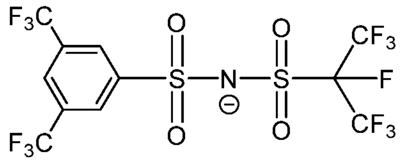, 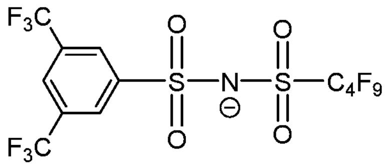,

(G36) (G37)

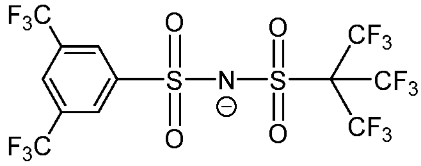,

(G38)

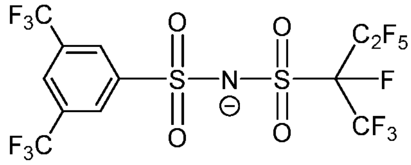, 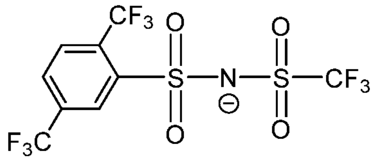,

(G39) (G40)

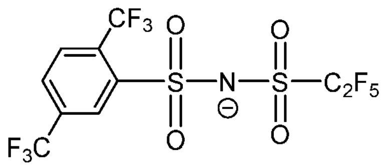,

(G41)

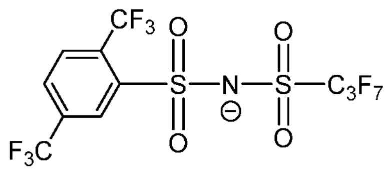, 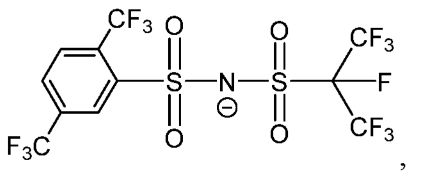,

(G42) (G43)

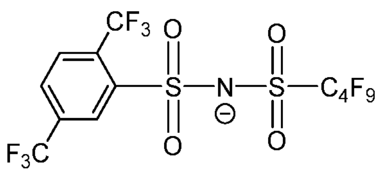, 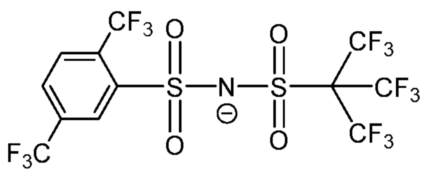

(G44) (G45)

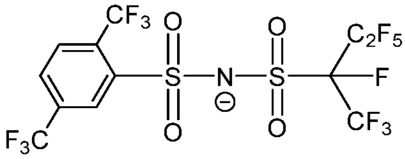
,
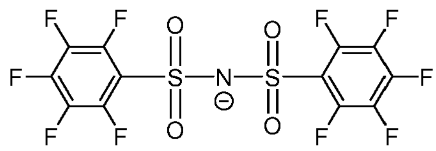

(G46) (G47)

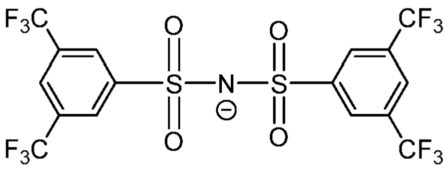
,
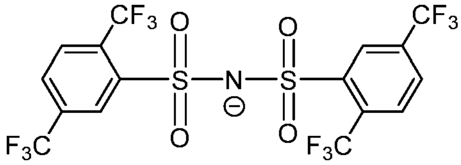

(G48) (G49)

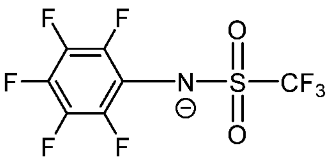
,
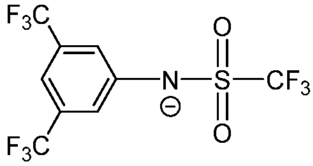
,
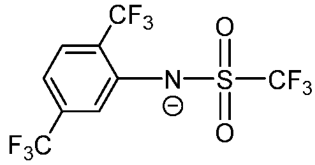
,

(G50) (G51) (G52)

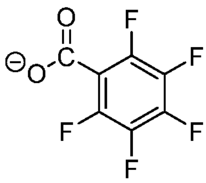
,
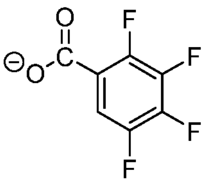
,
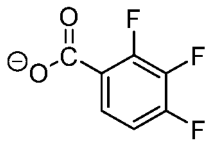
,
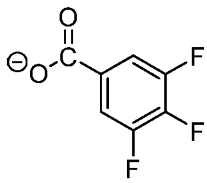
,

(G53) (G54) (G55) (G56)

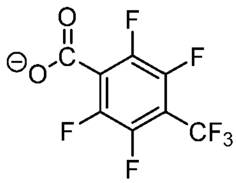
,
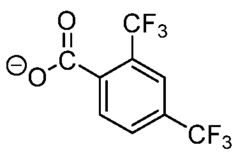
,
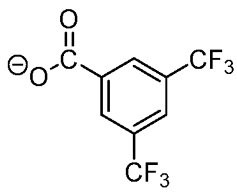
,

(G57) (G58) (G59)

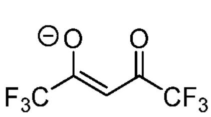
,
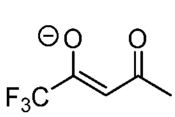
,
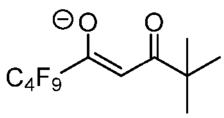
,

(G60) (G61) (G62)

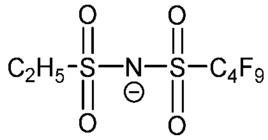 ,

(G63)

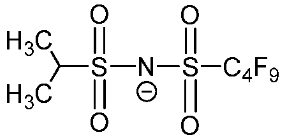 ,

(G64)

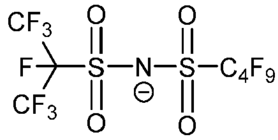 ,

(G65)

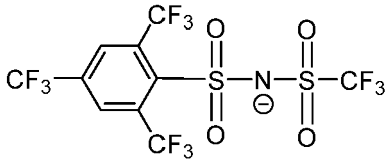 ,

(G66)

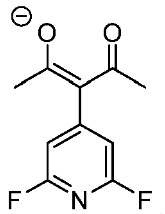 ,

(G67)

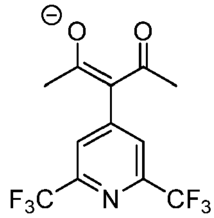 ,

(G68)

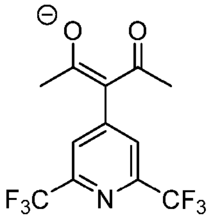 (G69),

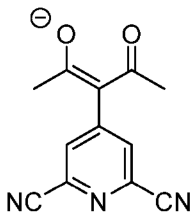 (G70),

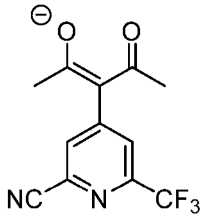 (G71),

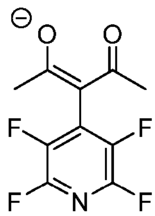 (G72),

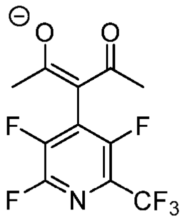 (G73),

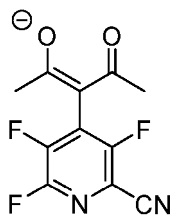 (G74),

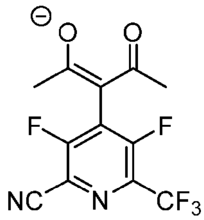 (G75),

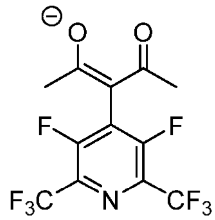 (G76),

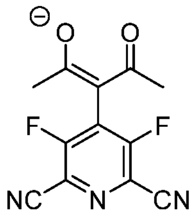 (G77),

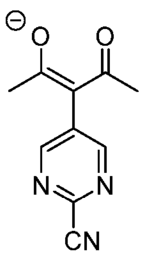 (G78),

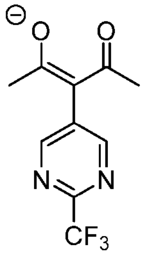 (G79),

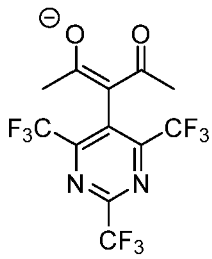 (G80),

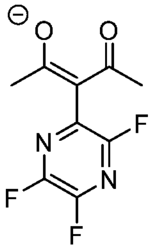 (G81),

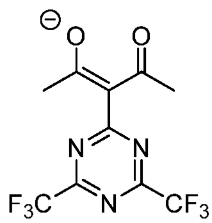 (G82),

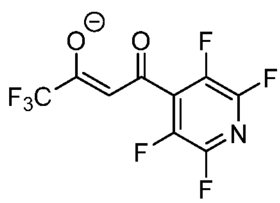 (G83),

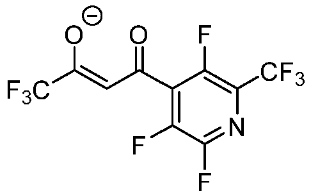 (G84), 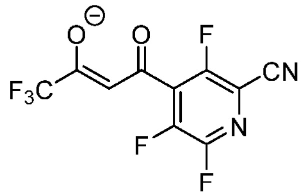 (G85), 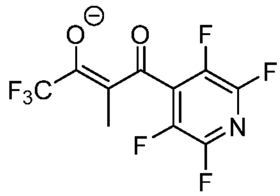 (G86),

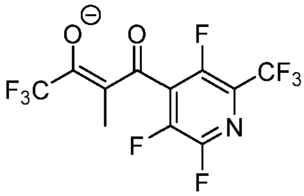 (G87), 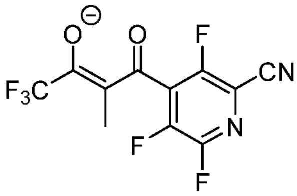 (G88), 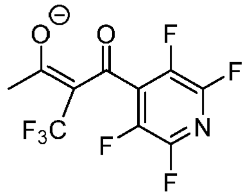 (G89),

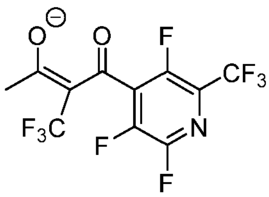 (G90), 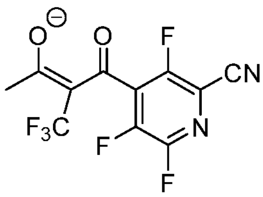 (G91), 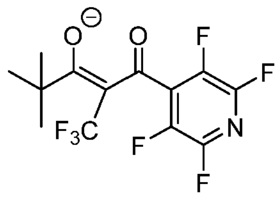 (G92),

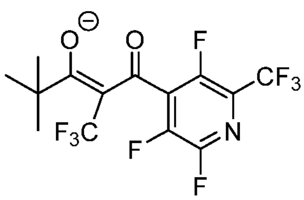 (G93), 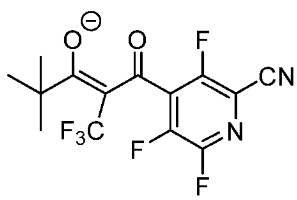 (G94),

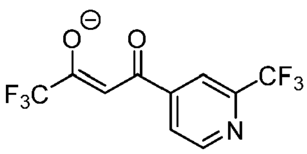 (G95), 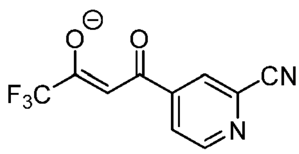 (G96),

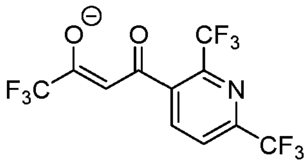 (G97), 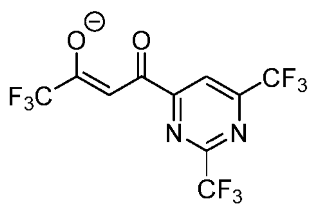 (G98),

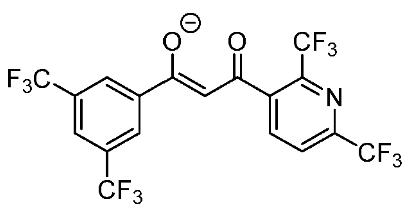 (G99), 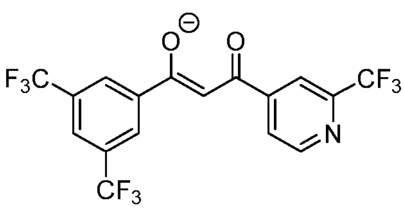 (G100),

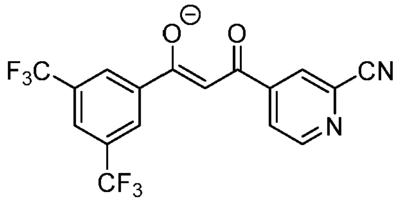 (G101), 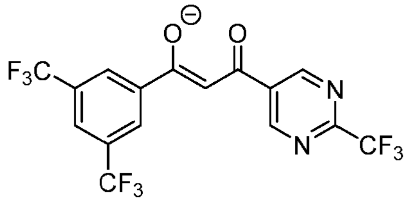 (G102),

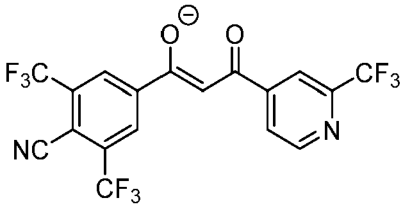 (G103),

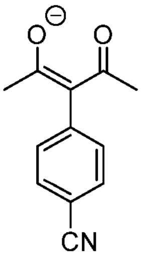 (G104), 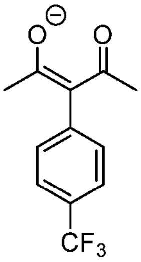 (G105), 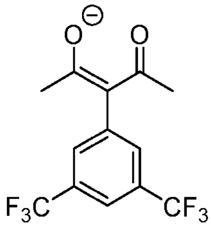 (G106), 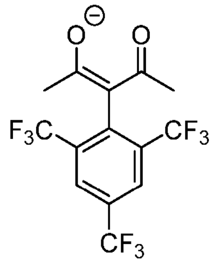 (G107),

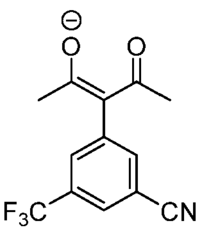 (G108), 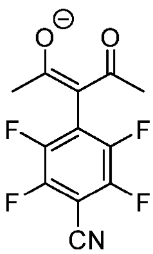 (G109), 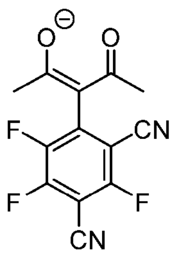 (G110), 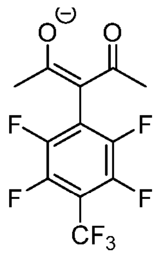 (G111),

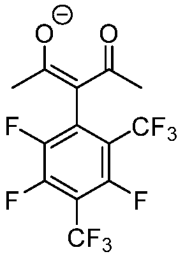 (G112), 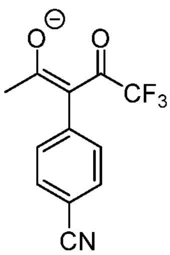 (G113), 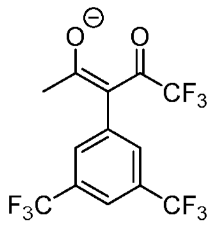 (G114),

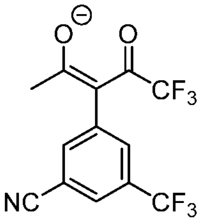 (G115), 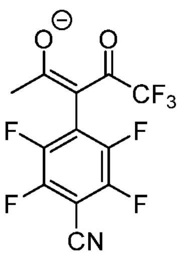 (G116), 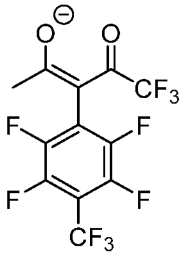 (G117),

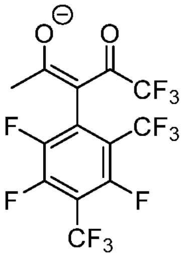 (G118),

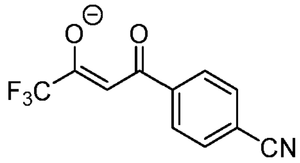 (G119), 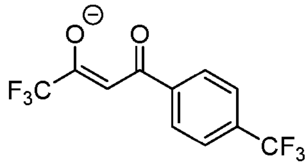 (G120),

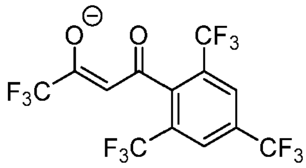 (G121), 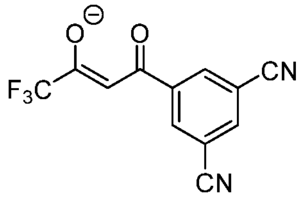 (G122),

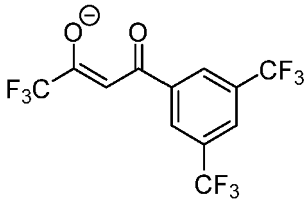 (G123), 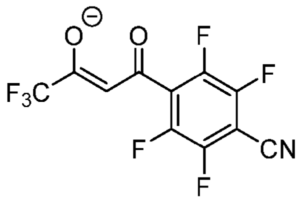 (G124),

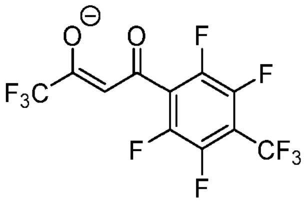 (G125), 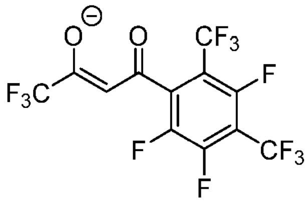 (G126),

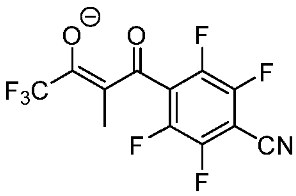 (G127), 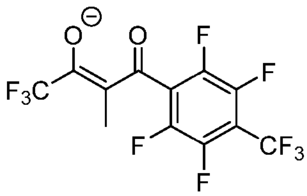 (G128),

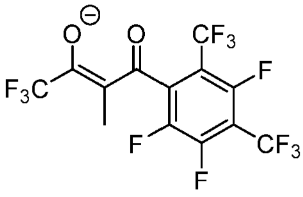 (G129), 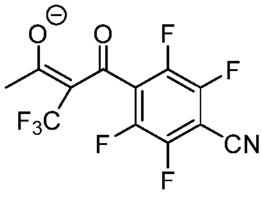 (G130), 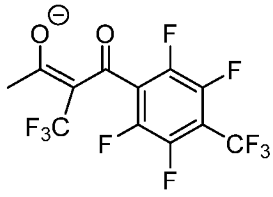 (G131),

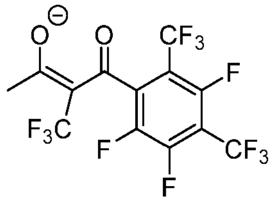 (G132), 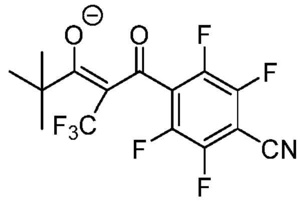 (G133),

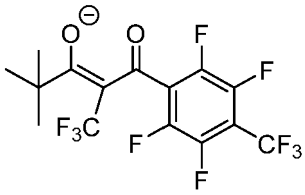 (G134), 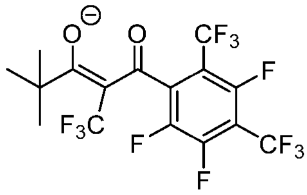 (G135),

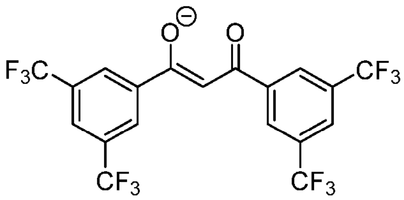 (G135), 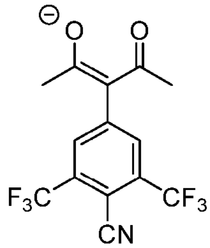 (G136), 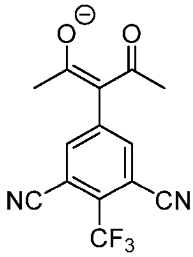 (G137),

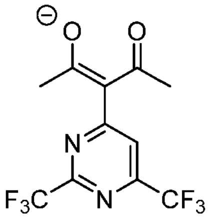 (G138), 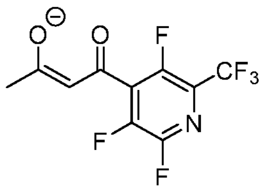 (G139), and 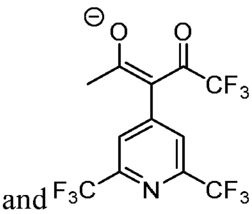 (G140).

According to one embodiment of the present invention, the anionic ligand L is selected from one of the following formulae:

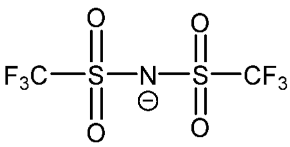 (G1), 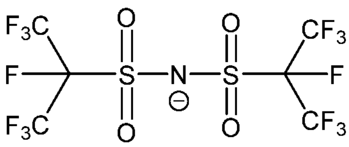 (G4), 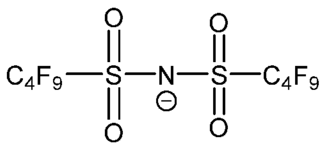 (G5),

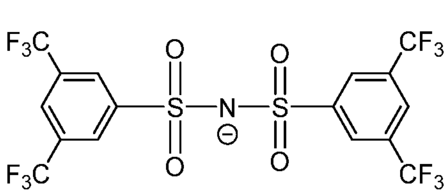 (G48), 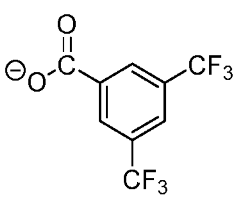 (G59),

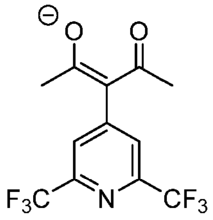 (G69), 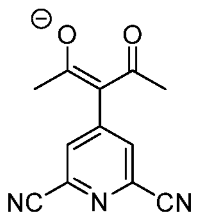 (G70), 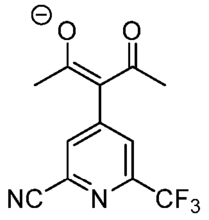 (G71), , 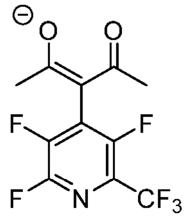 (G73),

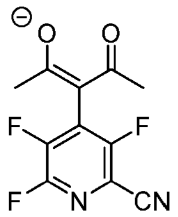 (G74), 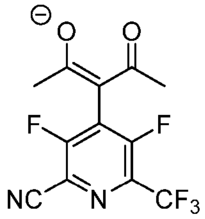 (G75), 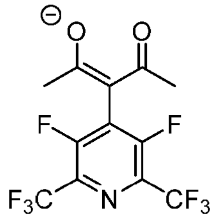 (G76), 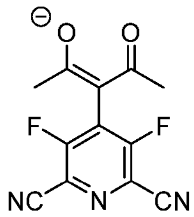 (G77),

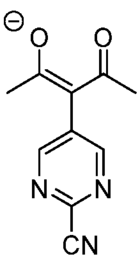 (G78), 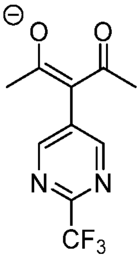 (G79), 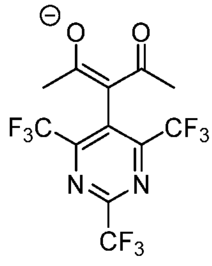 (G80), 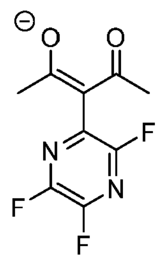 (G81),

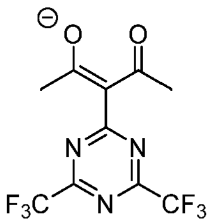 (G82), 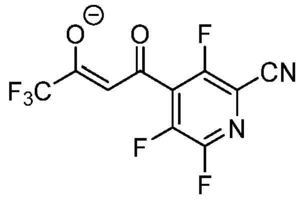 (G85),

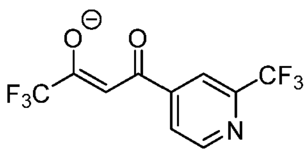 (G95), 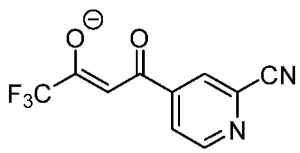 (G96), 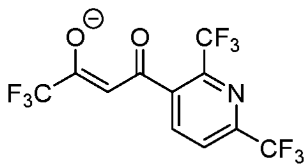 (G97),

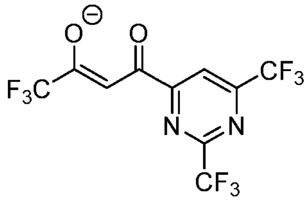 (G98), 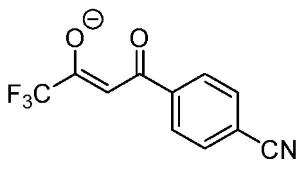 (G119),

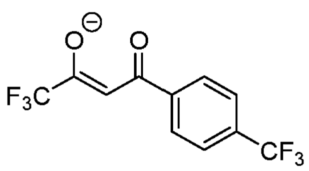 (G120), 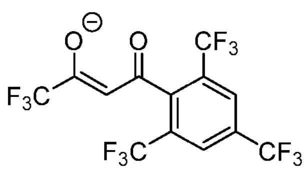 (G121),

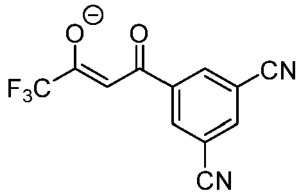 (G122), 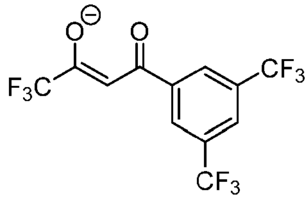 (G123),

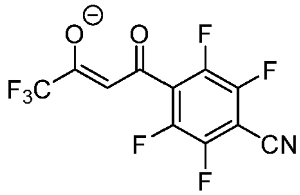 (G124), 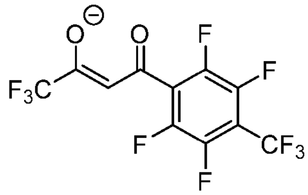 (G125),

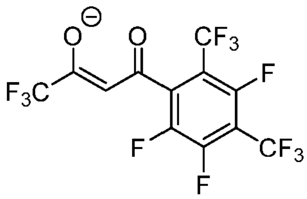 (G126), 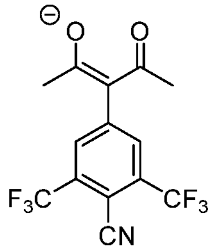 (G136), 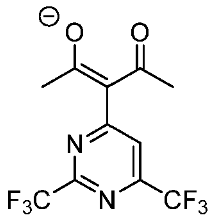 (G138),

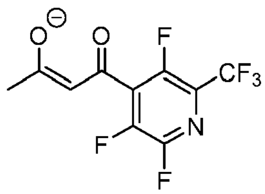 (G139), and. 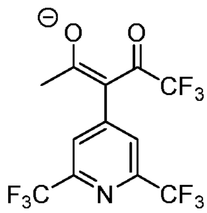 (G140).

According to one embodiment of the present invention, the anionic ligand L is selected from one of the following formulae:

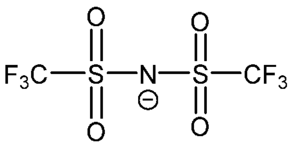 (G1), 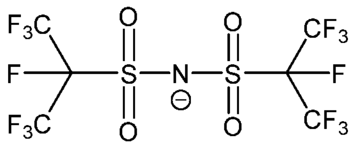 (G4), 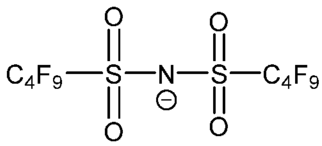 (G5),

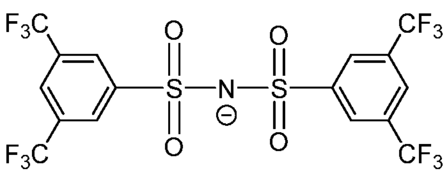 (G48), 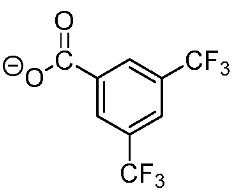 (G59), 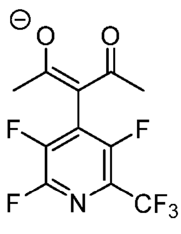 (G73),

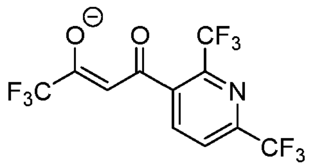 (G97), 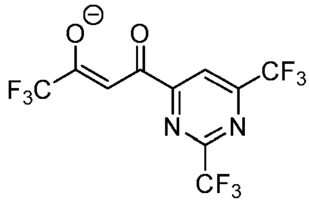 (G98),

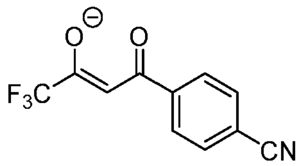 (G119), 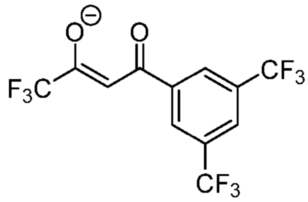 (G123),

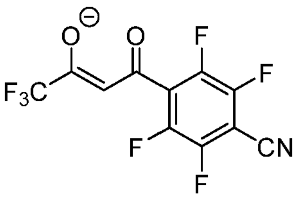 (G124), 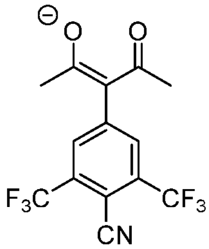 (G136), 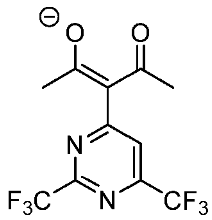 (G138),

and

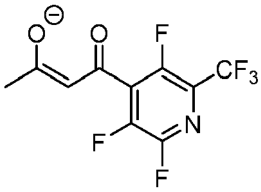 (G139), 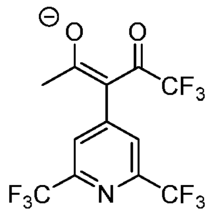 (G140).

According to one embodiment of the present invention, the metal complex according to formula (I) is selected from one of the formulae (VIIa) to (VIId):

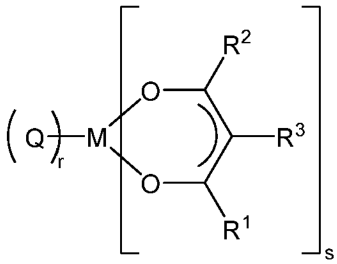 (VIIa) 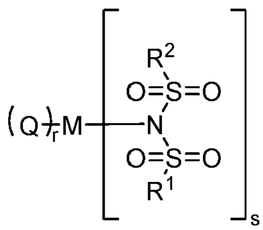 (VIIb)

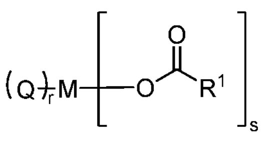 (VIIc) 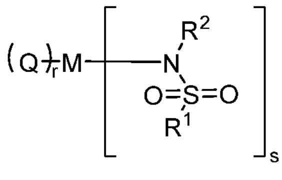 (VIId)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,

wherein for formula (VIIa) $R^1$ and $R^2$ may also be selected from D or H,

wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (VIIa) to (VIId):

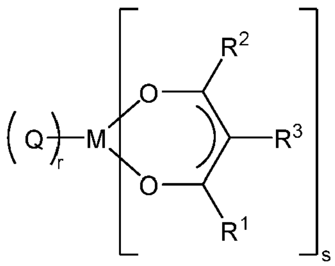
(VIIa)

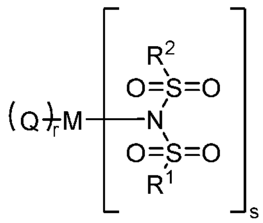
(VIIb)

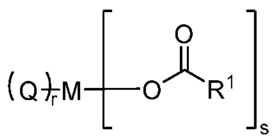
(VIIc)

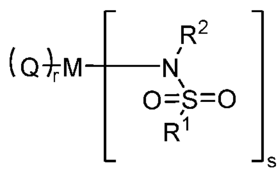
(VIId)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,

wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,

wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

According to one embodiment of the present invention, the metal complex according to formula (I) is selected from one of the formulae (VIIa) to (VIIc):

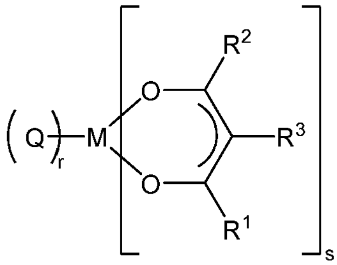 (VIIa)

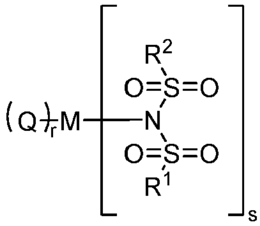 (VIIb)

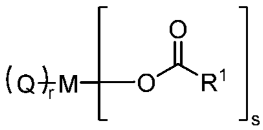 (VIIc).

According to one embodiment of the present invention, the metal complex according to formula (I) is selected from one of the formulae (VIIa) or (VIIb):

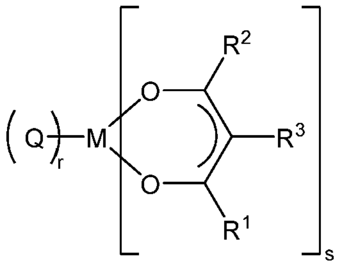 (VIIa)

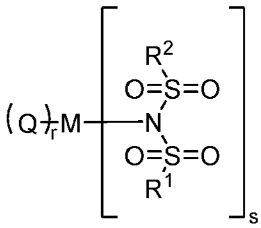 (VIIb).

According to one embodiment of the present invention, the metal complex according to formula (I) is selected from formula (VIIa):

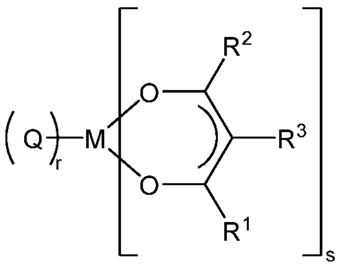 (VIIa).

According to one embodiment of the present invention, the metal complex according to formula (I) is selected from formula (VIIa):

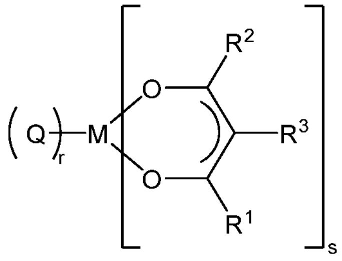

(VIIa),

wherein

at least one of $R^1$, $R^2$ and/or $R^3$ is selected from a substituted $C_2$ to $C_{24}$ heteroaryl group or substituted $C_6$ to $C_{24}$ aryl group, wherein at least one substituent is selected from halogen, F, Cl, CN, partially or fully fluorinated $C_1$ to $C_{12}$ alkyl, partially or fully fluorinated $C_1$ to $C_6$ alkoxy.

According to one embodiment of the present invention, the metal complex according to formula (I) is selected from formula (VIIa):

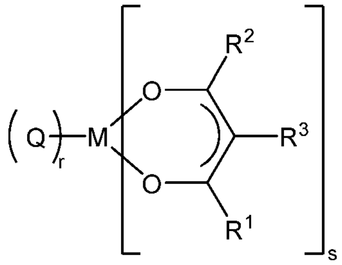

(VIIa),

wherein

at least one $R^1$, $R^2$ and/or $R^3$ is selected from a substituted $C_2$ to $C_{24}$ heteroaryl group or substituted $C_6$ to $C_{24}$ aryl group, wherein at least one substituent of the substituted $C_2$ to $C_{24}$ heteroaryl group is selected from halogen, F, Cl, CN, partially or fully fluorinated $C_1$ to $C_6$ alkyl, partially or fully fluorinated $C_1$ to $C_6$ alkoxy, or wherein at least one substituent of the substituted $C_6$ to $C_{24}$ aryl group is selected from halogen, F, Cl, CN, or partially or fully fluorinated $C_1$ to $C_{12}$ alkyl.

According to one embodiment of the present invention, the metal complex according to formula (I) is selected from formula (VIIa):

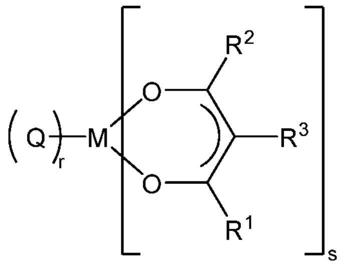

(VIIa),

$R^1$ and $R^2$ are independently selected from D, H, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,

wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,

wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $Ci_8$ heteroaryl are selected from halogen, F, Cl, CN, $C_1$ to $C_6$ alkyl, $CF_3$, $OCH_3$, or $OCF_3$;

and

$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or

substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $Ci_8$ heteroaryl are selected from halogen, F, Cl, CN, $C_1$ to $C_6$ alkyl, $CF_3$, $OCH_3$, or $OCF_3$;
wherein
at least one of $R^1$, $R^2$ and/or $R^3$ is selected from a substituted $C_2$ to $C_{24}$ heteroaryl group or substituted $C_6$ to $C_{24}$ aryl group, wherein at least one substituent is selected from halogen, F, Cl, CN, partially or fully fluorinated $C_1$ to $C_6$ alkyl, partially or fully fluorinated $C_1$ to $C_6$ alkoxy.

According to one embodiment of the present invention, the metal complex according to formula (I) is selected from formula (VIIa):

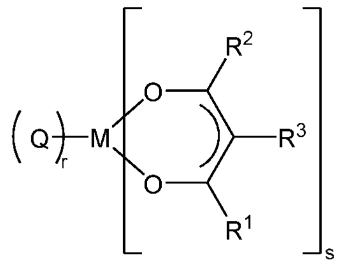
(VIIa),

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, $CF_3$, $OCH_3$, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, $CF_3$, $OCH_3$, or $OCF_3$;
wherein
at least one of $R^1$, $R^2$ and/or $R^3$ is selected from a substituted $C_2$ to $C_{24}$ heteroaryl group or substituted $C_6$ to $C_{24}$ aryl group, wherein at least one substituent is selected from halogen, F, Cl, CN, partially or fully fluorinated $C_1$ to $C_6$ alkyl, partially or fully fluorinated $C_1$ to $C_6$ alkoxy.

According to one embodiment of the present invention, the metal complex according to formula (I) is selected from formula (VIIa):

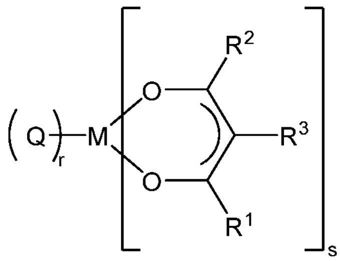 (VIIa),

wherein
at least one of $R^1$, $R^2$ and/or $R^3$ is selected from a substituted $C_6$ to $C_{24}$ aryl group, wherein at least one substituent is selected from CN or partially or fully fluorinated $C_1$ to $C_{12}$ alkyl.

According to one embodiment of the present invention, the metal complex according to formula (I) is selected from formula (VIIa):

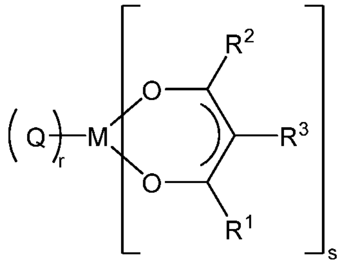 (VIIa),

wherein
at least one $R^1$, $R^2$ and/or $R^3$ is selected from a substituted $C_2$ to $C_{24}$ heteroaryl group, wherein at least one substituent of the substituted $C_2$ to $C_{24}$ heteroaryl group is selected from halogen, F, Cl, CN, partially or fully fluorinated $C_1$ to $C_6$ alkyl, partially or fully fluorinated $C_1$ to $C_6$ alkoxy.

According to one embodiment, at least one substituted $C_6$ to $C_{24}$ aryl group of $R^1$, $R^2$ or $R^3$ is selected from the following Formulas D1 to D19:

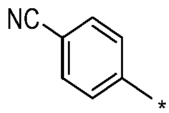 (D1), 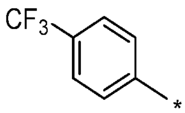 (D2), 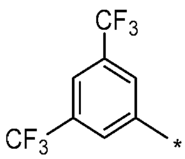 (D3), 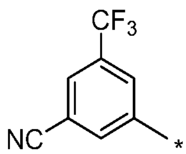 (D4),

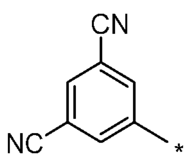 (D5), 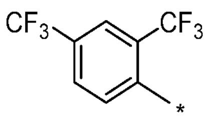 (D6), 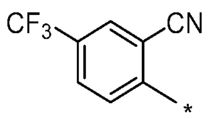 (D7), 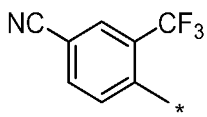 (D8),

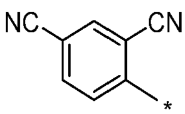 (D9), 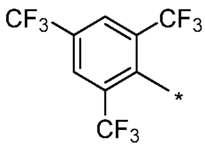 (D10), 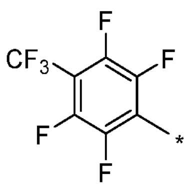 (D11), 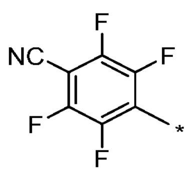 (D12),

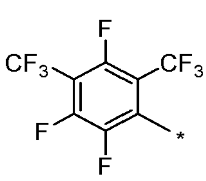 (D13), 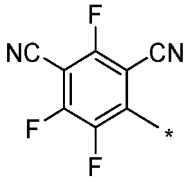 (D14), 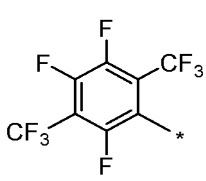 (D15), 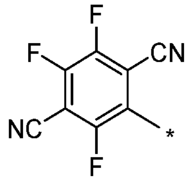 (D16),

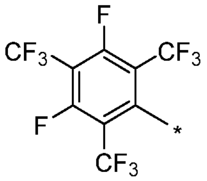 (D17), 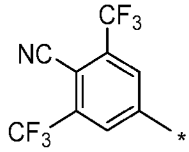 (D18), 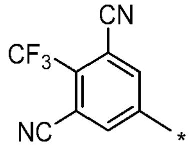 (D19),

wherein the "*" denotes the binding position.

According to one embodiment, at least one substituted $C_2$ to $C_{24}$ heteroaryl group of $R^1$, $R^2$ or $R^3$ is selected from the following Formulas D20 to D48:

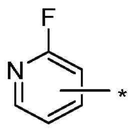 (D20), 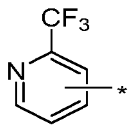 (D21), 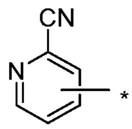 (D21), 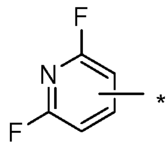 (D22),

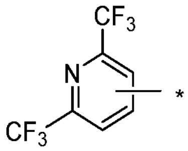 (D23), 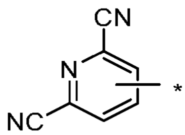 (D24), 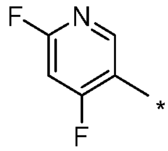 (D25), 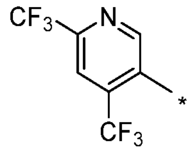 (D26),

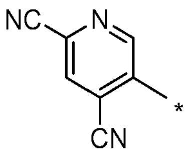 (D27), 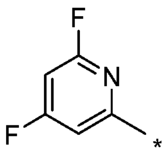 (D28), 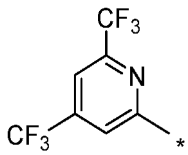 (D29), 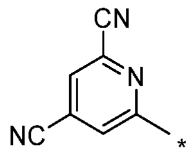 (D30),

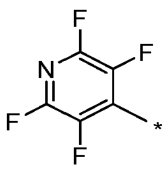 (D31), 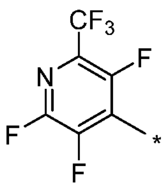 (D32), 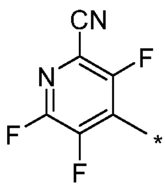 (D33), 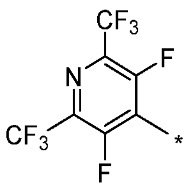 (D34),

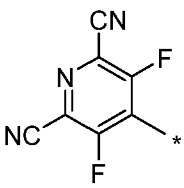 (D35), 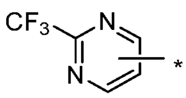 (D36), 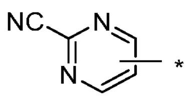 (D37), 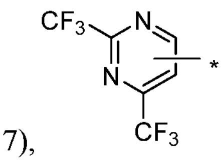 (D38),

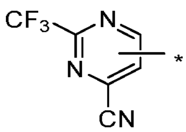 (D39), 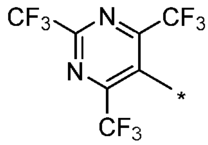 (D40), 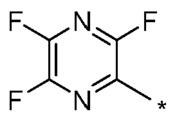 (D41),

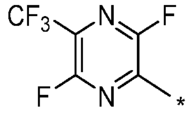 (D42), 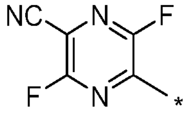 (D43), 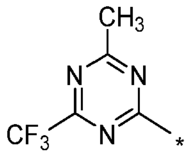 (D44),

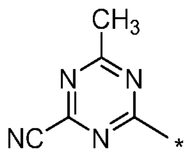 (D45), 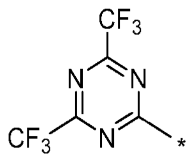 (D47), 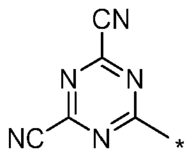 (D48),

wherein the "*" denotes the binding position.

According to one embodiment of the present invention, r in formulae VIIa to VIId is an integer selected from 0 or 1, preferably 0.

According to one embodiment of the present invention, the metal complex of formula (I) is selected from one of the following compounds:

Li TFSI, K TFSI, Cs TFSI, Ag TFSI, $Mg(TFSI)_2$, $Mn(TFSI)_2$, $Sc(TFSI)_3$, $Mg[N(SO_2{}^iC_3F_7)_2]_2$, $Zn[N(SO_2{}^iC_3F_7)_2]_2$, $Zn[N(SO_2C_4F_9)_2]_2$, $Ag[N(SO_2{}^iC_3F_7)_2]$, $Ag[N(SO_2C_3F_7)_2]$, $Ag[N(SO_2C_4F_9)_2]$, $Ag[N(SO_2CF_3)(SO_2C_4F_9)]$, $Cs[N(SO_2C_4F_9)_2]$, $Mg[N(SO_2C_4F_9)_2]_2$, $Ca[N(SO_2C_4F_9)_2]_2$, $Ag[N(SO_2C_4F_9)_2]$, $Na[N(SO_2{}^iC_3F_7)_2]$, $Na[N(SO_2C_4F_9)_2]_2$, $Cu[N(SO_2{}^iC_3F_7)_2]_2$, $Cu[N(SO_2C_3F_7)_2]_2$, $Cu[N(SO_2CF_3)(SO_2C_4F_9)]_2$, $Mg[N(SO_2CF_3)(SO_2C_4F_9)]_2$, $Mn[N(SO_2CF_3)(SO_2C_4F_9)]_2$, $Cu[N(SO_2CH_3)(SO_2C_4F_9)]_2$, $Ag[N(SO_2CH_3)(SO_2C_4F_9)]$,

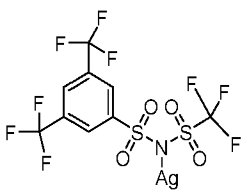 , 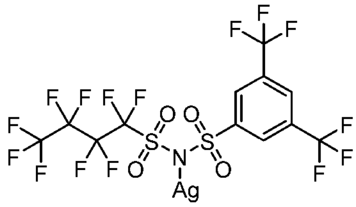 , 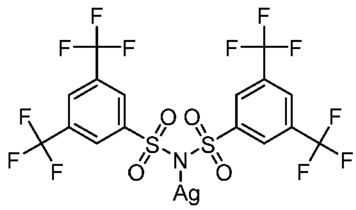 ,

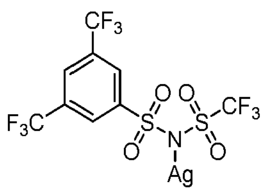 , 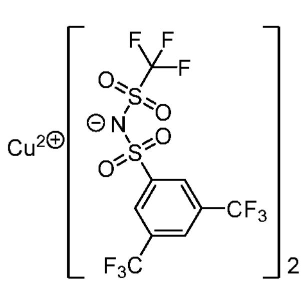 , 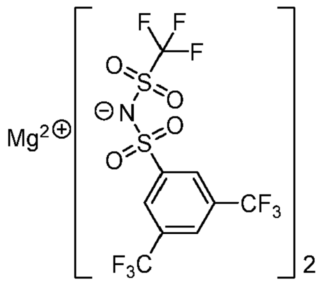 ,

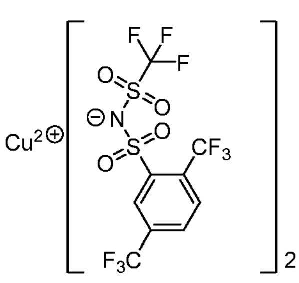, 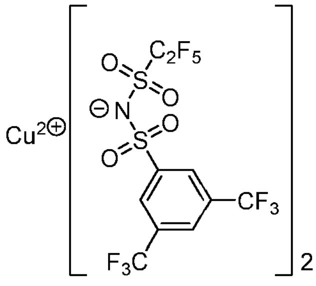, 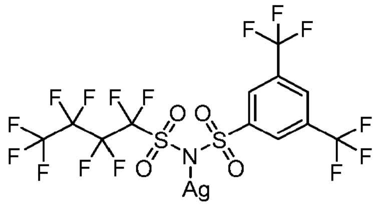,

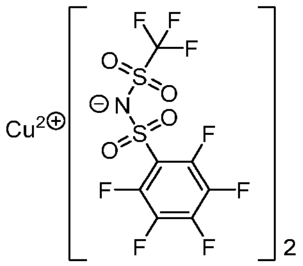, 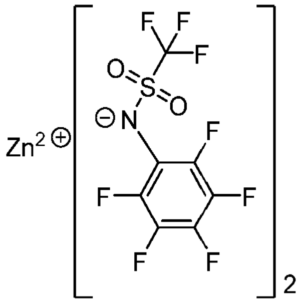, 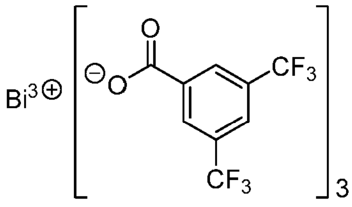,

Cu $[N(SO_2C_2H_5)\ (SO_2C_4F_9)]_2$, Cu $[N(SO_2\ {}^{i}C_3H_7)\ (SO_2C_4F_9)]_2$, Cu $[N(SO_2\ {}^{i}C_3F_7)\ (SO_2C_4F_9)]_2$,

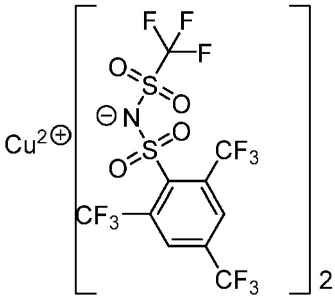, 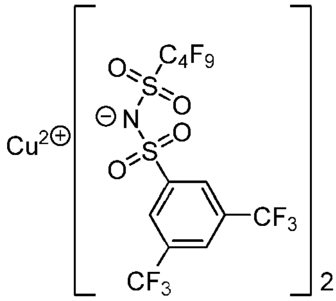,

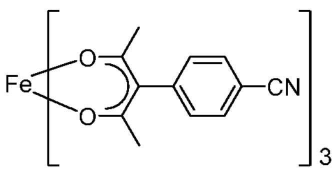, 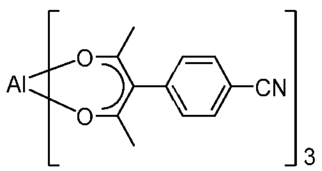, 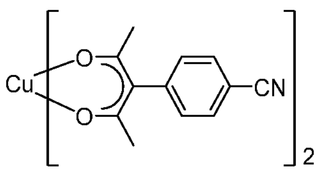,

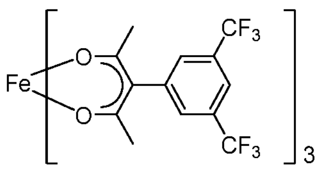, 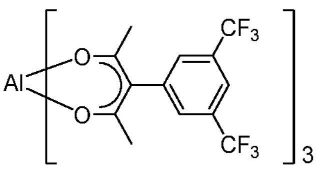, 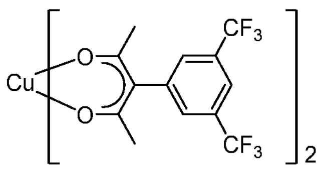,

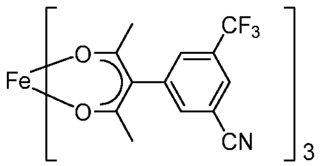, 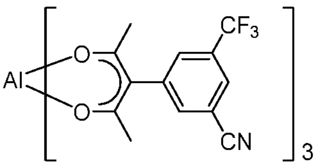, 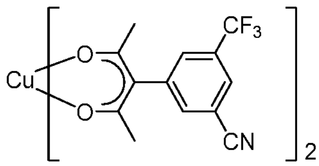,

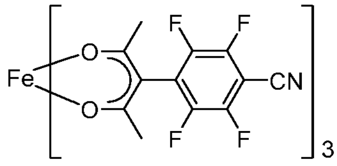, 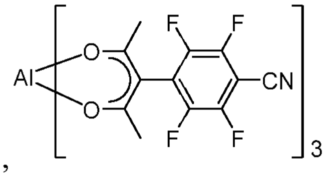, 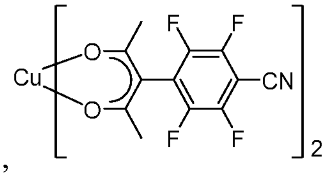,

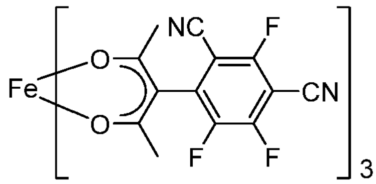, 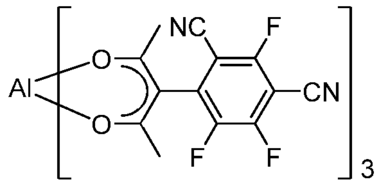,

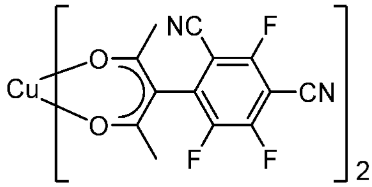,

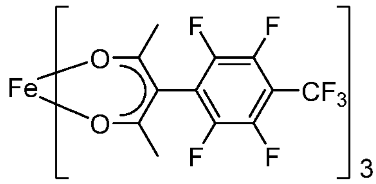, 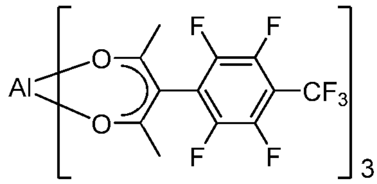,

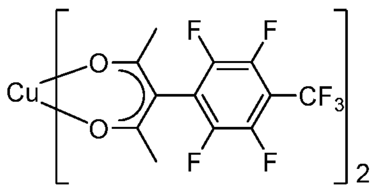,

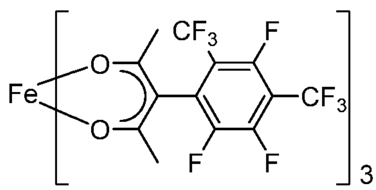, 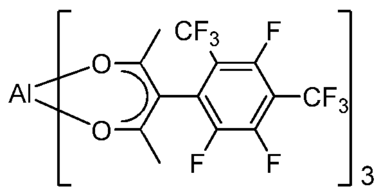,

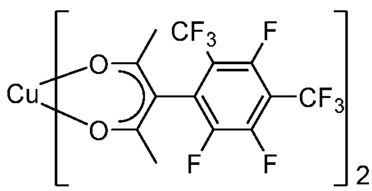,

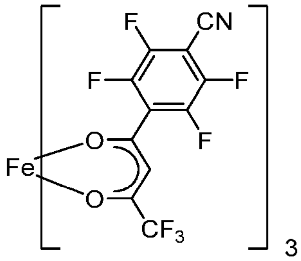 , 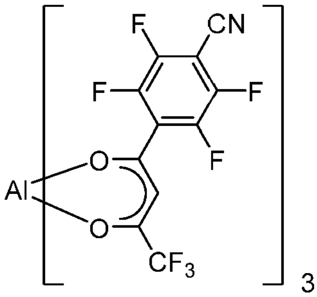 , 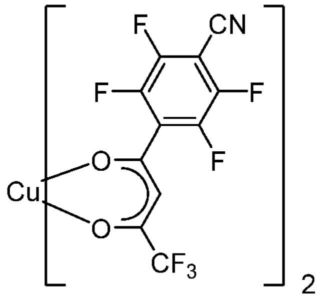 ,

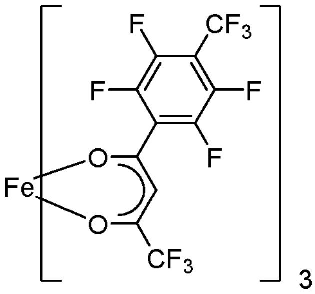 , 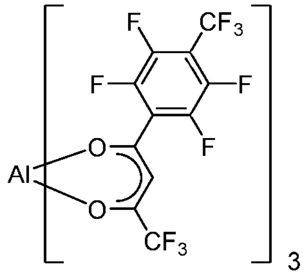 , 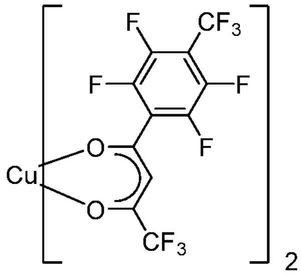 ,

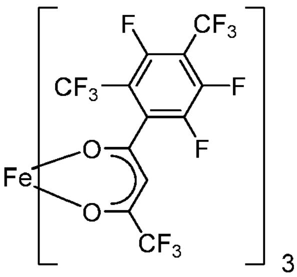 , 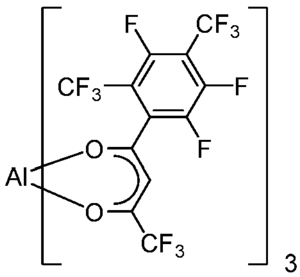 , 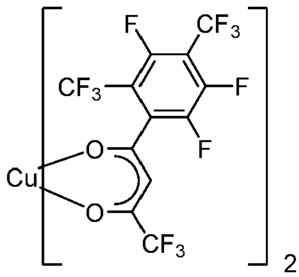 ,

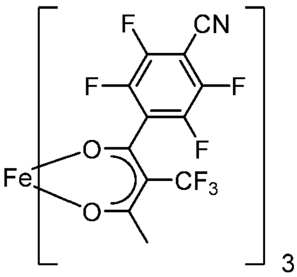 , 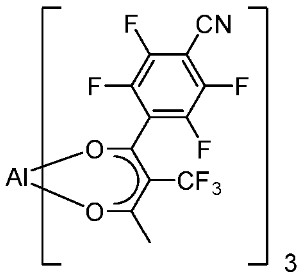 , 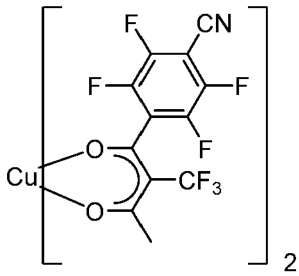 ,

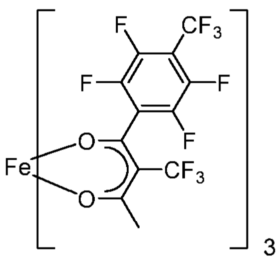 , 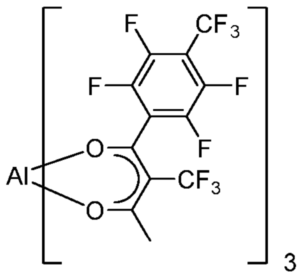 , 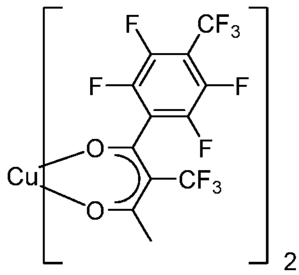 ,

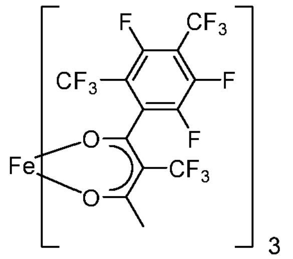,
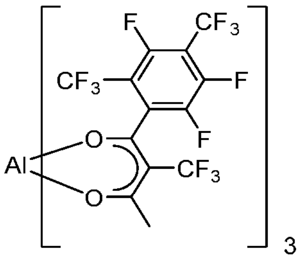),
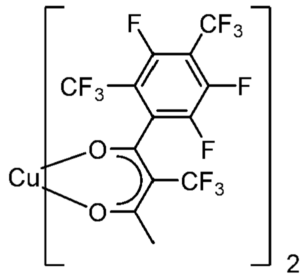,

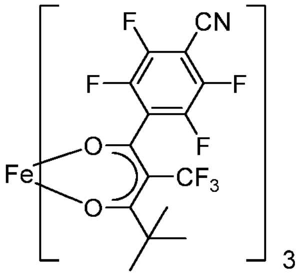,
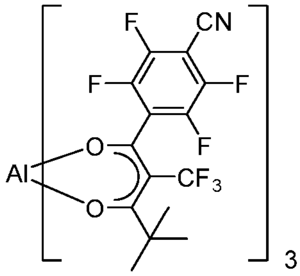,
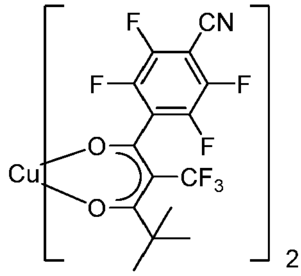,

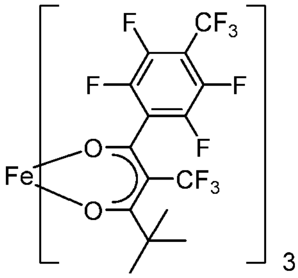,
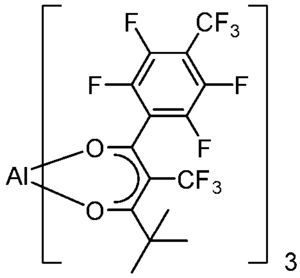,
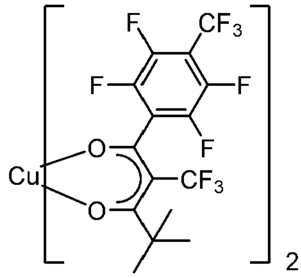,

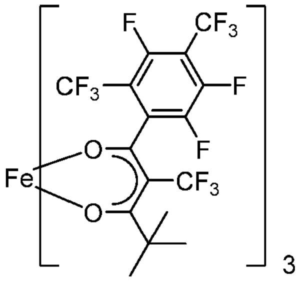,
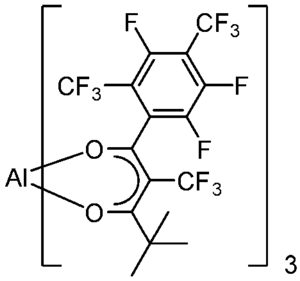,
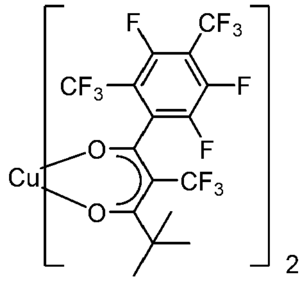,

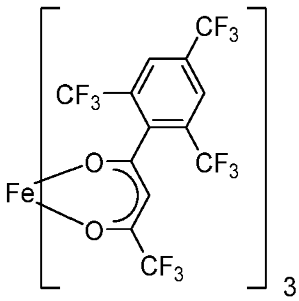
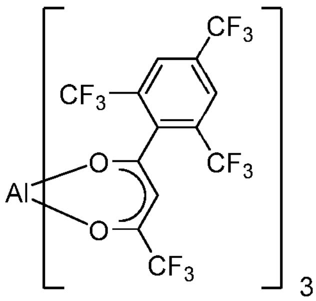
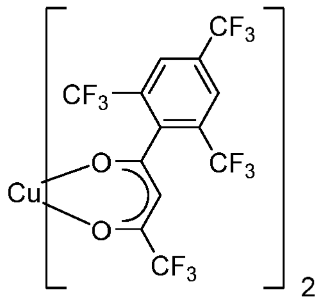

,

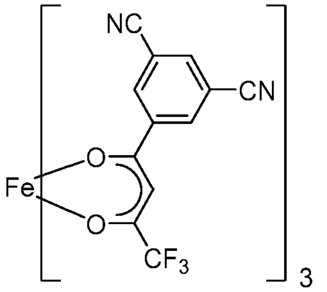

,

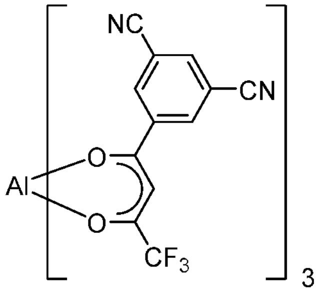

,

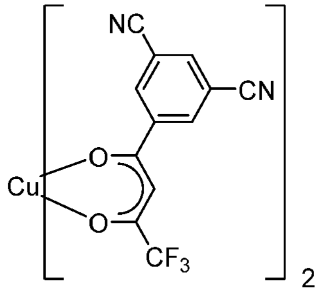

,

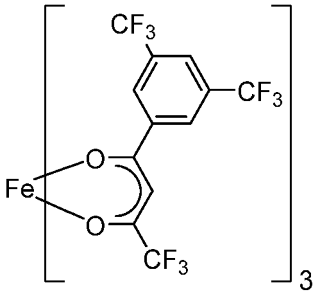

,

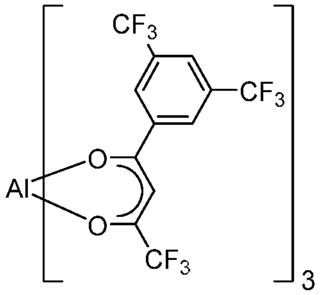

,

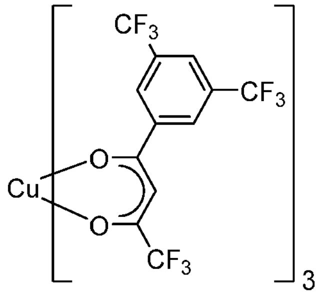

,

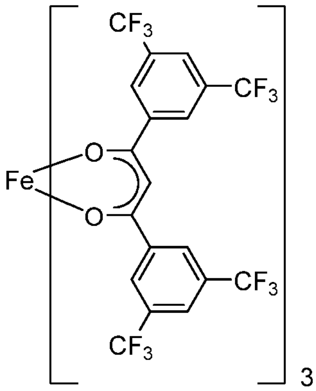

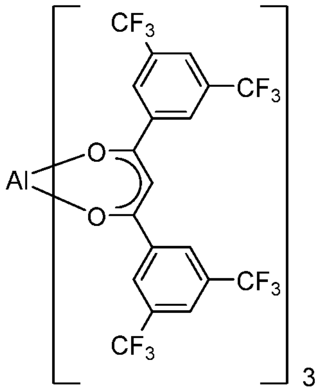

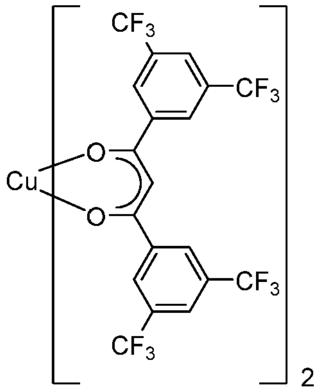

,

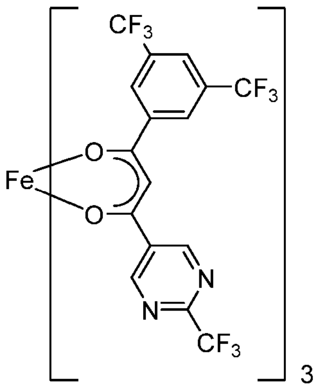

,

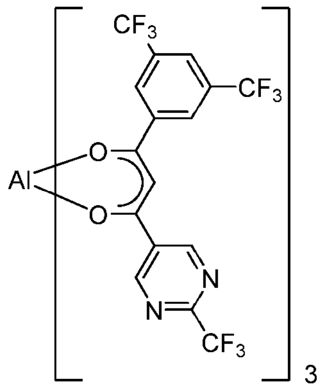

,

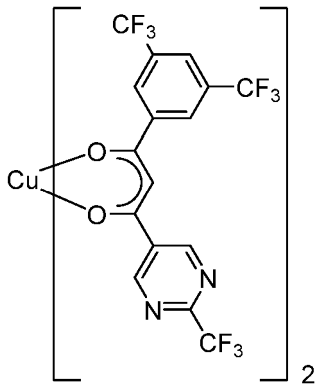

, , ,

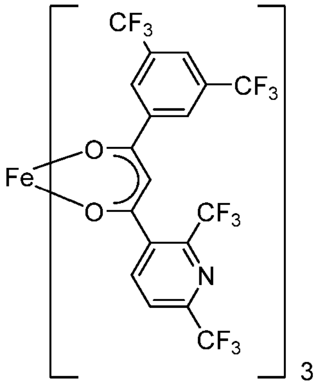 , 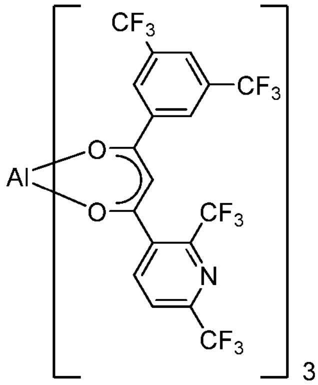 , 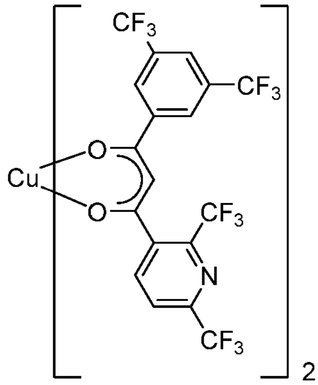 ,

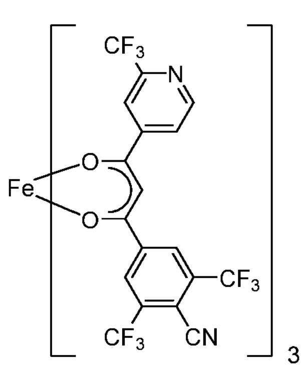 , 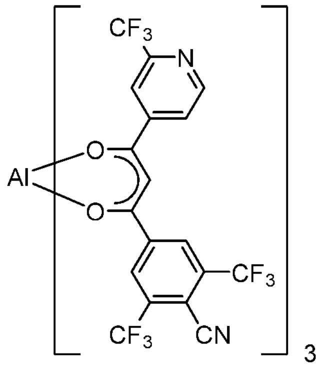 , 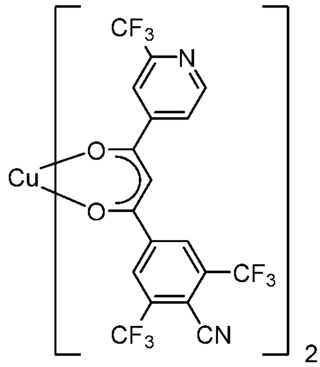 ,

, , ,

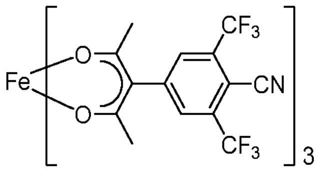 , 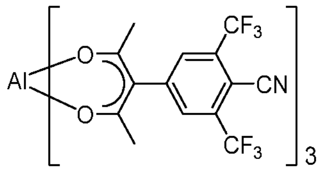 , 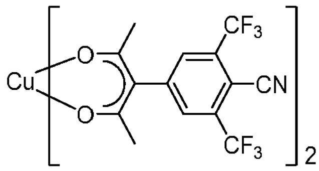 ,

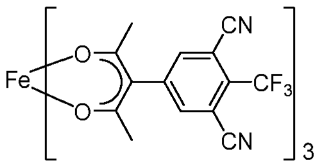 , 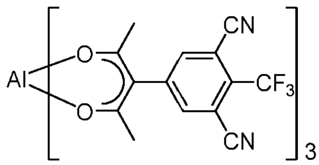 , 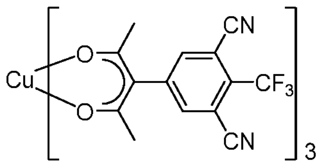 ,

, , ,

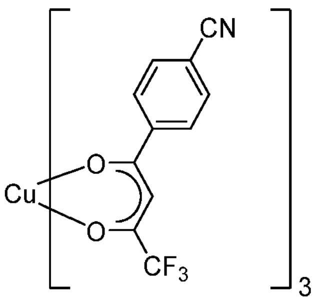

,

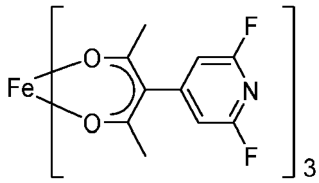,
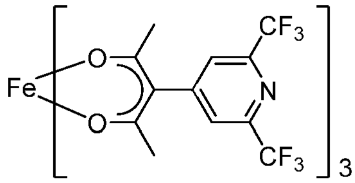,
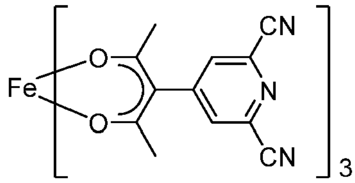,

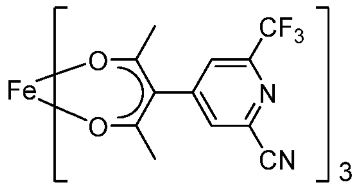,
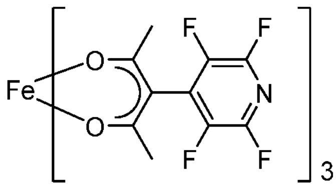,
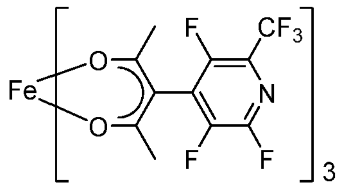,

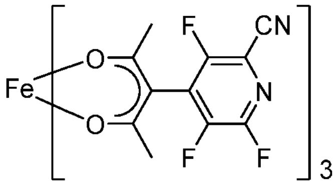,
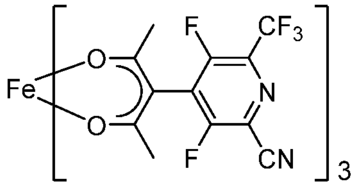,
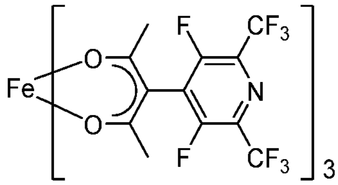,

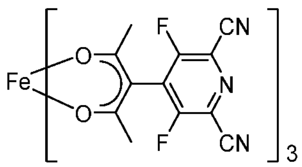,
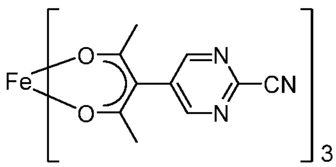,
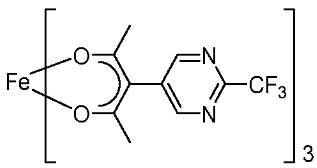,

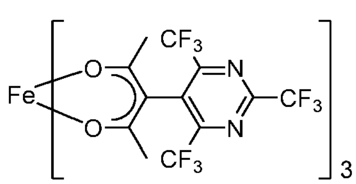,
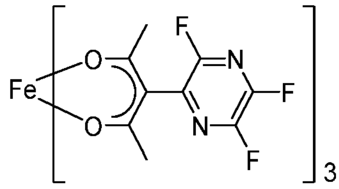,
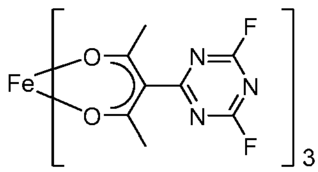,

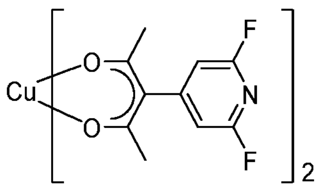,
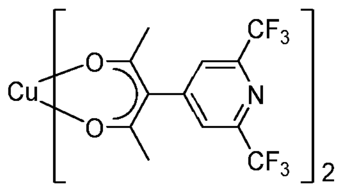,
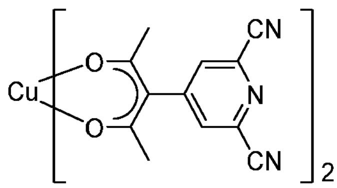,

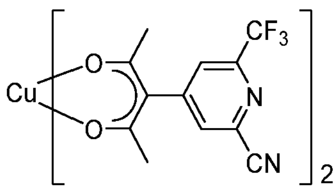,
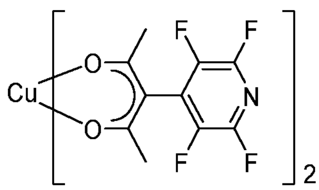,
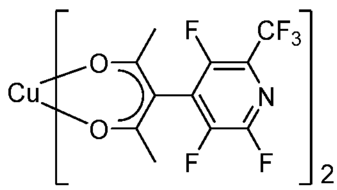,

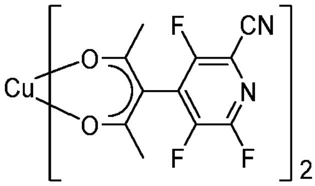,
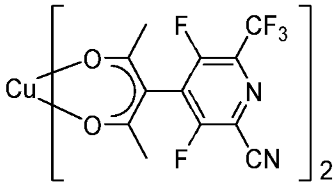,
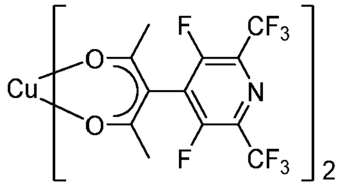,

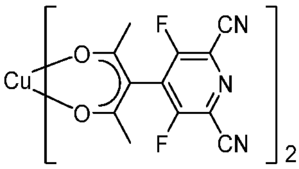,
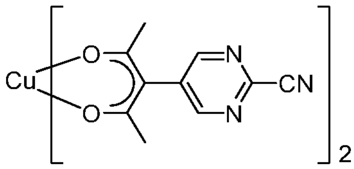,
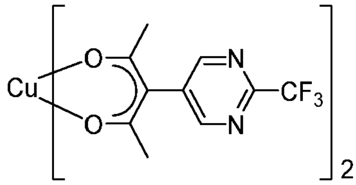,

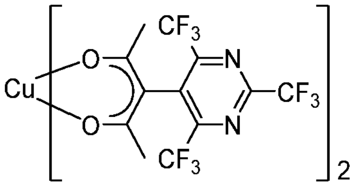,
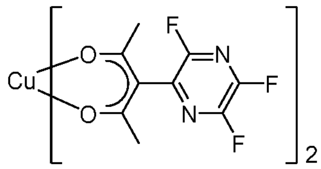,
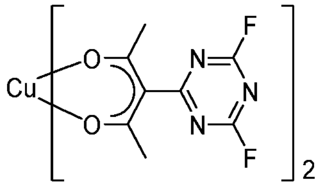,

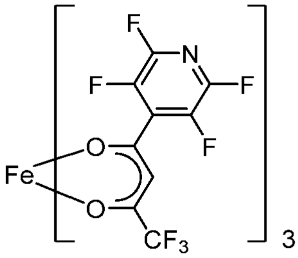,
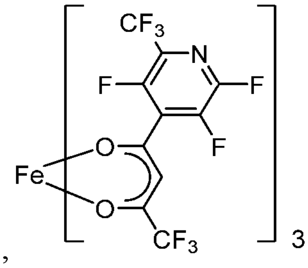,
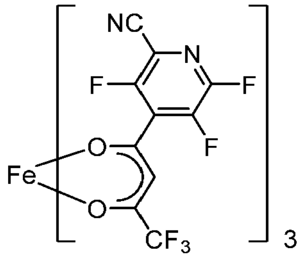,

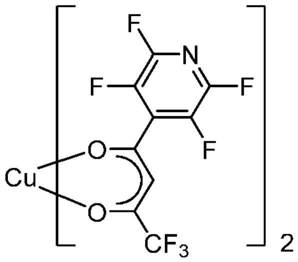,
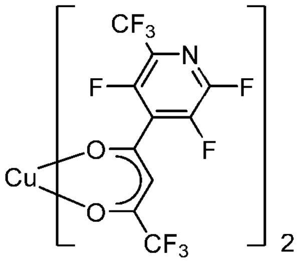,
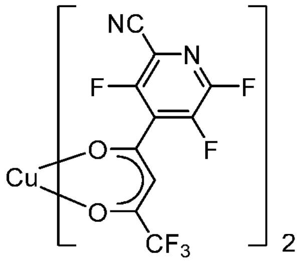,

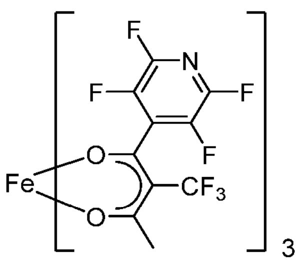.
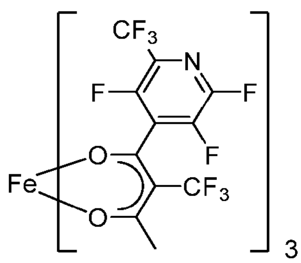.
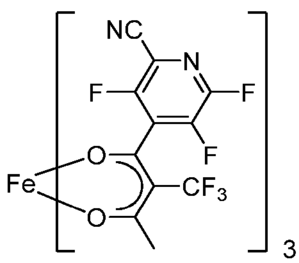.

, , ,

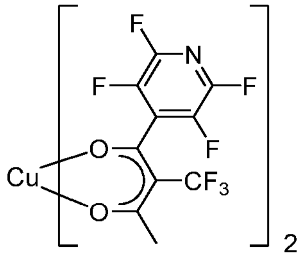, 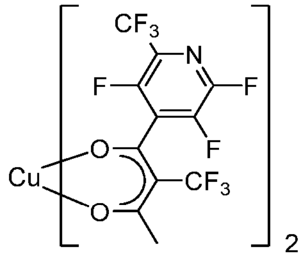, 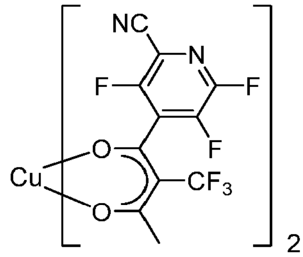,

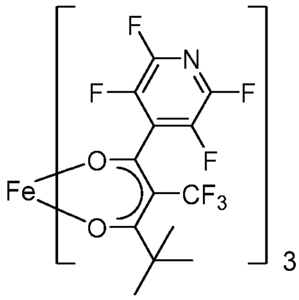, 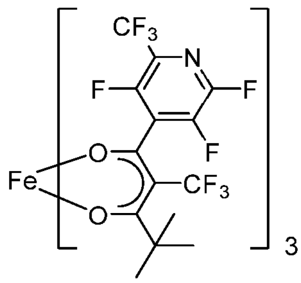, 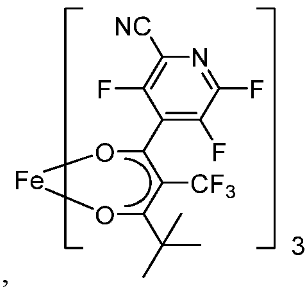,

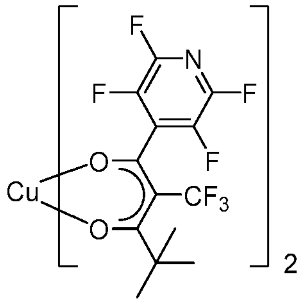, 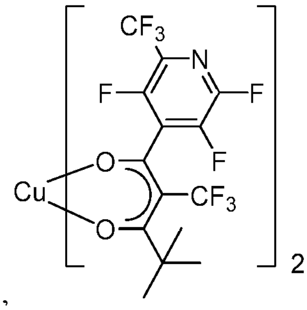, 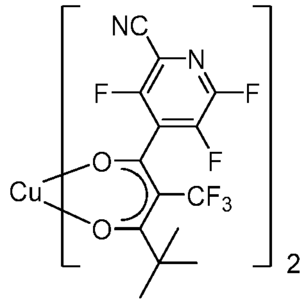,

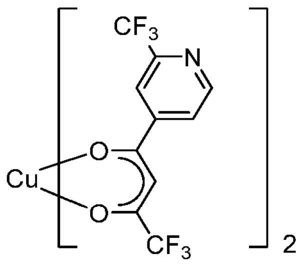, 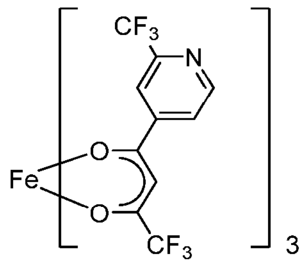, 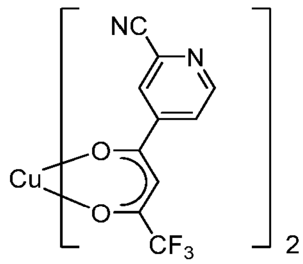,

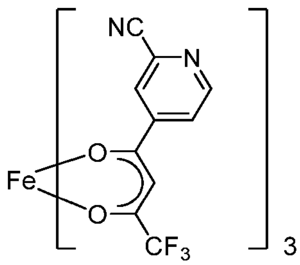, 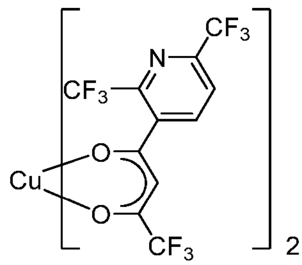, 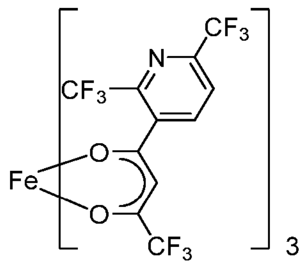,

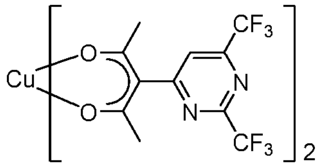, 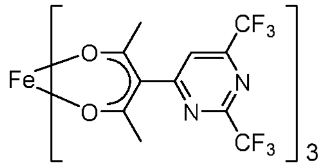, 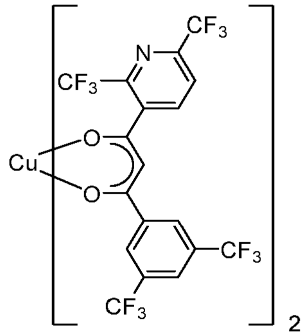,

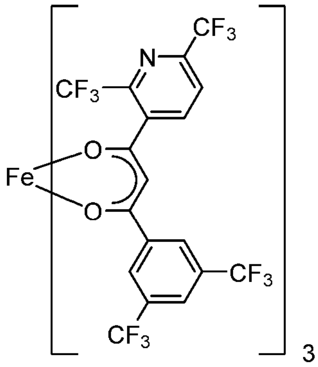, 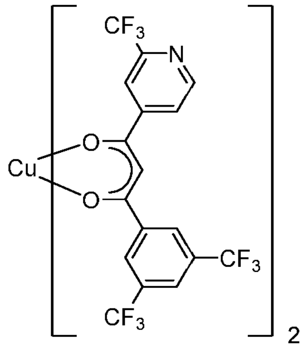, 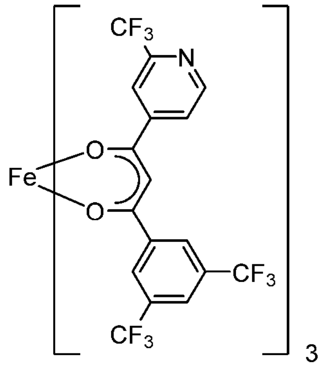,

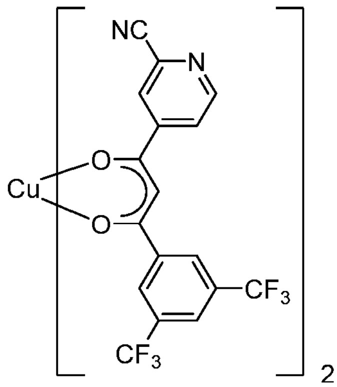 –, 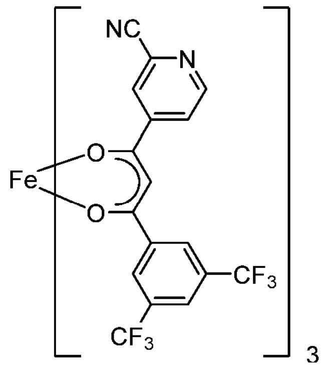 -, 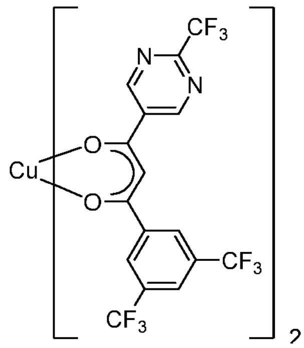 –,

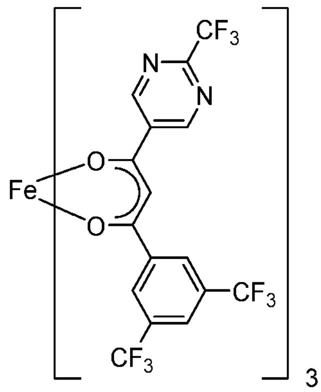, 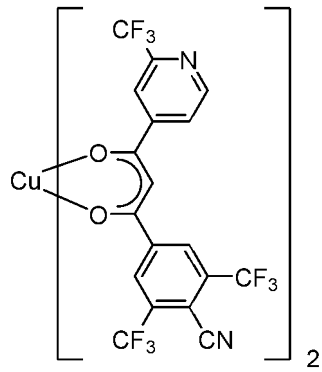, and 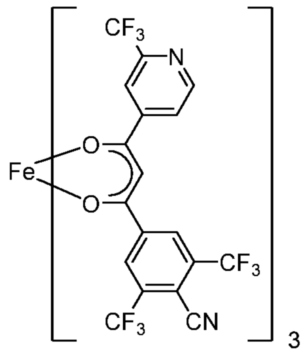,

wherein "i" denotes "iso".

For example, "$^{i}C_3F_7$" denotes iso-heptafluoropropyl. TFSI according to the present invention refers to bis(trifluoromethane)sulfonimide.

According to one embodiment of the invention, the metal complex of formula (I) is selected from one of the following compounds:

$Mg(TFSI)_2$, $Mg[N(SO_2C_4F_9)_2]_2$, $Na[N(SO_2{}^iC_5F_7)_2]$, $Na[N(SO_2C_4F_9)_2]$,

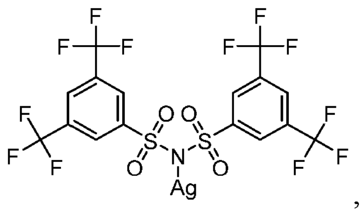,
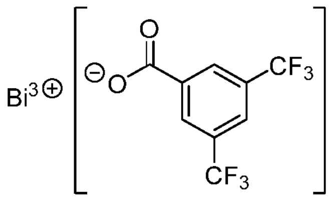,
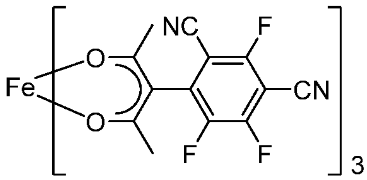

,

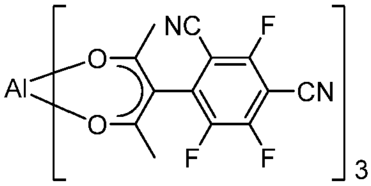,
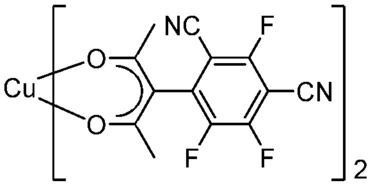,
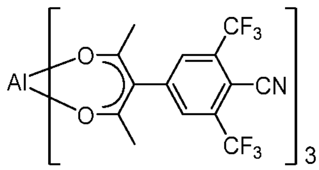,

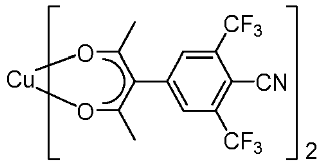,

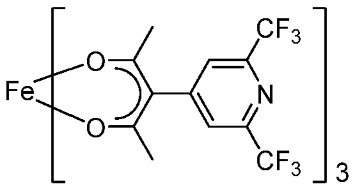,
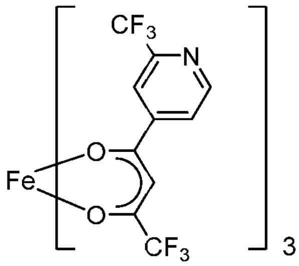,
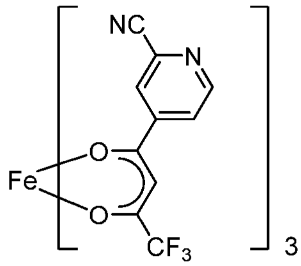,

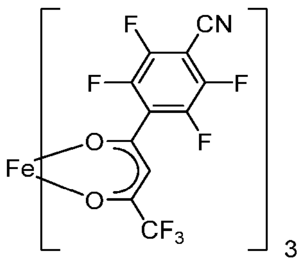,
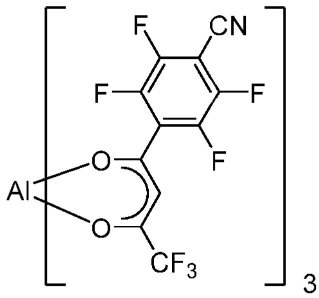,
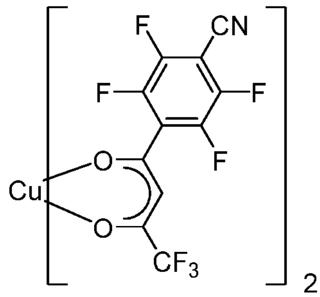,

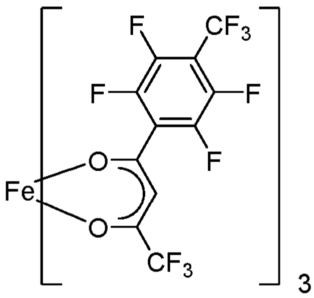, 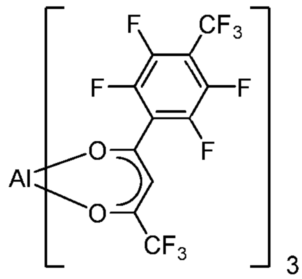, 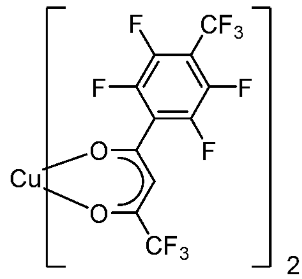,

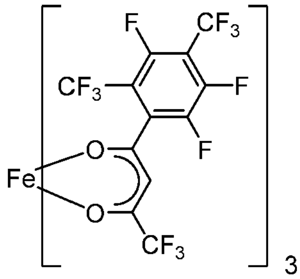, 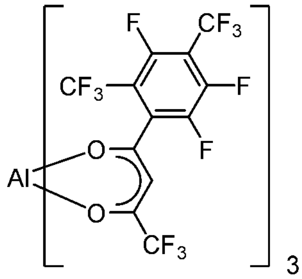, 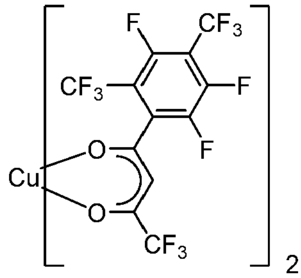,

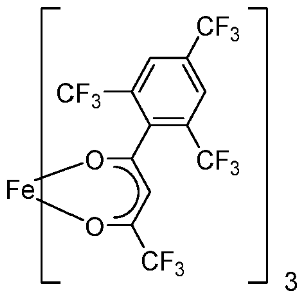, 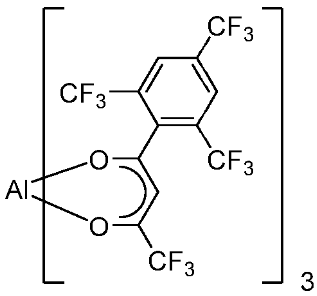, 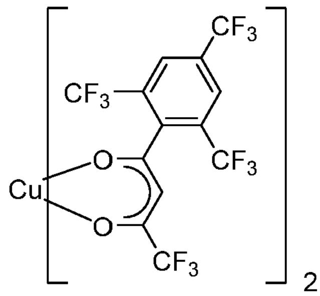,

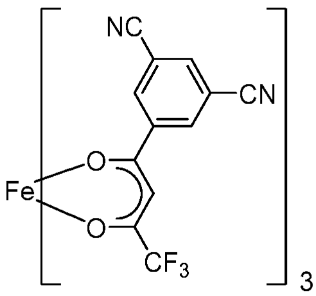, 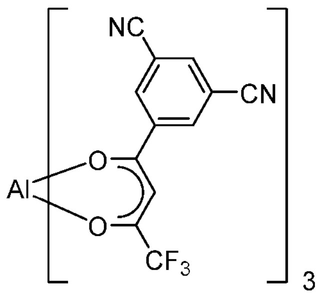, 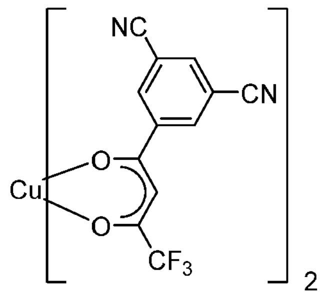,

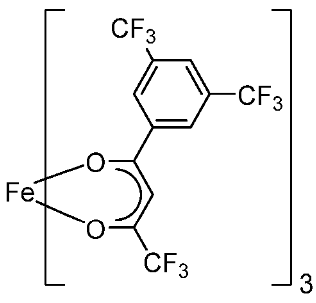, 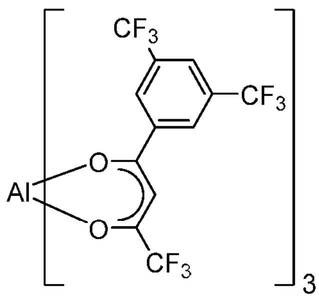, 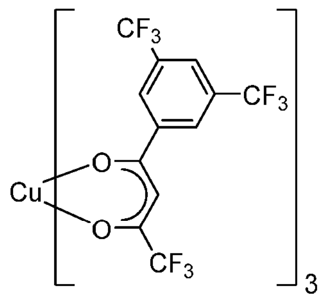,

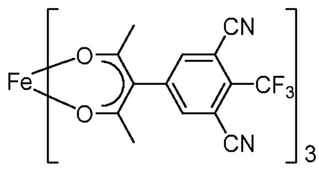, 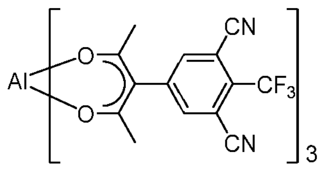, 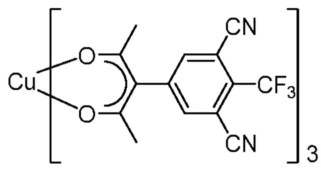,

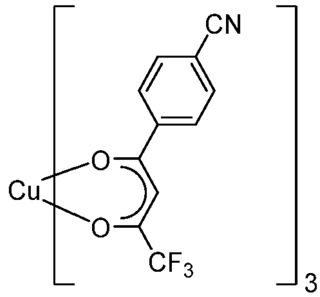,

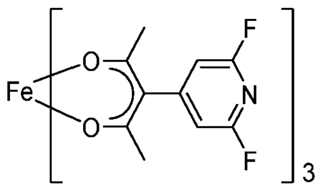, 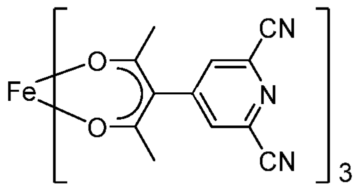, 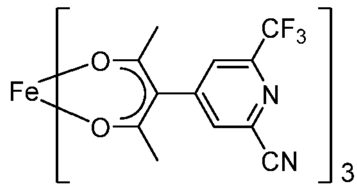,

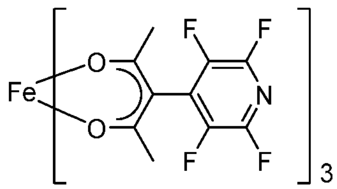, 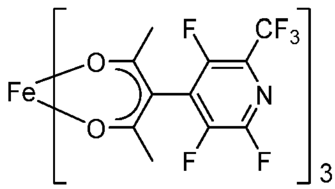, 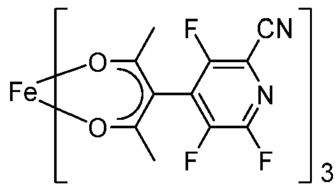,

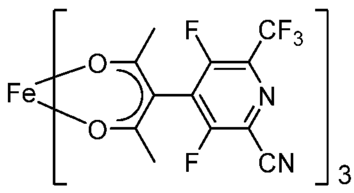, 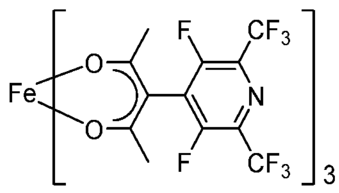, 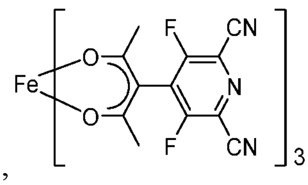,

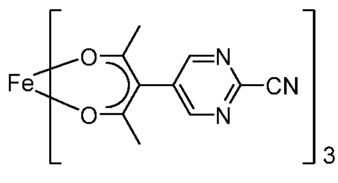, 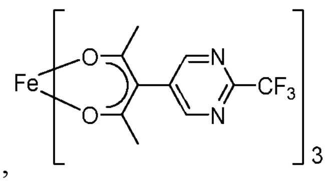, 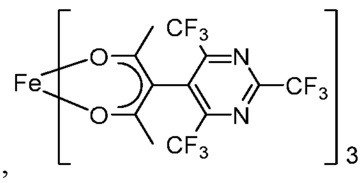,

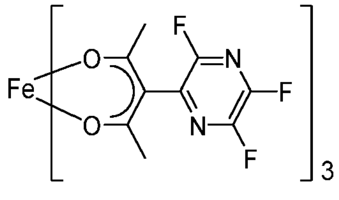, 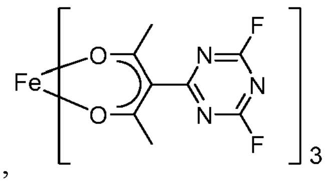, 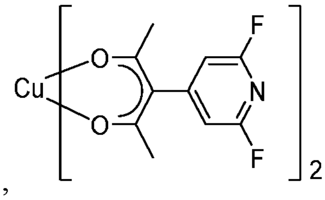,

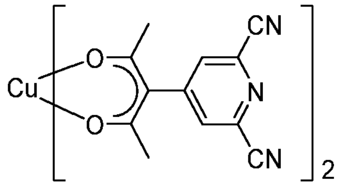,
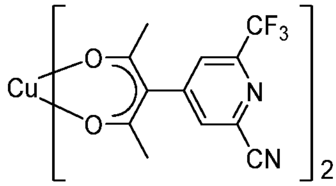,
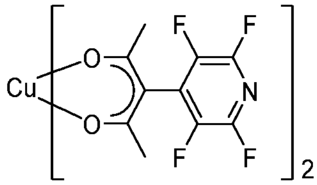,
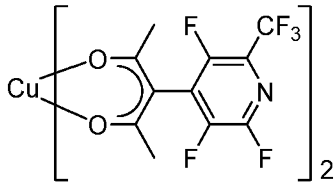,
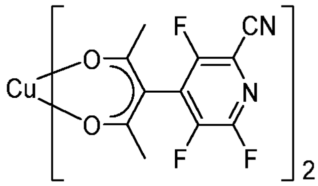,
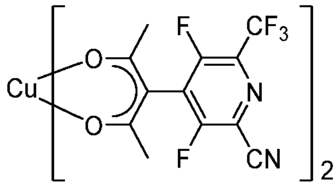,
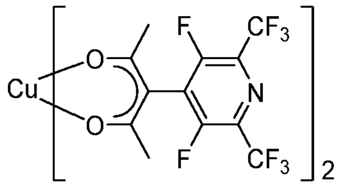,
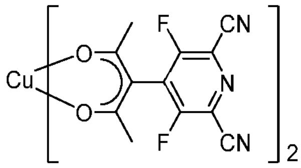,
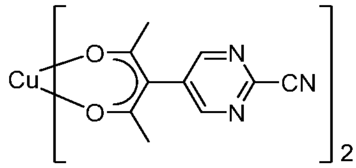,
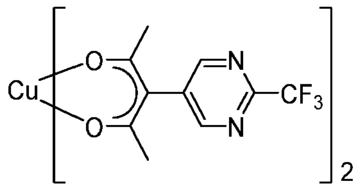,
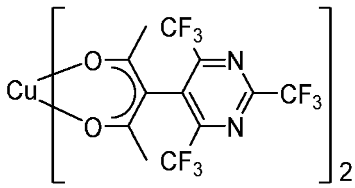,
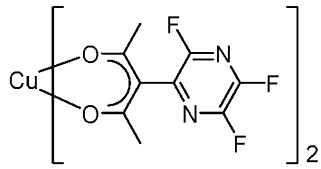,
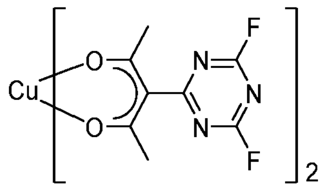,
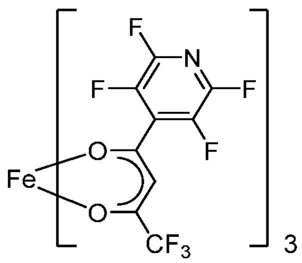,
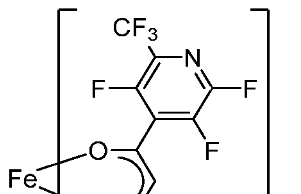,
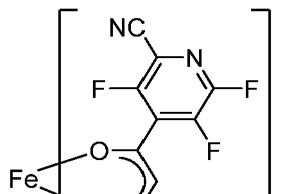,
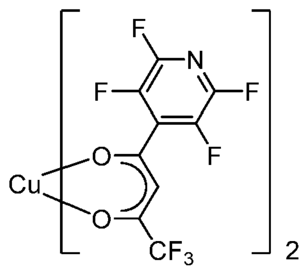,
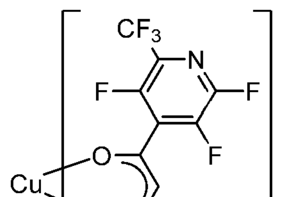,
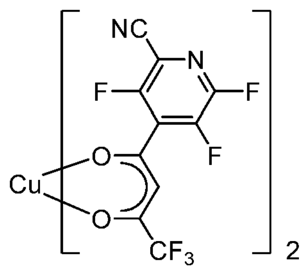,

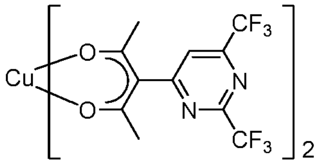, and 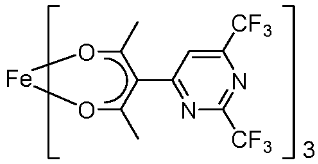,

wherein "i" denotes "iso".

According to one embodiment of the invention, the metal complex of formula (I) is selected from one of the following compounds:

$Mg(TFSI)_2$, $Mg[N(SO_2C_4F_9)_2]_2$, $Na[N(SO_2{}^iC_3F_7)_2]$, Na[N(SO2C4F9)2],

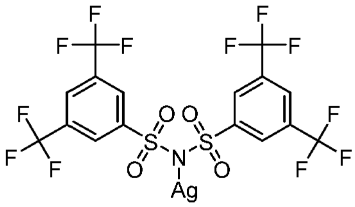 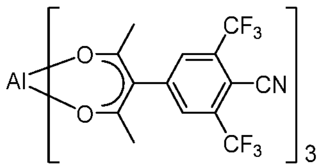, 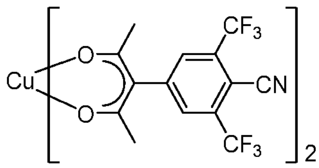,

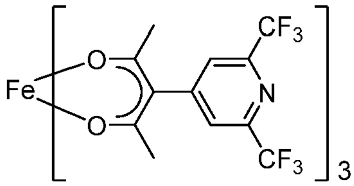, 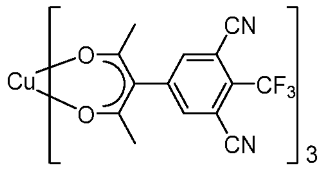, 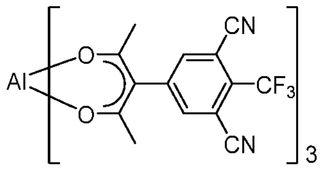,

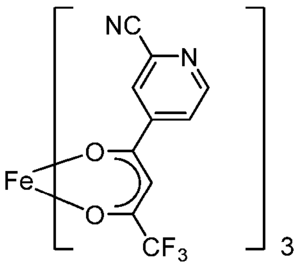, 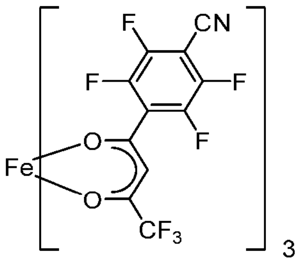, 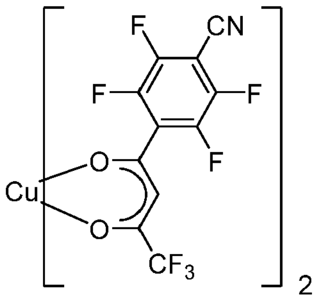,

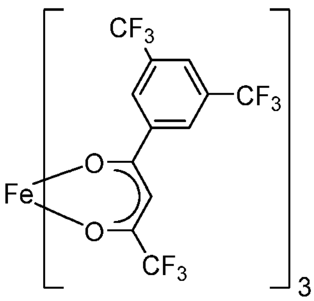, 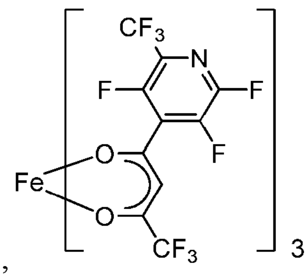, 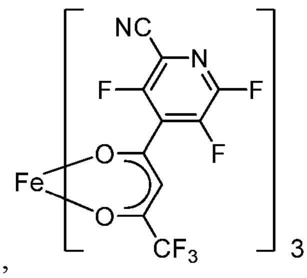,

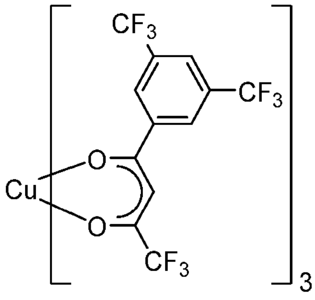, 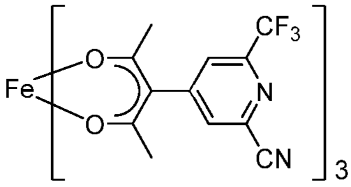, 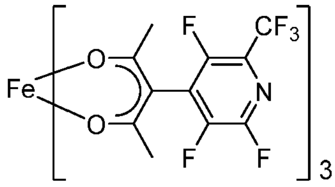,

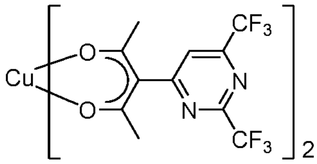, and 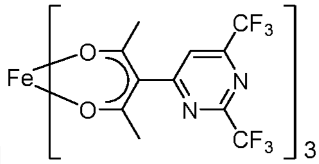,

wherein "i" denotes "iso".

According to one embodiment of the present invention, the semiconductor layer the semiconductor layer comprises a substantially covalent matrix compound.

According to one embodiment of the invention, the substantially covalent matrix compound is selected from at least one organic compound.

According to one embodiment of the invention, the thickness of the organic semiconductor layer is in the range of 1 nm to 20 nm, preferably in the range of 1 nm to 15 nm, more preferably in the range of 2 nm to 10 nm.

According to one embodiment of the invention, the semiconductor layer comprises the metal complex in a range of ≥31 percent by weight to ≤90 percent by weight, based on the total weight of the semiconductor layer, preferably ≥31 percent by weight to ≤85 percent by weight, more preferably ≥31 percent by weight to ≤80 percent by weight, even more preferably ≥31 percent by weight to ≤75 percent by weight; and a substantially covalent matrix compound in a range of ≥10 percent by weight to ≤69 percent by weight, based on the total weight of the semiconductor layer, preferably ≥15 percent by weight to ≤69 percent by weight, more preferably ≥20 percent by weight to ≤69 percent by weight, even more preferably ≥25 percent by weight to ≤69 percent by weight; wherein preferably the percent by weight of the metal complex is higher than the percent by weight of the substantially covalent matrix compound.

Substantially covalent matrix compound

The semiconductor layer may further comprises a substantially covalent matrix compound. According to one embodiment the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the organic electronic device, the semiconductor layer further comprises a substantially covalent matrix compound, wherein the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

Compound of formula (X) or a compound of formula (XI)

According to another aspect of the present invention, the at least one matrix compound, also referred to as "substantially covalent matrix compound", may comprises at least one arylamine compound, diarylamine compound, triarylamine compound, a compound of formula (X) or a compound of formula (XI)

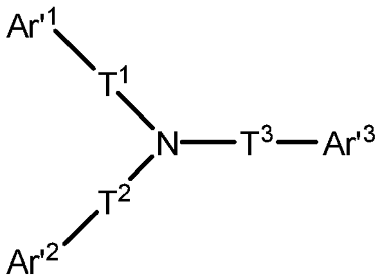
(X),
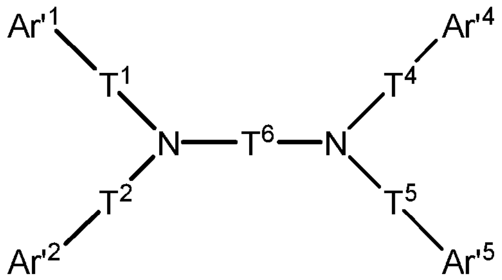
(XI),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
Ar'[1], Ar'[2], Ar'[3], Ar'[4] and Ar'[5] are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar'[1], Ar'[2], Ar'[3], Ar'[4] and Ar'[5] are selected the same or different from the group comprising **H, D,** F, $C(=O)R^2$, CN, $Si(R^2)_3$, $P(=O)(R^2)_2$, $OR^2$, $S(=O)R^2$, $S(=O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently

selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment wherein $Ar'^1$, $Ar'^2$, $Ar'^3$, $Ar'^4$ and $Ar'^5$ may be independently selected from D1 to D16:

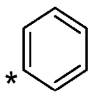 (D1), 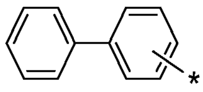 (D2), 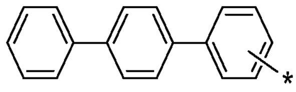 (D3), 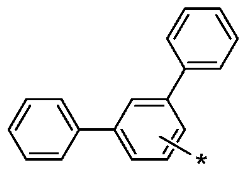 (D4),

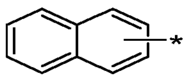 (D5), 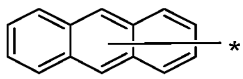 (D6), 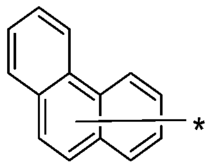 (D7), 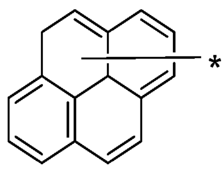 (D8),

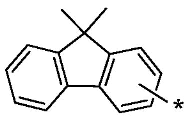 (D9), 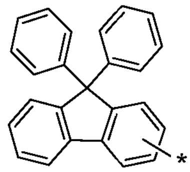 (D10), 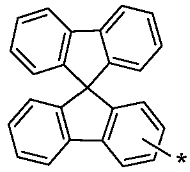 (D11),

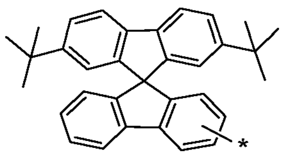 (D12), 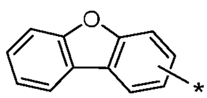 (D13), 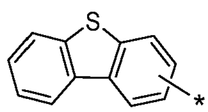 (D14),

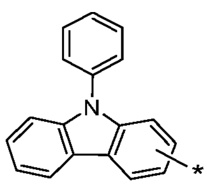 (D15), 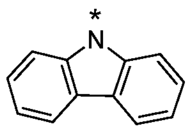 (D16),

, wherein the asterisk "*" denotes the binding position.

According to an embodiment, wherein $Ar'^1$, $Ar'^2$, $Ar'^3$, $Ar'^4$ and $Ar'^5$ may be independently selected from D1 to D15; alternatively selected from D1 to D10 and D13 to D15.

According to an embodiment, wherein $Ar'^1$, $Ar'^2$, $Ar'^3$, $Ar'^4$ and $Ar'^5$ may be independently selected from the group consisting of D1, D2, D5, D7, D9, D10, D13 to D16.

The rate onset temperature may be in a range particularly suited to mass production, when $Ar'^1$, $Ar'^2$, $Ar'^3$, $Ar'^4$

and Ar'[5] are selected in this range.

The "matrix compound of formula (X) or formula (XI)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (X) or formula (XI) are selected from F1 to F18:

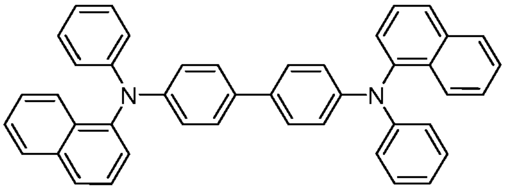
(F1),
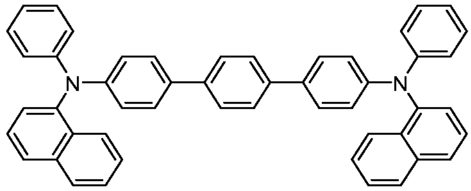
(F2),

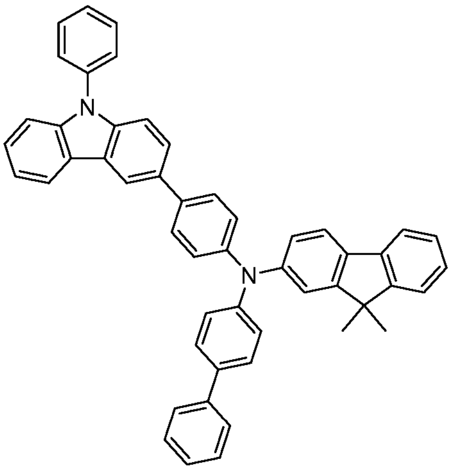
(F3),
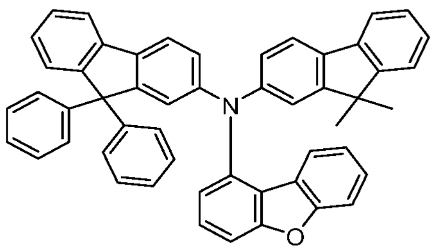
(F4),

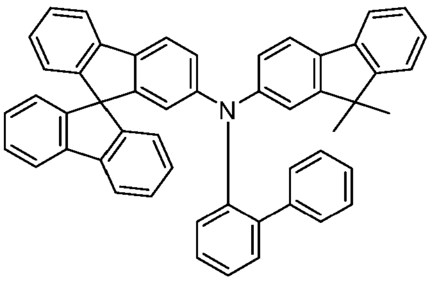
(F5),
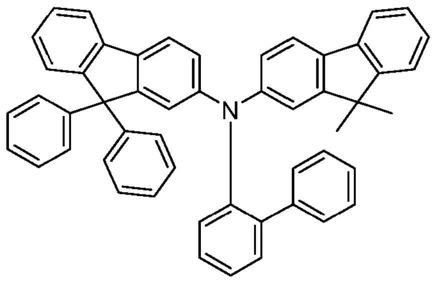
(F6),

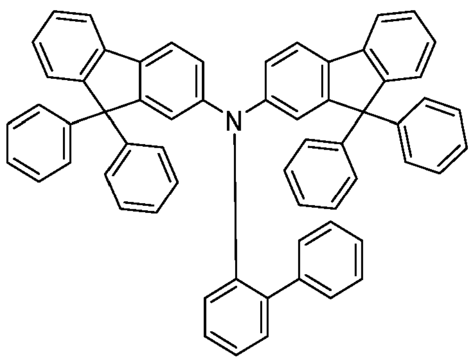
(F7),
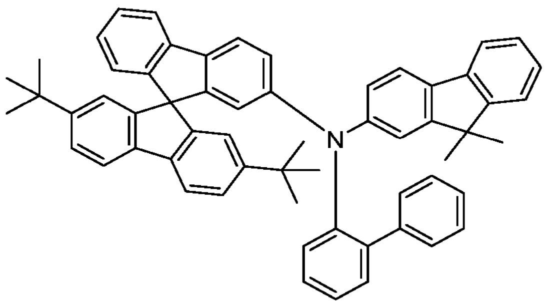
(F8),

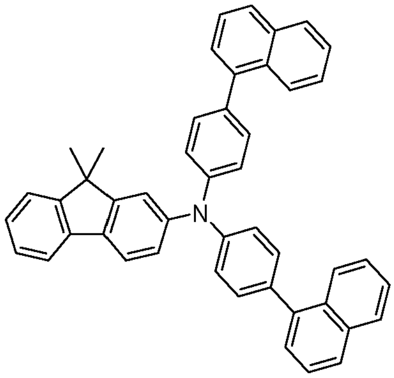
(F9),

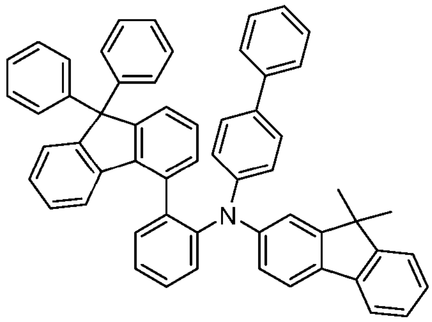
(F10),

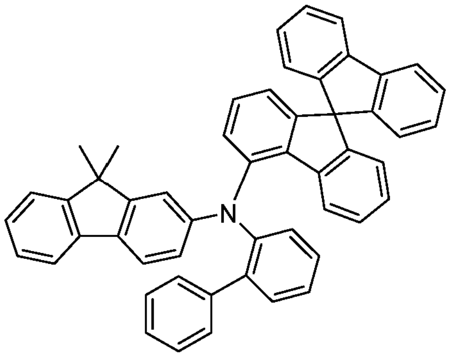
(F11),

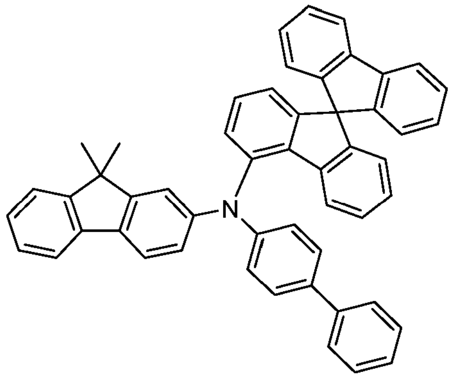
(F12),

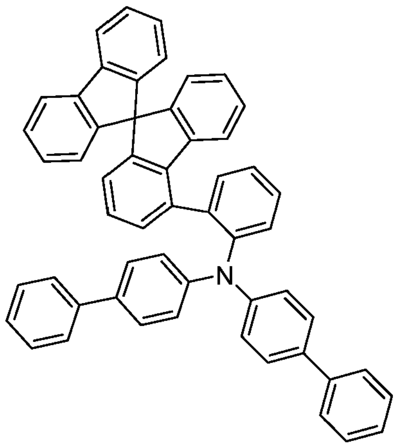
(F13),

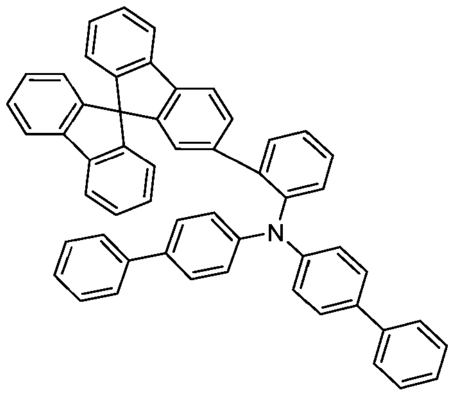
(F14),

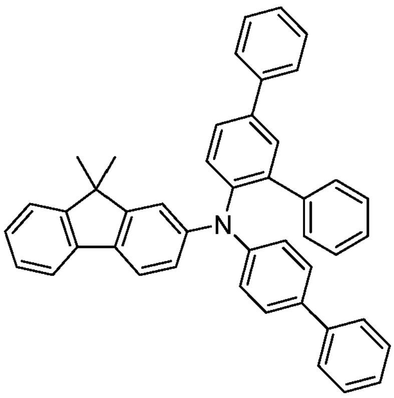
(F15),
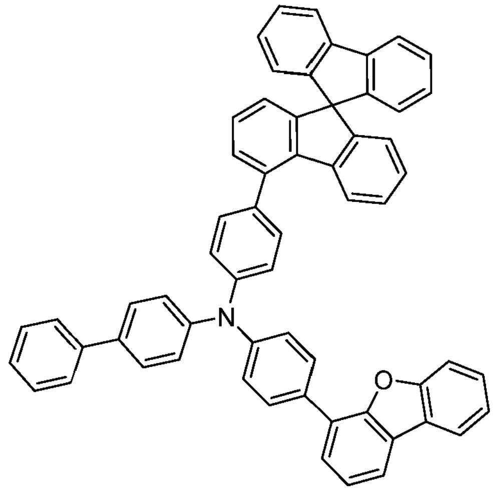
(F16),

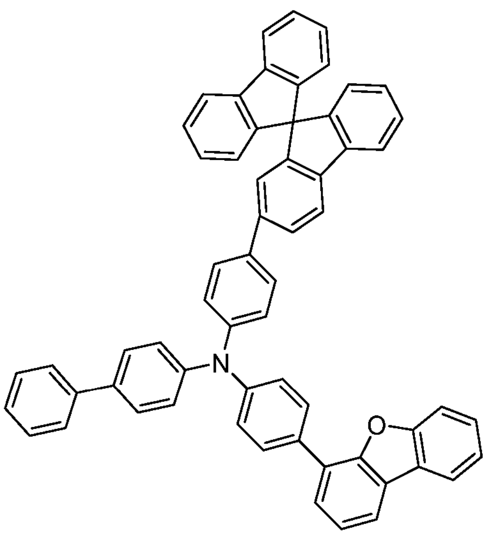
(F17)
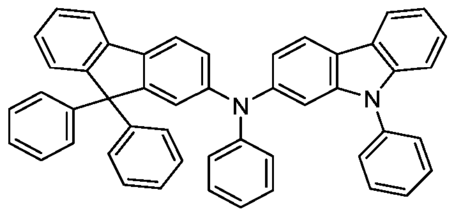
(F18).

**The substantially** covalent matrix compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to one embodiment of the present invention, the semiconductor layer is in direct contact to the anode layer.

According to one embodiment of the present invention the semiconductor layer is non-emissive.

**In** the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the semiconductor layer is arranged between an anode and an emission layer.

According to one embodiment of the present invention, the semiconductor layer is a hole injection layer.

According to one embodiment of the present invention, the hole injection layer comprises a substantially covalent matrix compound.

According to one embodiment of the present invention, the semiconductor layer is a hole injection layer, comprising a first hole injection sub-layer comprising the metal complex and a second hole injection sub-layer comprising the substantially covalent matrix compound, wherein the first hole injection sub-layer is arranged closer to the anode layer and the second hole injection sub-layer is arranged closer to the at least one photoactive layer; preferably the matrix compound consists of a substantially covalent matrix compound; preferably the photoactive layer is an emission layer.

According to one embodiment of the present invention, the semiconductor layer is a hole injection layer, comprising a first hole injection sub-layer consisting essentially of the metal complex and a second hole injection sub-layer comprising the substantially covalent matrix compound, wherein the first hole injection sub-layer is arranged closer to the anode layer and the second hole injection sub-layer is arranged closer to the at least one photoactive layer; preferably the matrix compound consists of a substantially covalent matrix compound; preferably the photoactive layer is an emission layer.

In the context of the present specification the term "consisting essentially of " especially means and/or includes a concentration of ≥ 90% (vol/vol) more preferred ≥ 95% (vol/vol) and most preferred ≥ 99% (vol/vol).

According to one embodiment of the present invention, the anode layer of the organic electronic device comprises in addition a third anode sub-layer; wherein the third anode sub-layer comprises preferably a transparent conductive oxide, wherein the first anode sub-layer is arranged between the third anode sub-layer and the second anode sub-layer.

According to one embodiment of the present invention, the organic electronic device further comprises a hole transport layer, wherein the hole transport layer is arranged between the semiconductor layer and the at least one emission layer.

According to one embodiment of the present invention, the organic electronic device is a light emitting device or a display device.

According to one embodiment of the present invention, the photoactive layer is a light emitting layer.

According to one embodiment of the present invention, the organic electronic device further comprises a substrate.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may has a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the anode layer comprises a first anode sub-layer comprising of Ag, a second anode sub-layer comprising of transparent conductive oxide, preferably **ITO,** and a third anode sub-layer comprising of transparent conductive oxide, preferably ITO; wherein the first anode sub-layer is arranged between the second and the third anode sub-layer.

According to one embodiment of the present invention, the semiconductor layer is in direct contact with the anode layer.

According to one embodiment of the present invention, the hole injection layer is in direct contact with the anode layer.

According to one embodiment of the present invention, the organic semiconductor layer is in direct contact with the anode layer and the anode layer is in direct contact with the substrate, wherein the substrate is selected from a glass substrate, a plastic substrate, a metal substrate or a backplane.

According to one embodiment of the present invention, the hole injection layer is in direct contact with the anode layer and the anode layer is in direct contact with the substrate, wherein the substrate is selected from a glass substrate, a plastic substrate, a metal substrate or a backplane.

The present invention furthermore relates to a display device comprising an organic electronic device according

to the present invention.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

*Hole injection layer*

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/IPSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluorotetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto.

The p-type dopant may be a radialene compound, preferably according to formula (I) or for example 2,2',2"-(cyclopropane-1,2,3-triylidene)tris(2-(p-cyanotetrafluorophenyl)acetonitrile) (CC3).

The p-type dopant concentrations can be selected from 1 to 20 wt.-%, more preferably from 3 wt.-% to 10 wt.-%.

The p-type dopant concentrations can be selected from 1 to 20 vol.-%, more preferably from 3 vol.-% to 10 vol.-%.

*Hole transport layer*

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010. Examples

of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to one embodiment of the present invention, the hole transport layer may comprise a compound of formula (X) or (XI) as described above.

According to one embodiment of the present invention, the hole injection layer and the hole transport layer comprises the same substantially covalent matrix compound as described above.

According to one embodiment of the present invention, the hole injection layer and the hole transport layer comprises the same compound of formula (X) or (XI) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the compound of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

*Electron injection layer (EIL)*

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

According to a preferred embodiment of the present invention, the cathode is transparent.

It is to be understood that the cathode layer is not part of an electron injection layer or the electron transport layer.

*Organic light-emitting diode (OLED)*

The organic electronic device according to the invention may be an organic light-emitting device.
According to one aspect of the present invention, there is provided an organic light-emitting diode (OLED) comprising: a substrate; an anode electrode formed on the substrate; a hole injection layer comprising a compound of formula (I), a hole transport layer, an emission layer, an electron transport layer and a cathode electrode.
According to another aspect of the present invention, there is provided an OLED comprising: a substrate; an anode electrode formed on the substrate; a hole injection layer comprising a compound of formula (I), a hole transport layer, an electron blocking layer, an emission layer, a hole blocking layer, an electron transport layer and a cathode electrode.
According to another aspect of the present invention, there is provided an OLED comprising: a substrate; an anode electrode formed on the substrate; a hole injection layer comprising a compound of formula (I), a hole transport layer, an electron blocking layer, an emission layer, a hole blocking layer, an electron transport layer, an electron injection layer, and a cathode electrode.
According to various embodiments of the present invention, there may be provided OLEDs layers arranged between the above mentioned layers, on the substrate or on the top electrode.
According to one aspect, the OLED may comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.
The organic semiconductor layer according to the invention may be the first hole injection layer and/or the p-type charge generation layer.

Organic electronic device

The organic electronic device according to the invention may be a light emitting device, or a photovoltaic cell, and preferably a light emitting device.
According to another aspect of the present invention, there is provided a method of manufacturing an organic electronic device, the method using:

- at least one deposition source, preferably two deposition sources and more preferred at least three deposition sources.

The methods for deposition that can be suitable comprise:

- deposition via vacuum thermal evaporation;
- deposition via solution processing, preferably the processing is selected from spin-coating, printing, casting; and/or
- slot-die coating.

According to various embodiments of the present invention, there is provided a method using:

- a first deposition source to release the compound of formula (I) according to the invention, and
- a second deposition source to release the substantially covalent matrix compound;

the method comprising the steps of forming the hole injection layer and/or p-type charge generation layer; whereby for an organic light-emitting diode (OLED):

- the hole injection layer and/or p-type charge generation layer is formed by releasing the compound of formula (I) according to the invention from the first deposition source and the substantially covalent matrix compound from the second deposition source.

According to various embodiments of the present invention, the method may further include forming on the anode

electrode, at least one layer selected from the group consisting of forming a hole transport layer or forming a hole blocking layer, and an emission layer between the anode electrode and the first electron transport layer.

According to various embodiments of the present invention, the method may further include the steps for forming an organic light-emitting diode (OLED), wherein

- on a substrate an anode electrode is formed,
- on the anode electrode a hole injection layer comprising a compound of formula (I) is formed,
- on the hole injection layer comprising a compound of formula (I) a hole transport layer is formed,
- on the hole transport layer an emission layer is formed,
- on the emission layer an electron transport layer is formed, optionally a hole blocking layer is formed on the emission layer,
- and finally a cathode electrode is formed,
- optional a hole blocking layer is formed in that order between the first anode electrode and the emission layer,
- optional an electron injection layer is formed between the electron transport layer and the cathode electrode.

According to various embodiments, the OLED may have the following layer structure, wherein the layers having the following order:
anode, hole injection layer comprising a compound of formula (I) according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

<u>Figures 1 to 9</u>

FIG. 1 is a schematic sectional view of an organic electronic device, according to an exemplary embodiment of the present invention;

FIG. 2 is a schematic sectional view of an organic electronic device, according to an exemplary embodiment of the present invention;

FIG. 3 is a schematic sectional view of an organic electronic device, according to an exemplary embodiment of the present invention.

FIG. 4 is a schematic sectional view of an organic electronic device, according to an exemplary embodiment of the present invention;

FIG. 5 is a schematic sectional view of an organic electronic device, according to an exemplary embodiment of the present invention;

FIG. 6 is a schematic sectional view of an organic electronic device, according to an exemplary embodiment of the present invention;

FIG. 7 is a schematic sectional view of an organic electronic device, according to an exemplary embodiment of the present invention;

FIG. 8 is a schematic sectional view of an organic electronic device, according to an exemplary embodiment of the present invention;

FIG. 9 is a schematic sectional view of an organic electronic device, according to an exemplary embodiment of the present invention.

Hereinafter, the figures 1 to 9 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a first emission layer (EML) (150), and a cathode layer (190) are disposed.

FIG. 2 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120) comprising a first anode sub-layer (121), a second anode sub-layer (122) and a third anode sub-layer (123). Onto the HIL (130), a first emission layer (EML) (150), and a cathode layer (190) are disposed.

FIG. 3 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130) comprising a first hole injection sub-layer (131) and a second hole injection sub-layer (132). The HIL (130) comprising a first hole injection sub-layer (131) and a second hole injection sub-layer (132) is disposed on the anode layer (120). Onto the HIL (130), a first emission layer (EML) (150), and a cathode layer (190) are disposed.

FIG. 4 is a schematic sectional view of an organic electronic device (100), according to an exemplary embodiment of the present invention. The organic electronic device (100) includes a substrate (110), an anode layer (120) that comprises a first anode sub-layer (121) a second anode sub-layer (122) and a third anode sub-layer (123), and a hole injection layer (HIL) (130) comprising a first hole injection sub-layer (131) and a second hole injection sub-layer (132). The HIL (130) comprising a first hole injection sub-layer (131) and a second hole injection sub-layer (132) is disposed on the anode layer (120). Onto the HIL (130), a first emission layer (EML) (150), and a cathode layer (190) are disposed.

FIG. 5 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120). Onto the HIL (130), an hole transport layer (HTL) (140), a first emission layer (EML) (150), a hole blocking layer (BL) (155), an electron transport layer (ETL) (160), and a cathode layer (190) are disposed.

FIG. 6 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), an hole transport layer (HTL) (140), a first emission layer (EML) (150), a hole blocking layer (HBL) (155), an electron transport layer (ETL) (160), and a cathode layer (190) are disposed.

FIG. 7 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

FIG. 8 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) comprises a first hole injection sub-layer (131) and a second hole injection sub-layer (132), wherein the first hole injection sub-layer (131) is disposed on the second anode sub-layer (122) and the second hole injection sub-layer (132) is disposed on the first hole injection sub-layer (131). Onto the HIL (130), a hole transport layer (HTL) (140), an

electron blocking layer (EBL) (145), a first emission layer (EML) (150), a hole blocking layer (HBL) (155), an electron transport layer (ETL) (160), and a cathode layer (190) are disposed.

FIG. 9 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), an electron injection layer (EIL) (180) and a cathode layer (190) are disposed.

While not shown in Fig. 1 to Fig. 9, a capping and/or a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

## Detailed description

The invention is furthermore illustrated by the following examples which are illustrative only and non-binding.

Metal complexes in particular compounds of formula (I) may be prepared as described below or are commercially available:

**Synthesis of tris(((Z)-4-oxo-3-(2,3,5-trifluoro-6-(trifluoromethyl)pyridin-4-yl)pent-2-en-2-yl)oxy)iron (E1)**

Synthesis of 3-(2,3,5-trifluoro-6-(trifluoromethyl)pyridin-4-yl)pentane-2,4-dione (ligand)

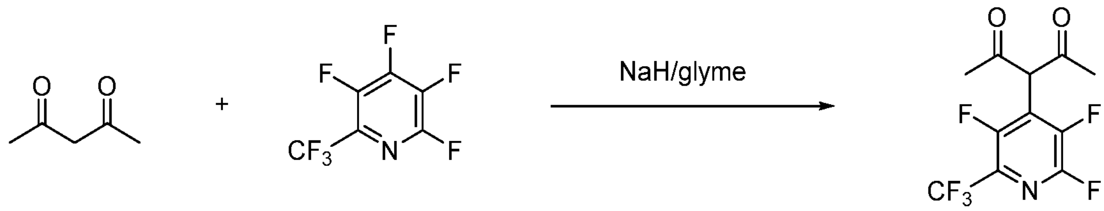


To 2.41g (100.43 mmol) sodium hydride in a flame-dried Schleck flask 200mL dry glyme was added via a double-needle cannula. The suspension was cooled with an ice-bath and 10.3mL (100.43mmol) of acetylacetone was added dropwise. During the addition the temperature should not rise above 10 °C. 20 g (91.30mmol) of 2,3,4,5-tetrafluoro-6-(trifluormethyl)pyridine was added with a syringe. The mixture was stirred at room temperature for 5 days and then added to 0.5L water, and acidified with conc. HCl to pH 1. The product was extracted with ethyl acetate. The combined organic layers were washed with water, dried over sodium sulfate, filtered and the solvent was removed under reduced pressure. The crude product was dissolved in hot methanol/water (3: 1) and after cooling the precipitate was filtered off and dried in high vacuum. Yield: 10.5g (38%)

Synthesis of tris(((Z)-4-oxo-3-(2,3,5-trifluoro-6-(trifluoromethyl)pyridin-4-yl)pent-2-en-2-yl)oxy)iron (E1)

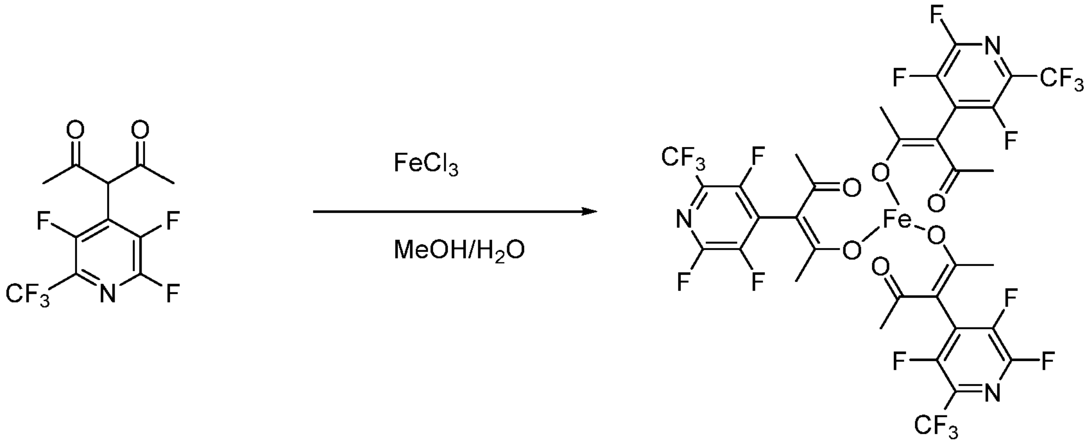


7.0g (23.4mmol) of substituted acetylacetone was dissolved in 70mL of methanol. 1.90g (23.4mmol) of sodium bicarbonate was dissolved in 20mL of water and added to the solution. The resulting suspension was heated to reflux and to the cloudy solution a solution of 1.27g (7.8 mmol) iron(III)chloride in 5mL water was added drop wise. The mixture was stirred for 30min under reflux. After cooling the residue was filtered off and washed with water. The crude product was dissolved in THF and precipitated from methanol/water, filtered off and dried in high vacuum. Yield: 5.17g (70%)

Synthesis of **tris(((Z)-3-(2,6-bis(trifluoromethyl)pyridin-4-yl)-4-oxopent-2-en-2-yl)oxy)iron** (E2)

Synthesis of 3-(2,6-bis(trifluoromethyl)pyridin-4-yl)pentane-2,4-dione (ligand)

83.20g (252.3mmol) caesium carbonate were suspended in 250mL dry DMF under inert conditions and cooled using an ice bath. 13mL (43.9mmol) acetylacetone were added drop wise to the cold suspension and 26.23g (105.1mmol) of 4-chloro-2,6-bis(trifluoromethyl)pyridine were added with nitrogen counterflow. The mixture was heated to 60°C for 20h. The solid was filtered off and washed with ethyl acetate. The mother liquor was added to 400mL 2N hydrochloric acid. After phase separation, the aqueous layer was extracted with ethyl acetate and the combined organic layers were washed with brine, dried over magnesium sulphate and the solvent removed under reduced pressure. The crude product was slurry washed with methanol/water, dissolved in dichloromethane and hexane (1:10), filtered over silica gel and sublimed in high vacuum at 100°C. 17.8g (54%) product was obtained as a yellow-white solid.

Synthesis of tris(((Z)-3-(2,6-bis(trifluoromethyl)pyridin-4-yl)-4-oxopent-2-en-2-yl)oxy)iron (E2)

17.05g (54,44mmol) of 3-(2,6-bis(trifluoromethyl)pyridin-4-yl)pentane-2,4-dione were suspended in 160mL methanol and 4.57g (54.44mmol) sodium bicarbonate were added. 2,94g (18.15 mmol) iron trichloride were dissolved cautiously in 20ml water and added drop wise to the suspension. The mixture was stirred at room temperature overnight. The solid was filtered off, washed carefully with water and dried in high vacuum. 13.4g crude product was recrystallized from 120ml chlorobenzene to obtain 9,56g (53%) as an orange solid. A 2nd fraction (2.03g, 11%) was obtained from crystallisation of the mother liquor in 40mL chlorobenzene.

**Synthesis of 4-(2,4-dioxopentan-3-yl)-2,6-bis(trifluoromethyl)benzonitrile (ligand)**

28.6g (87.7mmol) caesium carbonate were suspended in 100mL dry DMF under inert conditions. 4.5mL (43.9mmol) acetylacetone and 10g (36.6mmol) of 4-chloro-2,6-bis(trifluoromethyl)benzonitrile were added at room temperature. The mixture was heated to 60°C for 20h. The solid was filtered off and washed with ethyl acetate. The mother liquor was added to 250mL 2N hydrochloric acid. After phase separation, the aqueous layer was extracted with ethyl acetate and the combined organic layers were washed with brine, dried over magnesium sulphate and the solvent removed under reduced pressure. The crude product was slurry washed with methanol/water and ethyl acetate/hexane to obtain 8.7g (71% yield) product as an off-white, crystalline solid.

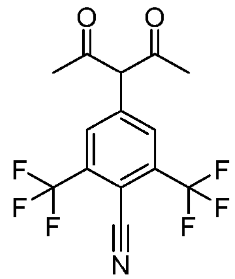

4-(2,4-dioxopentan-3-yl)-2,6-bis(trifluoromethyl)benzonitrile

**Synthesis of bis(((Z)-3-(4-cyano-3,5-bis(trifluoromethyl)phenyl)-4-oxopent-2-en-2-yl)oxy)copper (E3)**

3.0g (8.9mmol) of 4-(2,4-dioxopentan-3-yl)-2,6-bis(trifluoromethyl)benzonitrile were dissolved in 20ml acetonitrile and 0.89g (4.45mmol) copper(II) acetate monohydrate were added. The mixture was stirred at room temperature for one hour. 30ml water were added and the precipitate filtered off, washed with water and hexane and dried in high vacuum. 3.15g (96%) product was obtained as a greyish-violet powder.

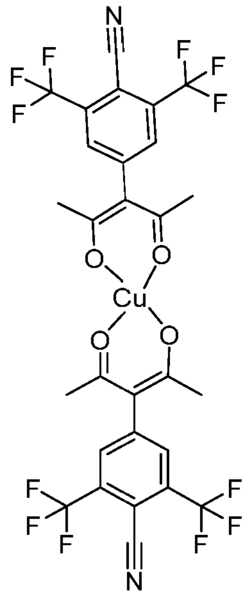

bis(((Z)-3-(4-cyano-3,5-bis(trifluoromethyl)phenyl)-4-oxopent-2-en-2-yl)oxy)copper

**Magnesium bis(trifluoromethylsulfonyl)imide (E4)**

Magnesium bis(trifluoromethylsulfonyl)imide (E4) [[133395-16-1]) is commercially available from Alfa Aesar or ABCR.

**Synthesis of sodium bis((perfluoropropan-2-yl)sulfonyl)amide (E5)**

5.0g (10.39mmol) bis((perfluoropropan-2-yl)sulfonyl)amide was dissolved in 40mL water and 0.55g (5.20mmol) sodium carbonate dissolved in 10mL water and added drop wise. The mixture was stirred for 1 hour and the solvent cautiously removed under reduced pressure. 30ml toluene were added to the residue and removed under reduced pressure. After repeating the last step the product was dried overnight in high vacuum . 4.80g (92%) product was obtained as a white solid.

**Synthesis of magnesium bis((perfluorobutyl)sulfonyl)amide (E6)**

5.1g (8.77mmol) bis((perfluorobutyl)sulfonyl)amide was dissolved in 20mL dry methyl tert-butyl ether and 0.2g

(8.77mmol) magnesium turnings were added. The mixture was heated to 50°C for one hour. The solvent was removed under reduced pressure and 40ml dry toluene was added. Half the solvent was removed under reduced pressure and the mixture was stirred in an ice bath for 30min. The precipitate was filtered off using a Schlenk frit and was washed toluene. The residue was treated again with 0,1g magnesium in 10mL methyl tert-butyl ether at 50°C for one hour, the excess magnesium was filtered off and the solvent removed under reduced pressure and the residue dried in high vacuum overnight. 3.23g (65%) product was obtained as white solid.

**(Bismuthanetriyltris(oxy))tris((3,5-bis(trifluoromethyl)phenyl)methanone) (E7)**

A mixture of 3.84g (14.9 mmol, 3.1 eq.) of 3,5-bis-trifluoromethyl benzoic acid and 2.31g (4.8 mmol) of tri-o-tolyl bismuthine in 80ml of toluene was stirred and heated at 80°C for 2h under dry conditions. After cooling to room temperature, the suspension was filtered and the obtained solid washed with toluene (2x10ml), then dried over night at 50°C in a high vacuum. Yield: 4.5g (98%) of a creamy-white fluffy solid.

**Synthesis of sodium sodium bis((perfluorobutyl)sulfonyl)amide (E8)**

10.2g (17.55mmol) bis((perfluorobutyl)sulfonyl)amide was dissolved in 50mL water and 0.93g (8.77mmol) sodium carbonate dissolved in 10mL water and added drop wise. The product was dried overnight in high vacuum. 10.6g (100%) product was obtained as a white solid.

General procedure for fabrication of organic electronic devices comprising a hole injection layer comprising a metal complex and a matrix compound

For Examples 1 - 28 in Table 2, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment, see Table 2, to prepare the anode layer. The plasma treatment was performed in nitrogen atmosphere or in an atmosphere comprising 97.6 vol.-% nitrogen and 2.4 vol.-% oxygen, see Table 2.

Then, the matrix compound (F4) N-(9,9-dimethyl-9H-fluoren-2-yl)-N-(9,9-diphenyl-9H-fluoren-2yl)dibenzo[b,d]furan-1-amine and the metal complex given in Table 2 were co-deposited in vacuum on the anode layer, to form a hole injection layer (HIL) having a thickness as given in Table 2.

Then, the matrix compound (F4) N-(9,9-dimethyl-9H-fluoren-2-yl)-N-(9,9-diphenyl-9H-fluoren-2yl)dibenzo[b,d]furan-1-amine was vacuum deposited on the HIL, to form a HTL having a thickness of 128 nm. The matrix compound in the HTL is selected the same as the matrix compound in the HIL. The matrix compound can be seen in Table 2.

Then N,N-di([1,1'-biphenyl]-4-yl)-3'-(9H-carbazol-9-yl)-[1,1'-biphenyl]-4-amine was vacuum deposited on the HTL, to form an electron blocking layer (EBL) having a thickness of 5 nm.

Then 97 vol.-% H09 as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then electron injection layer having a thickness of 2 nm was formed on the electron transporting layer by depositing Yb.

Then Ag:Mg (90: 10 -wt %) was evaporated at a rate of 0.01 to 1 Å/s at $10^{-7}$ mbar to form a cathode layer with a thickness of 13 nm on the electron injection layer.

Then, F3 was deposited on the cathode layer to form a capping layer with a thickness of 75 nm.

Comparative examples 1 to 3 - Bottom emission on ITO

For comparative examples 1 to 3 in Table 2, a 15Ω /cm$^2$ glass substrate with 90 nm ITO (available from Corning Co.) was cut to a size of 50 mm x 50 mm x 0.7 mm, ultrasonically washed with water for 60 minutes and then with isopropanol for 20 minutes. The liquid film was removed in a nitrogen stream..

Then, 69 wt.-% F4 and 31 wt.-% E1 were co-deposited in vacuum on the anode layer, to form a hole injection layer (HIL) having a thickness as given in Table 2.

Then, F4 was vacuum deposited on the HIL, to form a HTL having a thickness of 135 nm.

Then, the EBL, EML, HBL and ETL are deposited in this order on the HTL, as described in the general procedure of manufacture above.

Then Al was evaporated at a rate of 0.01 to 1 Å/s at $10^{-7}$ mbar to form a cathode layer with a thickness of 100 nm on the electron transporting layer.

Comparative examples 4 to 6 - Top emission on Ag

In comparative examples 4 to 6 (Table 2), the anode layer consists of Ag. The anode layer was either treated with plasma in nitrogen atmosphere or in an atmosphere comprising 97.6 vol.-% nitrogen and 2.4 vol.-% oxygen, or not treated with plasma.

Then, 69 wt.-% F4 and 31 wt.-% E1were co-deposited in vacuum on the anode layer, to form a hole injection layer (HIL) having a thickness as given in Table 2.

Then, F4 was vacuum deposited on the HIL, to form a HTL having a thickness of 135 nm.

Then, the EBL, EML, HBL and ETL are deposited in this order on the HTL, as described in the general procedure for manufacture above.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 10 mA/cm$^2$ is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 10 mA/cm$^2$.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm$^2$.

Lifetime LT of the device is measured at ambient conditions (20°C) and 30 mA/cm$^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U = [U100\ h) - U(1h)]$$

or the operating voltage after 1 hour after the start of operation of the device from the operating voltage after 100 hours.

$$\Delta U = [U100\ h) - U(1h)]$$

The smaller the value of ΔU the better is the operating voltage stability.

Technical Effect of the invention

Table 1: Structures of metal complexes used in the examples.

| Structure | Name |
|---|---|
| 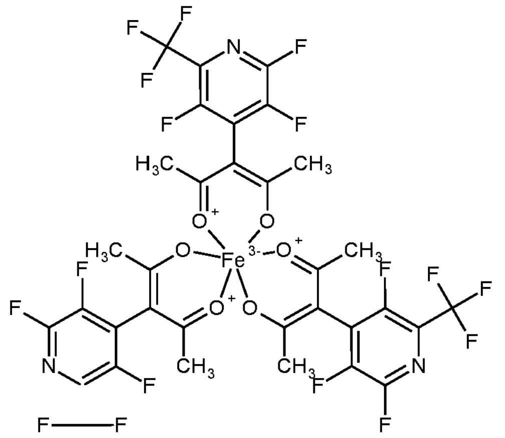 | E1 |
| 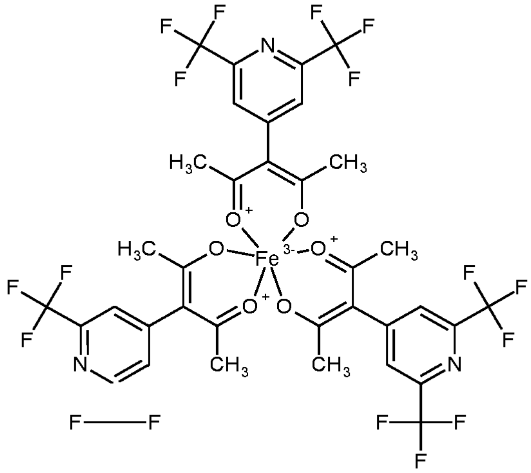 | E2 |
| 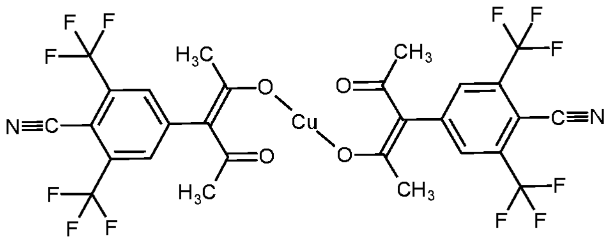 | E3 |
| 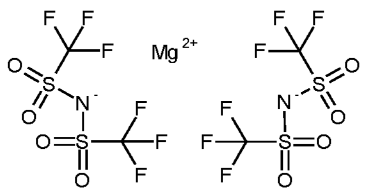 | E4 |
| 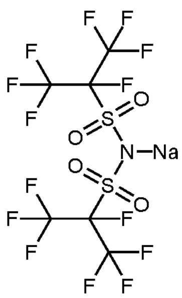 | E5 |

(continued)

| Structure | Name |
|---|---|
| 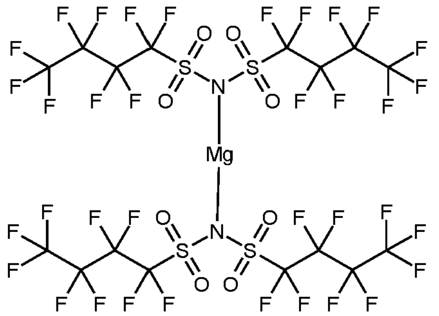 | E6 |
| 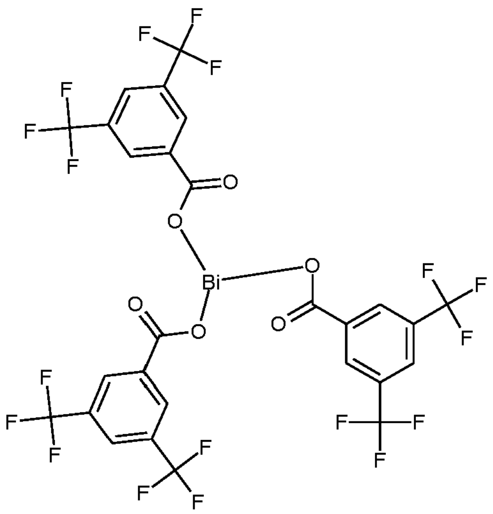 | E7 |
| 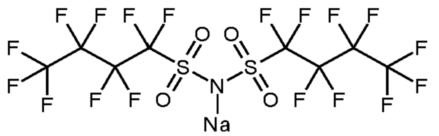 | E8 |

Table 2: Results

| | Anode | Plasma | Layer thickness [nm] | p-HIL | | Concentration metal compex [wt%] | Voltage [V] | Ceff at 10 mA/cm$^2$ [cd/A] | EQE At 10 mA/cm2 [%] |
|---|---|---|---|---|---|---|---|---|---|
| | | | | complex | host | | | | |
| Comp. Ex 1 | ITO | $N_2$ | 3 | **E1** | F4 | 31 | 10.05 | 4.92 | 5.59 |
| Comp. Ex 2 | ITO | $N_2$ | 5 | **E1** | F4 | 31 | 10.01 | 4.98 | 5.65 |
| Comp. Ex 3 | ITO | $N_2$ | 10 | **E1** | F4 | 31 | 10.60 | 4.89 | --- |
| Comp. Ex 4 | Ag | $N_2$; $N_2$:$O_2$; or with-out | 3 | **E1** | F4 | 31 | >10 | --- | --- |

(continued)

| | Anode | Plasma | Layer thickness [nm] | p-HIL | | Concentration metal compex [wt%] | Voltage [V] | Ceff at 10 mA/cm$^2$ [cd/A] | EQE At 10 mA/cm2 [%] |
|---|---|---|---|---|---|---|---|---|---|
| | | | | complex | host | | | | |
| Comp. Ex 5 | Ag | $N_2$; $N_2$:$O_2$; or with-out | 5 | **E1** | F4 | 31 | >10 | --- | --- |
| Comp. Ex 6 | Ag | $N_2$; $N_2$:$O_2$; or with-out | 10 | **E1** | F4 | 31 | >10 | --- | --- |
| Inv. Ex 1 | ITO/Ag/ITO | $N_2$ | 5 | **E1** | F4 | 31 | 4.43 | 6.09 | 12.19 |
| Inv. Ex 2 | ITO/Ag/ITO | $N_2$:$O_2$ | 3 | **E1** | F4 | 31 | 3.73 | 6.88 | 13,96 |
| Inv. Ex 3 | ITO/Ag/ITO | $N_2$:$O_2$ | 5 | **E1** | F4 | 31 | 3.71 | 6.91 | 13,96 |
| Inv. Ex 4 | ITO/Ag/ITO | $N_2$:$O_2$ | 10 | **E1** | F4 | 31 | 3.70 | 6.94 | 13,88 |
| Inv. Ex 5 | ITO/Ag/ITO | $N_2$:$O_2$ | 3 | **E1** | F4 | 50 | 3.72 | 6.97 | 13.88 |
| Inv. Ex 6 | ITO/Ag/ITO | $N_2$:$O_2$ | 5 | **E1** | F4 | 50 | 3.71 | 6.89 | 13.87 |
| Inv. Ex 7 | ITO/Ag/ITO | $N_2$:$O_2$ | 3 | **E1** | F4 | 75 | 3.72 | 6.87 | 13.93 |
| Inv. Ex 8 | ITO/Ag/ITO | $N_2$:$O_2$ | 5 | **E1** | F4 | 75 | 3.72 | 6.86 | 13.91 |
| Inv. Ex 9 | ITO/Ag/ITO | $N_2$:$O_2$ | 3 | **E3** | F4 | 31 | 3.71 | 6.78 | 13.83 |
| Inv. Ex 10 | ITO/Ag/ITO | $N_2$:$O_2$ | 5 | **E3** | F4 | 31 | 3.70 | 6.98 | 13.99 |
| Inv. Ex 11 | ITO/Ag/ITO | $N_2$:$O_2$ | 10 | **E3** | F4 | 31 | 3.69 | 6.93 | 13.94 |
| Inv. Ex 12 | ITO/Ag/ITO | $N_2$:$O_2$ | 3 | **E2** | F4 | 31 | 3.71 | 6.74 | 13.93 |
| Inv. Ex 13 | ITO/Ag/ITO | $N_2$:$O_2$ | 5 | **E2** | F4 | 31 | 3.69 | 6.76 | 13.96 |
| Inv. Ex 14 | ITO/Ag/ITO | $N_2$:$O_2$ | 10 | **E2** | F4 | 31 | 3.68 | 6.67 | 13.82 |
| Inv. Ex 15 | ITO/Ag/ITO | $N_2$:$O_2$ | 3 | **E2** | F4 | 40 | 3.69 | 7.04 | 13.96 |
| Inv. Ex 16 | ITO/Ag/ITO | $N_2$:$O_2$ | 5 | **E2** | F4 | 40 | 3.67 | 6.91 | 13.83 |
| Inv. Ex 17 | ITO/Ag/ITO | $N_2$:$O_2$ | 10 | **E2** | F4 | 40 | 3.68 | 6.83 | 13.70 |

(continued)

| | Anode | Plasma | Layer thickness [nm] | p-HIL | | Concentration metal compex [wt%] | Voltage [V] | Ceff at 10 mA/cm$^2$ [cd/A] | EQE At 10 mA/cm2 [%] |
|---|---|---|---|---|---|---|---|---|---|
| | | | | complex | host | | | | |
| Inv. Ex 18 | ITO/Ag/ITO | $N_2$:$O_2$ | 3 | **E2** | F4 | 50 | 3.72 | 6.87 | 13.93 |
| Inv. Ex 19 | ITO/Ag/ITO | $N_2$:$O_2$ | 5 | **E2** | F4 | 50 | 3.68 | 6.64 | 13.82 |
| Inv. Ex 20 | ITO/Ag/ITO | $N_2$:$O_2$ | 7 | **E2** | F4 | 50 | 3.69 | 6.65 | 13.73 |
| Inv. Ex 21 | ITO/Ag/ITO | $N_2$:$O_2$ | 10 | **E2** | F4 | 50 | 3.72 | 6.46 | 13.48 |
| Inv. Ex 22 | ITO/Ag/ITO | $N_2$:$O_2$ | 3 | **E2** | F4 | 75 | 3.70 | 6.89 | 14.03 |
| Inv. Ex 23 | ITO/Ag/ITO | $N_2$:$O_2$ | 5 | **E2** | F4 | 75 | 3.71 | 6.85 | 13.90 |
| Inv. Ex 24 | ITO/Ag/ITO | $N_2$:$O_2$ | 10 | **E5** | F4 | 31 | 3.68 | 6,89 | 14,03 |
| Inv. Ex 25 | ITO/Ag/ITO | $N_2$:$O_2$ | 10 | **E4** | F4 | 31 | 3,68 | 6,92 | 14,02 |
| Inv. Ex 26 | ITO/Ag/ITO | $N_2$:$O_2$ | 10 | **E6** | F4 | 31 | 3,72 | 7,07 | 14,27 |
| Inv. Ex 27 | ITO/Ag/ITO | $N_2$:$O_2$ | 10 | **E7** | F4 | 31 | 3,71 | 6,96 | 14,04 |
| Inv. Ex 28 | ITO/Ag/ITO | $N_2$:$O_2$ | 10 | **E8** | F4 | 31 | 3,67 | 6,94 | 14,08 |

As can be seen from Table 2, the operating voltage of the inventive example may be lower than the comparative example.

A lower operating voltage may be beneficial for improved battery life, in particular in mobile devices.

As can be seen from Table 2, the external quantum efficiency EQE may be substantially reduced in comparison to the comparative examples.

A high external quantum efficiency EQE may be beneficial for reduced power consumption and improved battery life, in particular in mobile devices.

As can be seen from Table 2, the current efficiency (CEff) may be higher than for the comparative example. A high efficiency may be beneficial for reduced power consumption and improved battery life, in particular in mobile devices.

The particular combinations of elements and features in the above detailed embodiments are exemplary only. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention’s scope is defined in the following claims. Furthermore, reference signs used in the description and claims do not limit the scope of the invention as claimed.

## Claims

1. An organic electronic device (100) comprising an anode layer (120), a cathode layer (190), at least one photoactive layer, and a semiconductor layer,

   wherein the photoactive layer and the semiconductor layer are arranged between the anode layer (120) and the

cathode layer (190), wherein the semiconductor layer is arranged between the photoactive layer and the anode layer (120);
wherein the anode layer (120) comprises a first anode sub-layer and a second anode sub-layer, wherein the first anode sub-layer (121) comprises a first metal having a work function in the range of ≥ 4 and ≤ 6 eV, and the second anode sub-layer (122) comprises a transparent conductive oxide (TCO);
wherein the second anode sub-layer (122) is arranged closer to the semiconductor layer than the first anode sub layer (121);
wherein the semiconductor layer comprises at least one metal complex, wherein the metal complex comprises a metal cation and at least one anionic ligand, wherein the anionic ligand comprises at least four covalently bound atoms, and
**characterized in that**
the semiconductor layer comprises the metal complex in a range of ≥31 percent by weight to <100 percent by weight, based on the total weight of the semiconductor layer;
wherein the semiconductor layer is free of copper phthalocyanine.

2. The organic electronic device (100) according to claim 1, wherein the semiconductor layer comprises the metal complex in a range of ≥31 percent by weight to ≤90 percent by weight, based on the total weight of the semiconductor layer.

3. The organic electronic device (100) according to any one of claims 1 or 2, wherein the metal complex is represented by formula (I)

$$Q_rM^{s\oplus}(L^{\ominus})_s \qquad (I)$$

wherein

M is a metal cation,
s is the valency of M;
L is an anionic ligand comprising at least 4 covalently bound atoms, wherein the anionic ligand comprises at least two atoms selected from carbon atoms,
s is an integer from 1 to 4;
Q is a charge-neutral ligand which coordinates to the metal cation M,
r is an integer selected from 0 to 2.

4. The organic electronic device (100) according to claim 3, wherein the metal cation M is selected from alkali, alkaline earth, transition, rare earth metal or group III to V metal

5. The organic electronic device (100) according to any one of claims 3 or 4, wherein the charge neutral ligand Q is selected from the group comprising $H_2O$, $C_2$ to $C_{40}$ mono- or multi-dentate ethers and $C_2$ to $C_{40}$ thioethers, $C_2$ to $C_{40}$ amines, $C_2$ to $C_{40}$ phosphine, $C_2$ to $C_{20}$ alkyl nitrile or $C_2$ to $C_{40}$ aryl nitrile, or a compound according to formula (II);

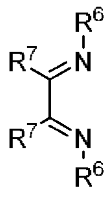
(II),

wherein $R^6$ and $R^7$ are independently selected from $C_1$ to $C_{20}$ alkyl, $C_1$ to $C_{20}$ heteroalkyl, $C_6$ to $C_{20}$ aryl, heteroaryl with 5 to 20 ring-forming atoms, halogenated or perhalogenated $C_1$ to $C_{20}$ alkyl, halogenated or perhalogenated $C_1$ to $C_{20}$ heteroalkyl, halogenated or perhalogenated $C_6$ to $C_{20}$ aryl, halogenated or perhalogenated heteroaryl with 5 to 20 ring-forming atoms, or at least one $R^6$ and $R^7$ are bridged and form a 5 to 20 member ring, or the two $R^6$ and/or the two $R^7$ are bridged and form a 5 to 40 member ring or form a 5 to 40 member ring comprising an unsubstituted or $C_1$ to $C_{12}$ substituted phenanthroline.

6. The organic electronic device (100) according to any one of claims 3 to 5, wherein the anionic ligand L is selected from formula (III)

$$(R^1)_a(A^1)_m-Z-(A^2)_n(R^2)_b \quad \text{(III)}$$

wherein

m, and n are independently selected from 0, 1;
$m+n \geq 1$;
a, and b are independently selected from 0, 1;
$a+b \geq 1$;
Z is selected from $CR^3$, N, or O;
if Z is O then a is 0 when m is 0 or b is o when n is 0;
$A^1$ and $A^2$ are independently selected from C=O, C-O, SO, or $SO_2$;
$A^1$ and $A^2$ together can form a cycle with Z;
$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for the case that $A^1$ and $A^2$ are selected from C=O or C-O, $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl;
wherein the substituents on $R^3$ is selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

**7.** The organic electronic device (100) according to any one of claims 3 to 6, wherein the metal complex according to formula (I) is selected from one of the formulae (IVa) to (IVd):

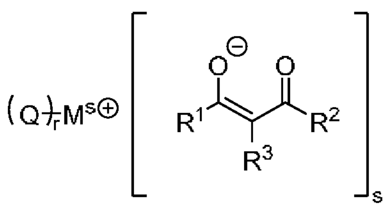
(IVa)

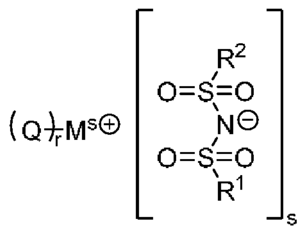
(IVb)

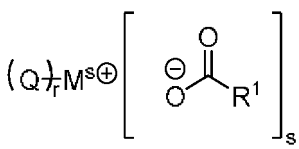
(IVc)

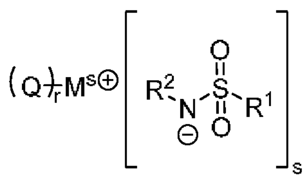
(IVd)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for formula (IVa) $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

**8.** The organic electronic device (100) according to any one of claims 3 to 7, wherein the anionic ligand L is selected from formula (VIa) or VIb):

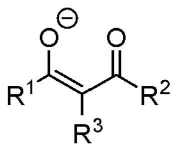
(VIa)

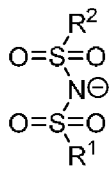
(VIb)

wherein

$R^1$ and $R^2$ are independently selected from substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or $C_2$ to $C_{24}$ heterocyclyl,
wherein for formula (VIa) $R^1$ and $R^2$ may also be selected from D or H,
wherein the substituents on $R^1$ or $R^2$ are independently selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$ to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$;
and
$R^3$ is selected from H, D, CN, substituted or unsubstituted $C_6$ to $C_{24}$ aryl, substituted or unsubstituted $C_2$ to $C_{24}$ heteroaryl, substituted or unsubstituted $C_1$ to $C_{12}$ alkyl, substituted or unsubstituted $C_3$ to $C_{24}$ carbocyclyl, or substituted or unsubstituted $C_2$ to $C_{24}$ heterocyclyl,
wherein the substituents on $R^3$ are selected from halogen, F, Cl, CN, substituted or unsubstituted $C_1$ to $C_{12}$ alkyl, partially or fully fluorinated $C_1$ to $C_{12}$ alkyl, substituted or unsubstituted $C_1$ to $C_{12}$ alkoxy, partially or fully fluorinated $C_1$ to $C_{12}$ alkoxy, substituted or unsubstituted $C_6$ to $C_{18}$ aryl, and substituted or unsubstituted $C_2$

to $C_{18}$ heteroaryl,
and wherein the substituents of the substituted or unsubstituted $C_1$ to $C_{12}$ alkyl, substituted or unsubstituted $C_1$ to $C_{12}$ alkoxy, substituted or unsubstituted $C_6$ to $C_{18}$ aryl, and substituted or unsubstituted $C_2$ to $C_{18}$ heteroaryl are selected from halogen, F, Cl, CN, $C_1$ to $C_6$ alkyl, partially or fully fluorinated $C_1$ to $C_6$ alkyl, $CF_3$, $OCH_3$, fully fluorinated $C_1$ to $C_6$ alkoxy, or $OCF_3$.

**9.** The organic electronic device (100) according to any one of claims 1 to 8, wherein the anionic ligand L is selected from one of the following formulae G1 to G140:

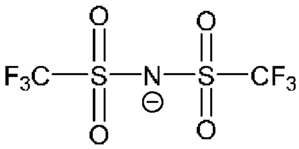,
(G1)

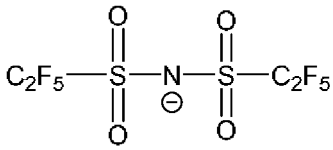,
(G2)

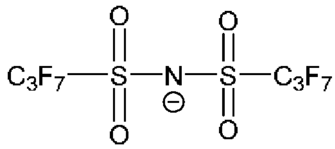,
(G3)

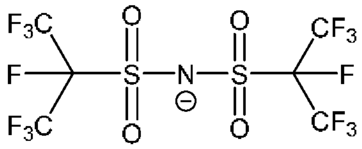,
(G4)

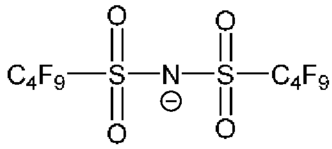,
(G5)

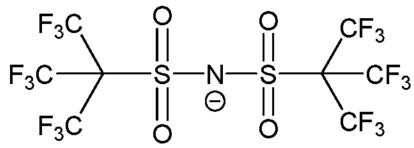,
(G6)

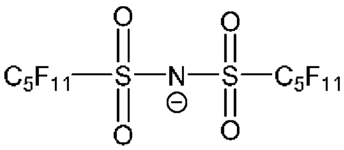,
(G7)

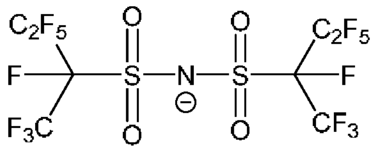,
(G8)

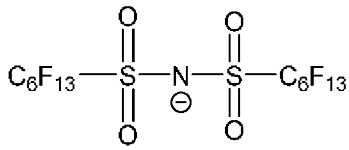,
(G9)

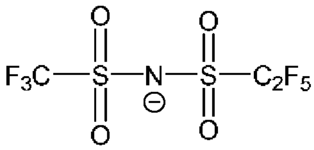,
(G10)

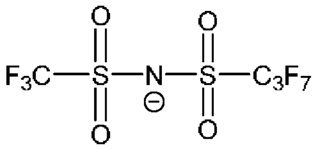,
(G11)

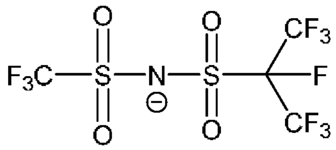,
(G12)

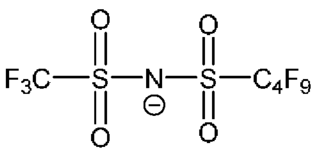,
(G13)

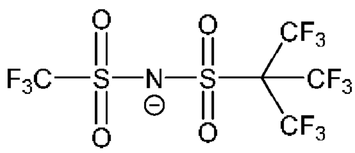,
(G14)

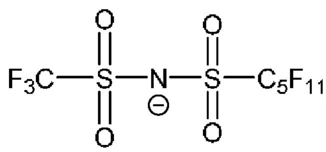,
(G15)

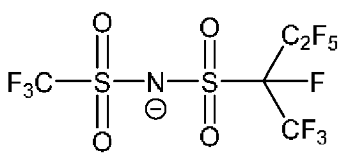,
(G16)

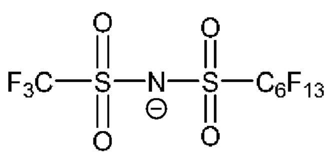,
(G17)

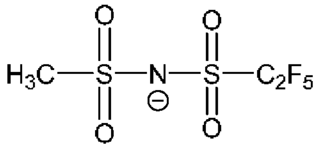 , 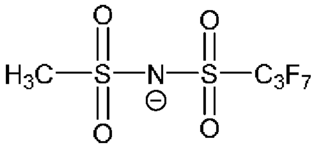 , 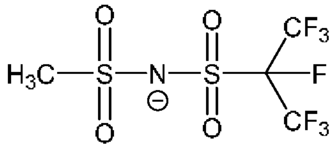 ,

(G18) (G19) (G20)

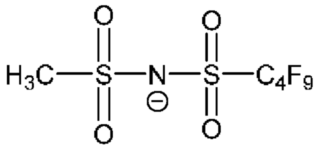 , 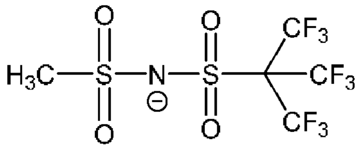 , 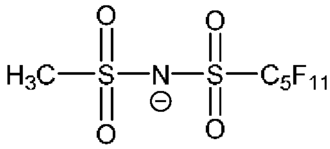 ,

(G21) (G22) (G23)

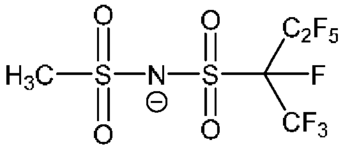 , 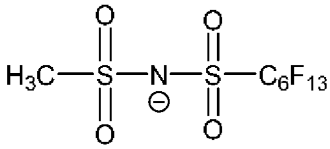 ,

(G24) (G25)

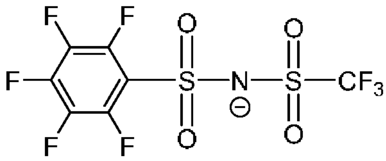 , 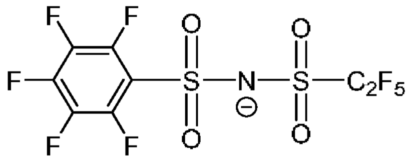 ,

(G26) (G27)

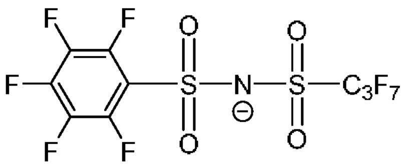 ,

(G28)

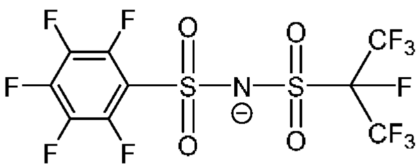 , 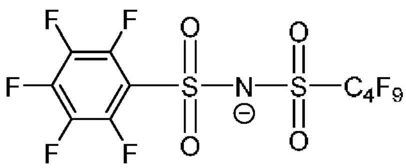 ,

(G29) (G30)

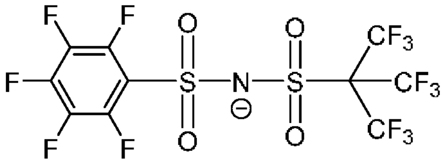,
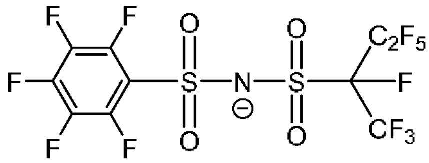,

(G31) (G32)

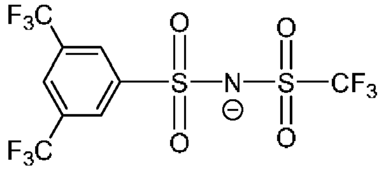,
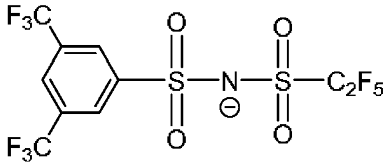,
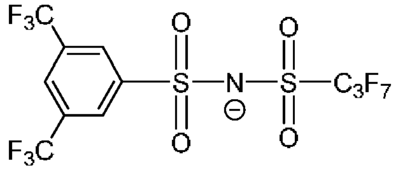,

(G33) (G34) (G35)

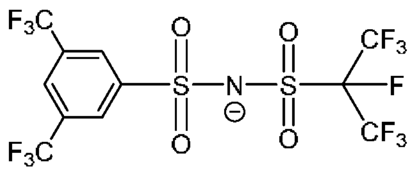,
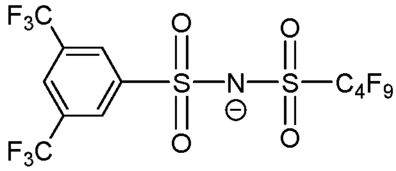,

(G36) (G37)

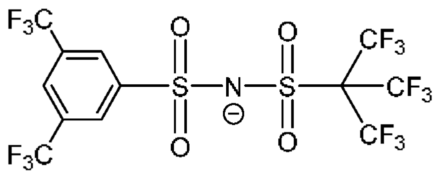,

(G38)

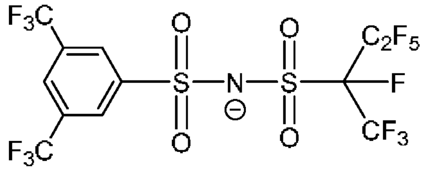,
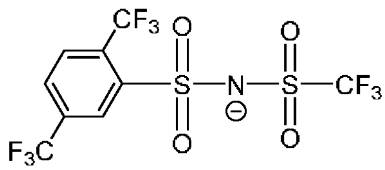,

(G39) (G40)

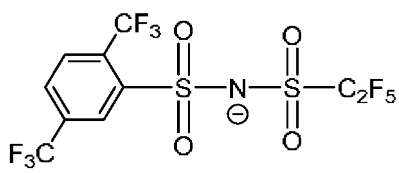,

(G41)

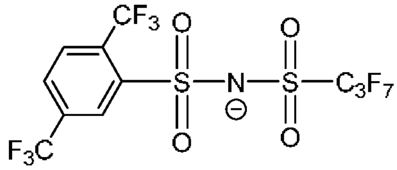 , 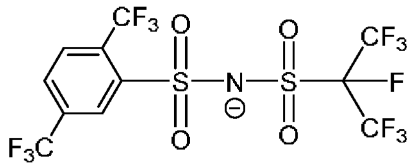 ,

(G42) (G43)

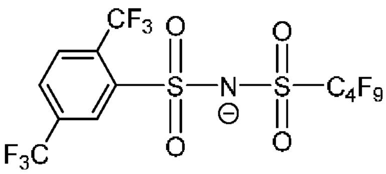 , 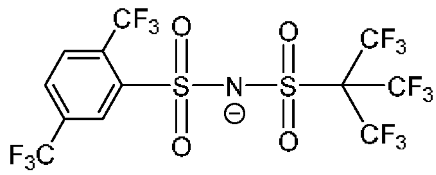

(G44) (G45)

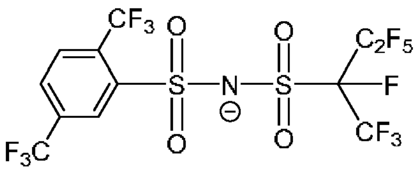 , 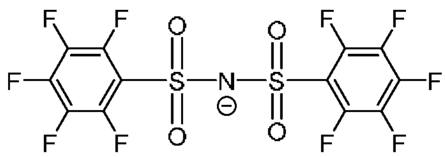

(G46) (G47)

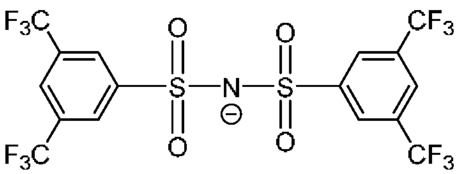 , 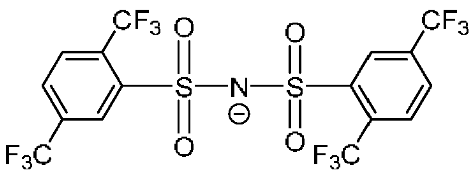

(G48) (G49)

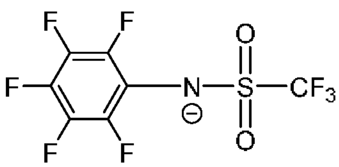 , 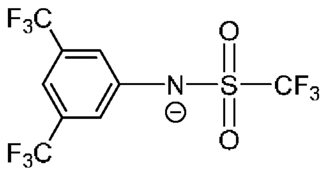 , 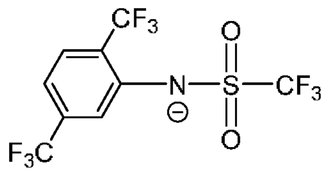 ,

(G50) (G51) (G52)

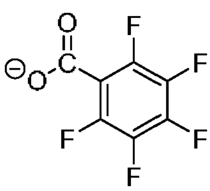 , 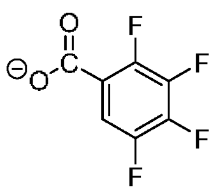 , 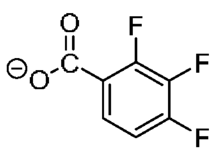 , 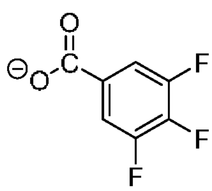 ,

(G53) (G54) (G55) (G56)

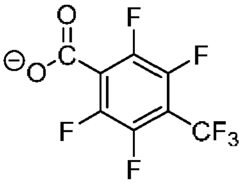,
(G57)

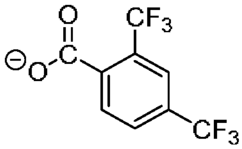,
(G58)

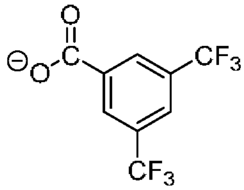,
(G59)

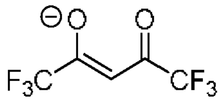,
(G60)

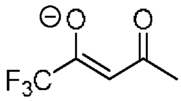,
(G61)

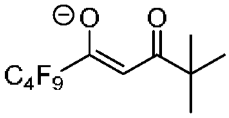,
(G62)

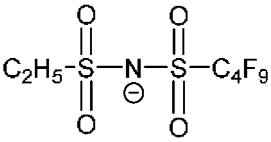,
(G63)

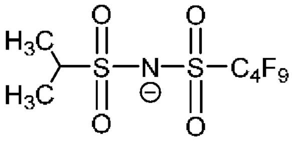,
(G64)

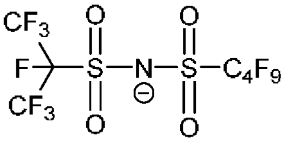,
(G65)

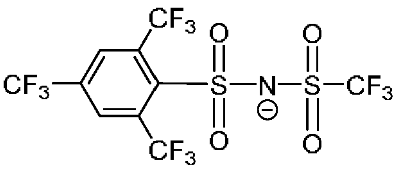,
(G66)

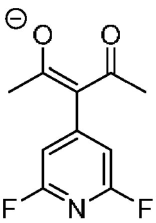,
(G67)

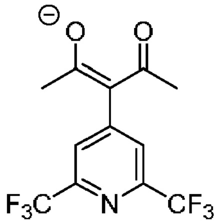,
(G68)

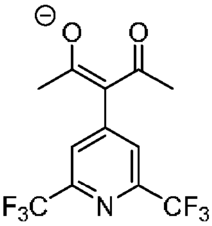 (G69),

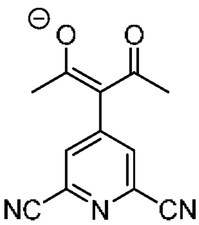 (G70),

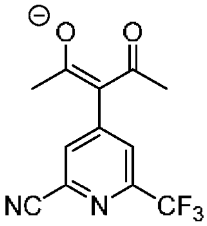 (G71),

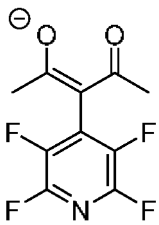 (G72),

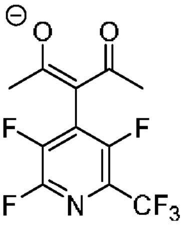 (G73),

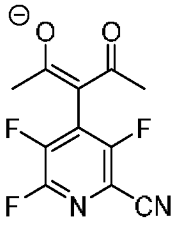 (G74),

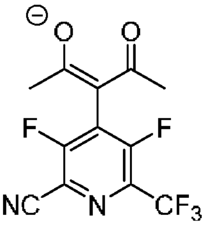 (G75),

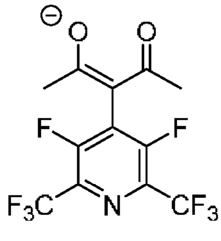 (G76),

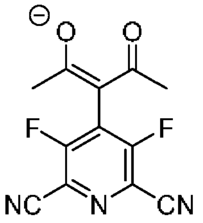 (G77), 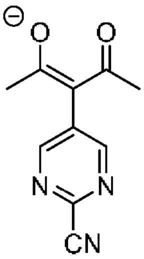 (G78), 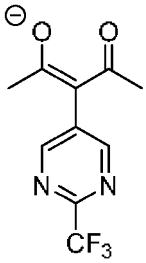 (G79), 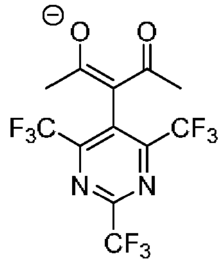 (G80),

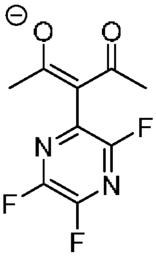 (G81), 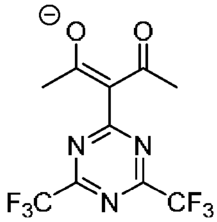 (G82), 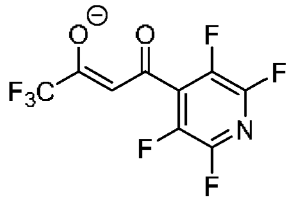 (G83),

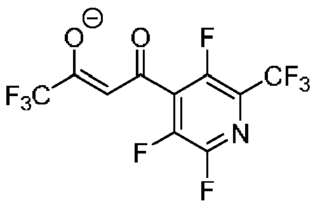 (G84), 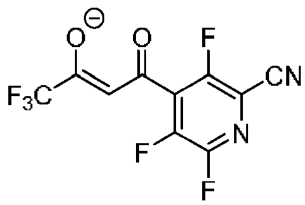 (G85), 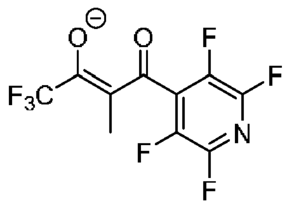 (G86),

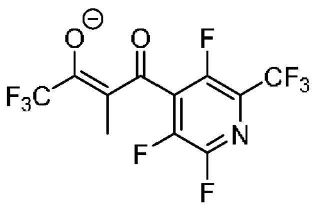 (G87), 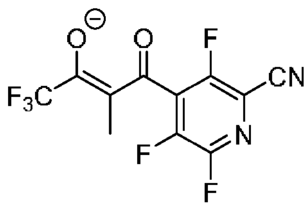 (G88), 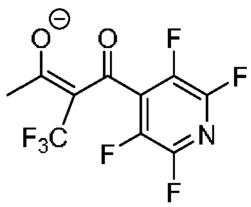 (G89),

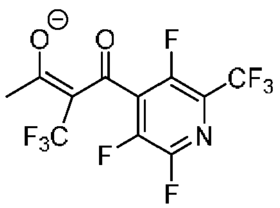 (G90), 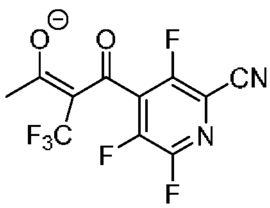 (G91), 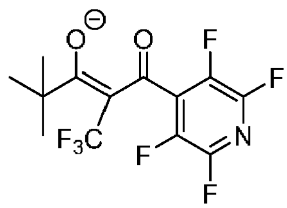 (G92),

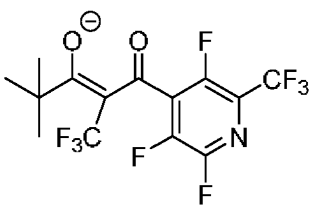 (G93), 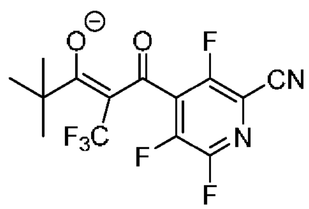 (G94),

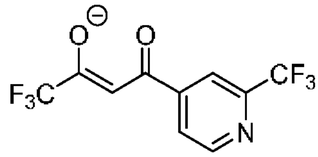 (G95), 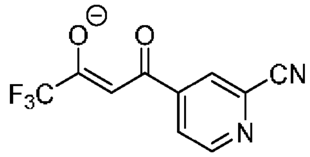 (G96),

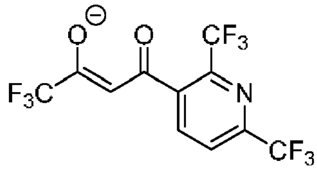 (G97), 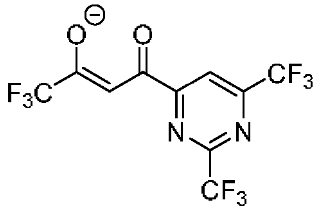 (G98),

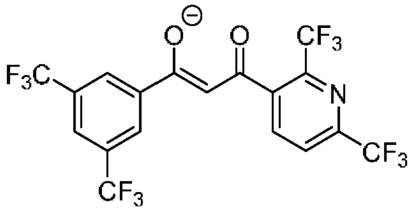 (G99), 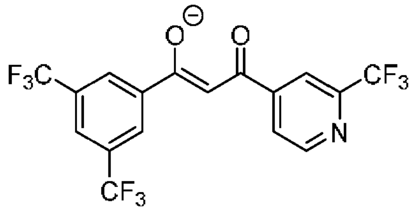 (G100),

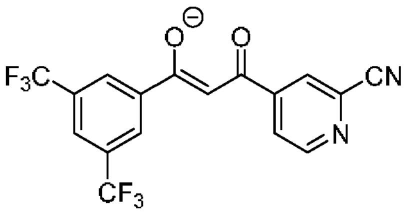 (G101), 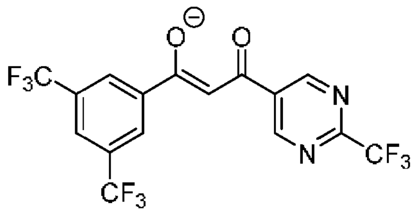 (G102),

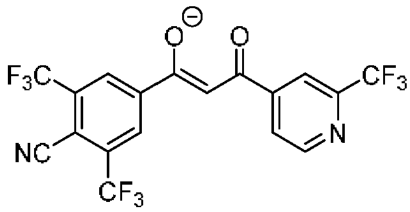 (G103),

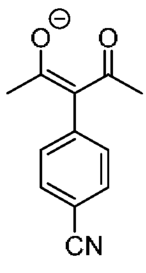 (G104), 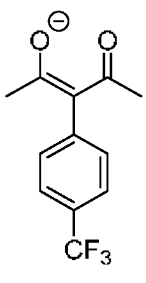 (G105), 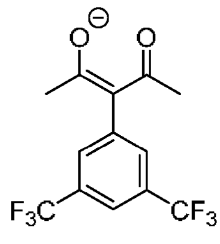 (G106), 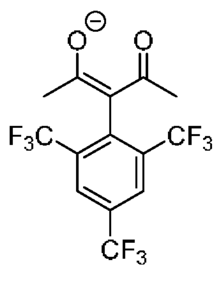 (G107),

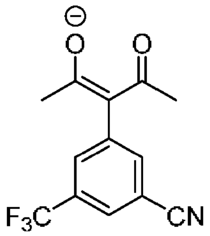 (G108), 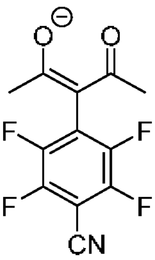 (G109), 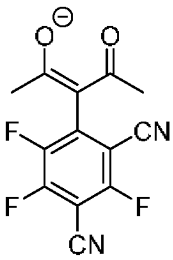 (G110), 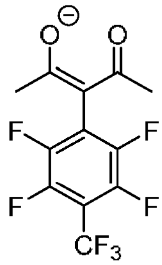 (G111),

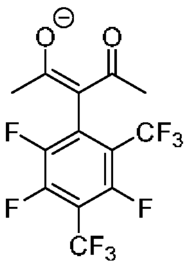 (G112), 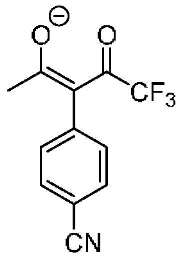 (G113), 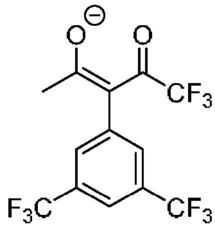 (G114),

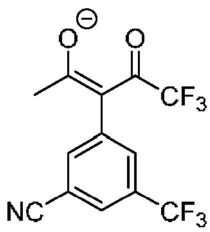 (G115), 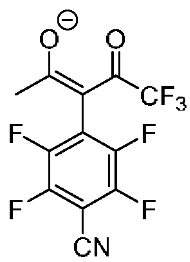 (G116), 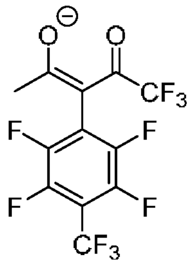 (G117),

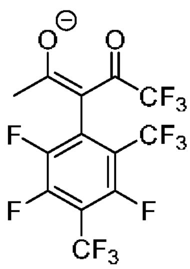 (G118),

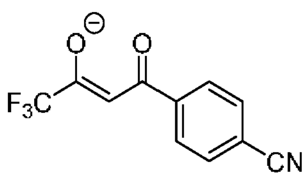 (G119), 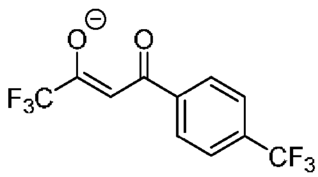 (G120),

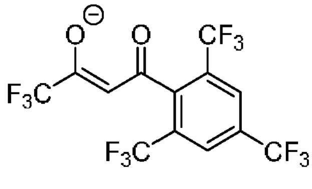 (G121), 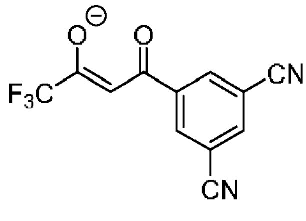 (G122),

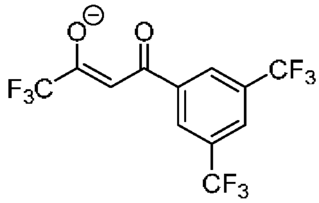 (G123), 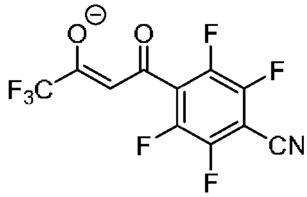 (G124),

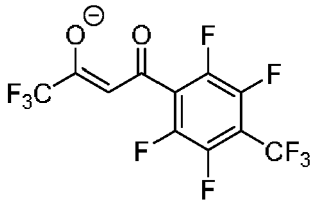 (G125), 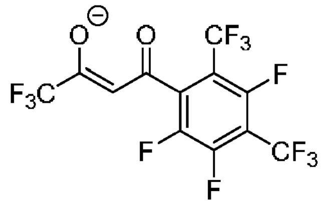 (G126),

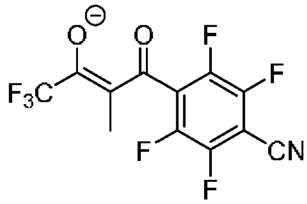 (G127), 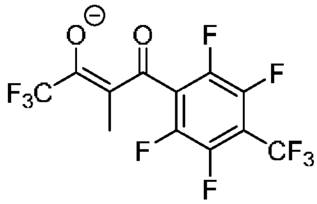 (G128),

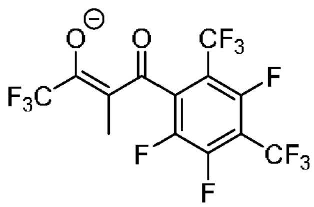 (G129), 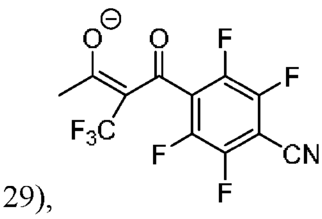 (G130), 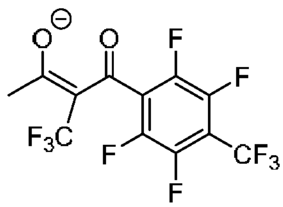 (G131),

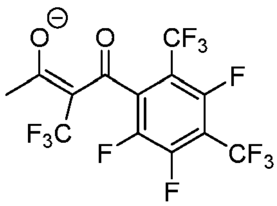 (G132), 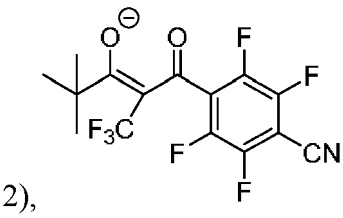 (G133),

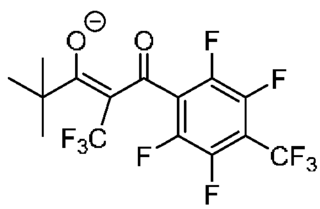 (G134), 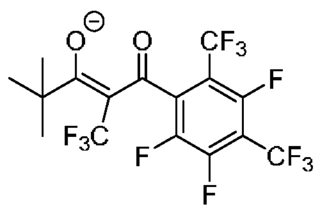 (G135),

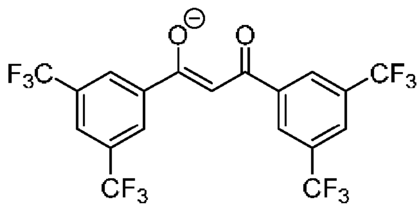 (G135), 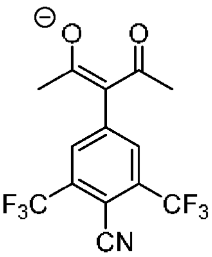 (G136), 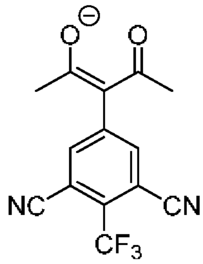 (G137),

and

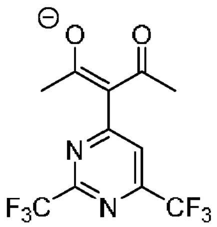 (G138) , 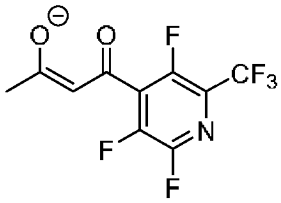 (G139), and. 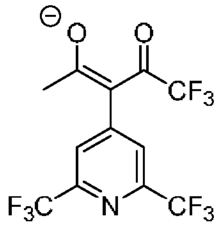 (G140).

**10.** The organic electronic device (100) according to any one of claims 1 or 9, wherein the semiconductor layer comprises a substantially covalent matrix compound.

**11.** The organic electronic device (100) according to any one of claims 1 or 10, wherein the semiconductor layer is in direct contact to the anode layer (120).

**12.** The organic electronic device (100) according to any one of claims 1 to 11, wherein the semiconductor layer is a hole injection layer (130).

**13.** The organic electronic device (100) according to any one of claims 1 to 12, wherein the anode layer (120) of the organic electronic device (100) comprises in addition a third anode sub-layer (123); wherein the third anode sub-layer (123) comprises preferably a transparent conductive oxide, wherein the first anode sub-layer (121) is arranged between the third anode sub-layer (123) and the second anode sub-layer (122).

**14.** The organic electronic device (100) according to any one of claims 1 to 13, wherein the organic electronic device (100) further comprises a hole transport layer (140), wherein the hole transport layer (140) is arranged between the semiconductor layer and the at least one photoactive layer.

**15.** The organic electronic device (100) according to any of the preceding claims 1 to 14, wherein the organic electronic device (100) is a light emitting device or a display device.

**Patentansprüche**

**1.** Organische elektronische Vorrichtung (100), die eine Anodenschicht (120), eine Kathodenschicht (190), mindestens eine fotoaktive Schicht und eine Halbleiterschicht aufweist,

wobei die fotoaktive Schicht und die Halbleiterschicht zwischen der Anodenschicht (120) und der Kathodenschicht (190) angeordnet sind, wobei die Halbleiterschicht zwischen der fotoaktiven Schicht und der Anodenschicht (120) angeordnet ist;
wobei die Anodenschicht (120) eine erste Anoden-Teilschicht und eine zweite Anoden-Teilschicht aufweist, wobei die erste Anoden-Teilschicht (121) ein erstes Metall aufweist, das eine Austrittsarbeit in der Spanne von ≥4 bis ≤ 6 eV aufweist, und die zweite Anoden-Teilschicht (122) ein transparentes leitfähiges Oxid (TCO) aufweist;
wobei die zweite Anoden-Teilschicht (122) näher an der Halbleiterschicht angeordnet ist als die erste Anoden-Teilschicht (121);
wobei die Halbleiterschicht mindestens einen Metallkomplex aufweist, wobei der Metallkomplex ein Metallkation und mindestens einen anionischen Liganden aufweist, wobei der anionische Ligand mindestens vier kovalent

gebundene Atome aufweist und
**dadurch gekennzeichnet, dass** die Halbleiterschicht den Metallkomplex in einer Spanne von ≥31 Gewichtsprozent bis < 100 Gewichtsprozent basierend auf dem Gesamtgewicht der Halbleiterschicht aufweist;
wobei die Halbleiterschicht kein Kupferphthalocyanin aufweist.

**2.** Organische elektronische Vorrichtung (100) nach Anspruch 1, wobei die Halbleiterschicht den Metallkomplex in einer Spanne von ≥31 Gewichtsprozent bis ≤ 90 Gewichtsprozent basierend auf dem Gesamtgewicht der Halbleiterschicht aufweist.

**3.** Organische elektronische Vorrichtung (100) nach einem der Ansprüche 1 oder 2, wobei der Metallkomplex durch Formel (I) dargestellt wird

$$Q_rM^{s\oplus}\,(L^{\ominus})_s \qquad (I)$$

wobei

M ein Metallkation ist,
s die Valenz von M ist;
L ein anionischer Ligand ist, der mindestens 4 kovalent gebundene Atome aufweist, wobei der anionische Ligand mindestens zwei Atome aufweist, die aus Kohlenstoffatomen ausgewählt sind,
s eine Ganzzahl von 1 bis 4 ist;
Q ein ladungsneutraler Ligand ist, der an das Metallkation M koordiniert ist, und
r eine aus 0 bis 2 ausgewählte Ganzzahl ist.

**4.** Organische elektronische Vorrichtung (100) nach Anspruch 3, wobei das Metallkation M aus Alkalimetallen, Erdalkalimetallen, Übergangsmetallen, Seltenerdmetallen oder Metallen der Gruppe III bis V ausgewählt ist.

**5.** Organische elektronische Vorrichtung (100) nach einem der Ansprüche 3 oder 4, wobei der ladungsneutrale Ligand Q aus der Gruppe, die $H_2O$, ein- oder mehrzähnige $C_2$- bis $C_{40}$-Ether und $C_2$- bis $C_{40}$-Thioether, $C_2$- bis $C_{40}$-Amine, $C_2$- bis $C_{40}$-Phosphine, $C_2$- bis $C_{20}$-Alkylnitrile oder $C_2$- bis $C_{40}$-Arylnitrile umfasst, ausgewählt ist oder eine Verbindung nach Formel (II) ist;

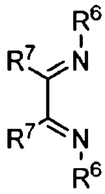
(II)

wobei $R^6$ und $R^7$ unabhängig aus $C_1$- bis $C_{20}$-Alkylen, $C_1$- bis $C_{20}$-Heteroalkylen, $C_6$- bis $C_{20}$ Arylen, Heteroarylen mit 5 bis 20 ringbildenden Atomen, halogenierten oder perhalogenierten $C_1$- bis $C_{20}$-Alkylen, halogenierten oder perhalogenierten $C_1$- bis $C_{20}$-Heteroalkylen, halogenierten oder perhalogenierten $C_6$- bis $C_{20}$-Arylen, halogenierten oder perhalogenierten Heteroarylen mit 5 bis 20 ringbildenden Atomen ausgewählt sind oder mindestens ein $R^6$ und ein $R^7$ durch eine Brücke verbunden sind und einen Ring mit 5 bis 20 Bestandteilen bilden oder die beiden $R^6$ und/oder die beiden $R^7$ durch eine Brücke verbunden sind und einen Ring mit 5 bis 40 Bestandteilen bilden oder einen Ring mit 5 bis 40 Bestandteilen bilden, der ein unsubstituiertes oder $C_1$- bis $C_{12}$-substituiertes Phenanthrolin aufweist.

**6.** Organische elektronische Vorrichtung (100) nach einem der Ansprüche 3 bis 5, wobei der anionische Ligand L nach Formel (III) ausgewählt ist

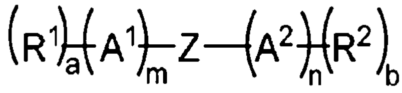
(III)

wobei

m und n unabhängig aus 0, 1 ausgewählt sind;
$m+n \geq 1$;
a und b unabhängig aus 0, 1 ausgewählt sind;
$a+b \geq 1$;
Z aus $CR^3$, N oder O ausgewählt ist;
wenn Z O ist, dann ist a 0, wenn m 0 ist, oder b ist 0, wenn n 0 ist;
$A^1$ und $A^2$ unabhängig aus C=O, C-O, SO oder $SO_2$ ausgewählt sind;
$A^1$ und $A^2$ zusammen einen Ring mit Z bilden können;
$R^1$ und $R^2$ unabhängig aus substituierten oder unsubstituierten $C_6$- bis $C_{24}$-Arylen, substituierten oder unsubstituierten $C_2$- bis $C_{24}$-Heteroarylne, substituierten oder unsubstituierten $C_1$- bis $C_{12}$-Alkylen, substituierten oder unsubstituierten $C_3$- bis $C_{24}$-Carbocyclylen oder $C_2$- bis $C_{24}$-Heterocyclylen ausgewählt sind,
wobei für den Fall, dass $A^1$ und $A^2$ aus C=O oder C-O ausgewählt sind, $R^1$ und $R^2$ auch aus D oder H ausgewählt sein können,
wobei die Substituenten an $R^1$ oder $R^2$ unabhängig aus Halogenen, F, Cl, CN, substituierten oder unsubstituierten $C_1$- bis $C_{12}$-Alkylen, teilweise oder vollständig fluorierten $C_1$- bis $C_{12}$-Alkylen, substituierten oder unsubstituierten $C_1$- bis $C_{12}$-Alkoxys, teilweise oder vollständig fluorierten $C_1$- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt sind
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluorierten $C_1$- bis $C_6$-Alkylen, $CF_3$, $OCH_3$, vollständig fluorierten $C_1$- bis $C_6$-Alkoxys oder $OCF_3$ ausgewählt sind;
und
$R^3$ aus H, D, CN, substituierten oder unsubstituierten $C_6$- bis $C_{24}$-Arylen, substituierten oder unsubstituierten $C_2$- bis $C_{24}$-Heteroarylen, substituierten oder unsubstituierten $C_1$- bis $C_{12}$-Alkylen, substituierten oder unsubstituierten $C_3$- bis $C_{24}$-Carbocyclylen oder substituierten oder unsubstituierten $C_2$- bis $C_{24}$-Heterocyclylen ausgewählt ist;
wobei die Substituenten an $R^3$ aus Halogenen, F, Cl, CN, substituierten oder unsubstituierten $C_1$- bis $C_{12}$-Alkyls, teilweise oder vollständig fluorierten $C_1$- bis $C_{12}$-Alkylen, substituierten oder unsubstituierten $C_1$- bis $C_{12}$-Alkoxys, teilweise oder vollständig fluorierten $C_1$- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt sind
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluorierten $C_1$- bis $C_6$-Alkylen, $CF_3$, $OCH_3$, vollständig fluorierten $C_1$- bis $C_6$-Alkoxys oder $OCF_3$ ausgewählt sind.

**7.** Organische elektronische Vorrichtung (100) nach einem der Ansprüche 3 bis 6, wobei der Metallkomplex gemäß Formel (I) nach einer der Formeln (IVa) bis (IVd) ausgewählt ist:

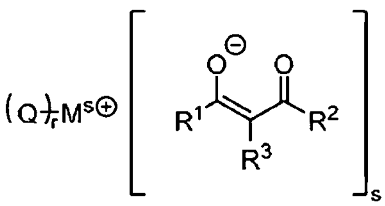
(IVa)

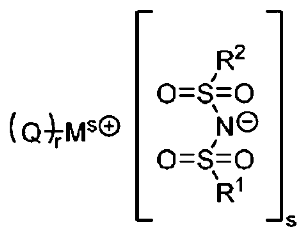
(IVb)

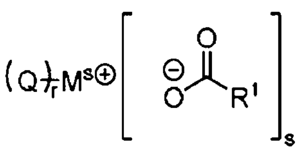
(IVc)

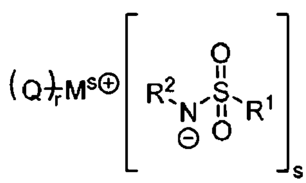
(IVd)

wobei

$R^1$ und $R^2$ unabhängig aus substituierten oder unsubstituierten $C_6$- bis $C_{24}$ Arylen, substituierten oder unsubstituierten $C_2$- bis $C_{24}$-Heteroarylen, substituierten oder unsubstituierten $C_1$- bis $C_{12}$-Alkylen, substituierten oder unsubstituierten $C_3$- bis $C_{24}$-Carbocyclylen oder $C_2$- bis $C_{24}$-Heterocyclylen ausgewählt sind,
wobei für Formel (IVa) $R^1$ und $R^2$ auch aus D oder H ausgewählt sein können,
wobei die Substituenten an $R^1$ oder $R^2$ unabhängig aus Halogenen, F, Cl, CN, substituierten oder unsubstituierten $C_1$- bis $C_{12}$-Alkylen, teilweise oder vollständig fluorierten $C_1$- bis $C_{12}$-Alkylen, substituierten oder unsubstituierten $C_1$- bis $C_{12}$-Alkoxys, teilweise oder vollständig fluorierten $C_1$- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt sind
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluoriertem $C_1$- bis $C_6$-Alkylen, $CF_3$, $OCH_3$, vollständig fluorierten $C_1$- bis $C_6$-Alkoxys oder $OCF_3$ ausgewählt sind;
und
$R^3$ aus H, D, CN, substituierten oder unsubstituierten $C_6$- bis $C_{24}$ Arylen, substituierten oder unsubstituierten $C_2$- bis $C_{24}$-Heteroarylen, substituierten oder unsubstituierten $C_1$- bis $C_{12}$-Alkylen, substituierten oder unsubstituierten $C_3$- bis $C_{24}$-Carbocyclylen, substituierten oder unsubstituierten $C_2$- bis $C_{24}$-Heterocyclylen ausgewählt ist,
wobei die Substituenten an $R^3$ aus Halogenen, F, Cl, CN, substituierten oder unsubstituierten $C_1$- bis $C_{12}$-Alkylen, teilweise oder vollständig fluorierten $C_1$- bis $C_{12}$-Alkylen, substituierten oder unsubstituierten $C_1$- bis $C_{12}$-Alkoxys, teilweise oder vollständig fluorierten $C_1$- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt sind
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluorierten $C_1$- bis $C_6$-Alkylen, $CF_3$, $OCH_3$, vollständig fluorierten $C_1$- bis $C_6$-Alkoxys oder $OCF_3$ ausgewählt sind.

**8.** Organische elektronische Vorrichtung (100) nach einem der Ansprüche 3 bis 7, wobei der anionische Ligand L nach Formel (VIa) oder (VIb) ausgewählt ist:

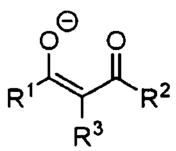
(VIa)

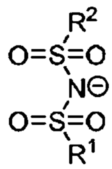
(VIb)

wobei

$R^1$ und $R^2$ unabhängig aus substituierten oder unsubstituierten $C_6$- bis $C_{24}$ Arylen, substituierten oder unsubstituierten $C_2$- bis $C_{24}$-Heteroarylen, substituierten oder unsubstituierten $C_1$- bis $C_{12}$-Alkylen, substituierten oder unsubstituierten $C_3$- bis $C_{24}$-Carbocyclylen oder $C_2$- bis $C_{24}$-Heterocyclylen ausgewählt sind,
wobei für Formel (VIa) $R^1$ und $R^2$ auch aus D oder H ausgewählt sein können,
wobei die Substituenten an $R^1$ oder $R^2$ unabhängig aus Halogenen, F, Cl, CN, substituierten oder unsubstituierten $C_1$- bis $C_{12}$-Alkylen, teilweise oder vollständig fluorierten $C_1$- bis $C_{12}$-Alkylen, substituierten oder unsubstituierten $C_1$- bis $C_{12}$-Alkoxys, teilweise oder vollständig fluorierten $C_1$- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt sind
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluoriertem $C_1$- bis $C_6$-Alkylen, $CF_3$, $OCH_3$, vollständig fluorierten $C_1$- bis $C_6$-Alkoxys oder $OCF_3$ ausgewählt sind;
und
$R^3$ aus H, D, CN, substituierten oder unsubstituierten $C_6$- bis $C_{24}$ Arylen, substituierten oder unsubstituierten $C_2$- bis $C_{24}$-Heteroarylen, substituierten oder unsubstituierten $C_1$- bis $C_{12}$-Alkylen, substituierten oder unsubstituierten $C_3$- bis $C_{24}$-Carbocyclylen oder substituierten oder unsubstituierten $C_2$- bis $C_{24}$-Heterocyclylen ausgewählt

ist,
wobei die Substituenten an $R^3$ aus Halogenen, F, Cl, CN, substituierten oder unsubstituierten $C_1$- bis $C_{12}$-Alkylen, teilweise oder vollständig fluorierten $C_1$- bis $C_{12}$-Alkylen, substituierten oder unsubstituierten $C_1$- bis $C_{12}$-Alkoxys, teilweise oder vollständig fluorierte n- bis $C_{12}$-Alkoxys, substituierten oder unsubstituierten $C_6$- bis $C_{18}$-Arylen und substituierten oder unsubstituierten $C_2$- bis $C_{18}$-Heteroarylen ausgewählt ist
und wobei die Substituenten der substituierten oder unsubstituierten $C_1$- bis $C_{12}$-Alkyle, substituierten oder unsubstituierten $C_1$- bis $C_{12}$-Alkoxys, substituierten oder unsubstituierten $C_6$- bis $C_{18}$-Aryle und substituierten oder unsubstituierten $C_2$- bis $C_{18}$-Heteroaryle aus Halogenen, F, Cl, CN, $C_1$- bis $C_6$-Alkylen, teilweise oder vollständig fluorierten $C_1$- bis $C_6$-Alkylen, $CF_3$, $OCH_3$, vollständig fluorierten $C_1$- bis $C_6$-Alkoxys oder $OCF_3$ ausgewählt sind.

**9.** Organische elektronische Vorrichtung (100) nach einem der Ansprüche 1 bis 8, wobei der anionische Ligand L nach einer der folgenden Formeln G1 bis G140 ausgewählt ist:

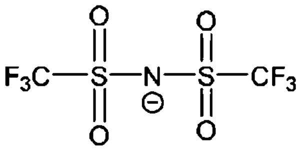 , 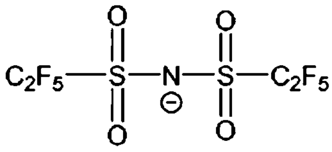 , 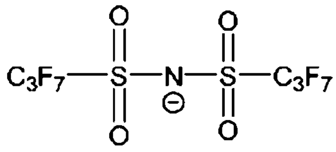 ,

(G1) (G2) (G3)

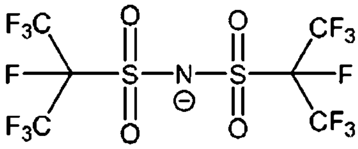 , 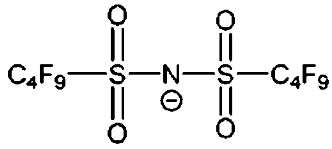 , 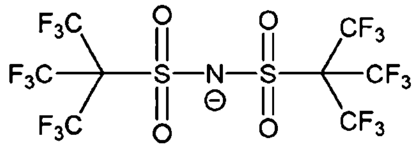 ,

(G4) (G5) (G6)

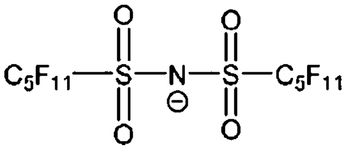 , 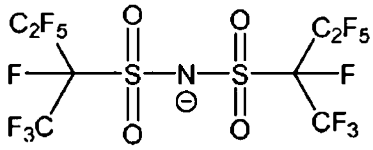 , 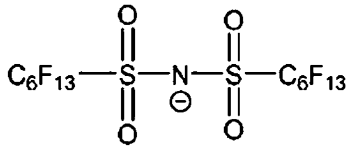 ,

(G7) (G8) (G9)

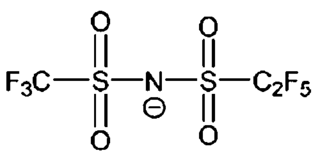 , 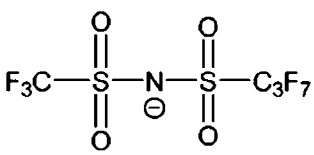 , 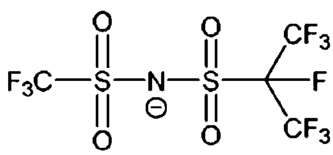 ,

(G10) (G11) (G12)

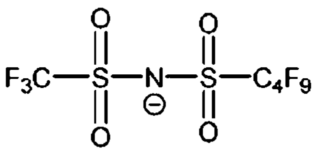 , 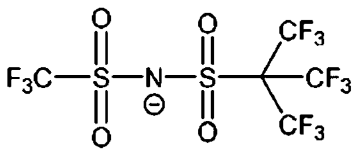 , 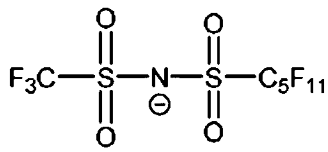 ,

(G13) (G14) (G15)

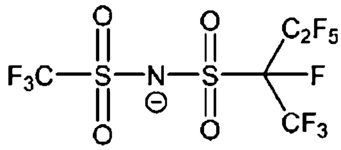,

(G16)

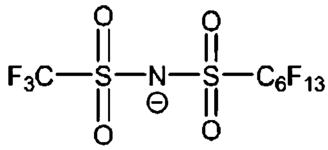,

(G17)

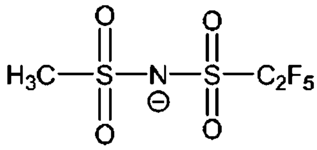,

(G18)

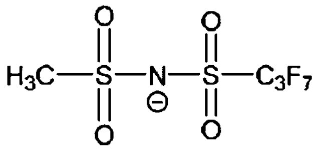,

(G19)

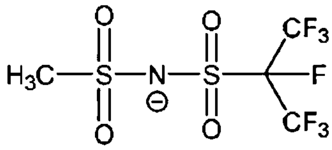,

(G20)

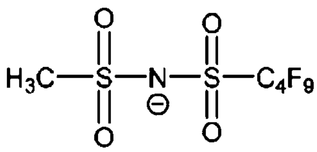,

(G21)

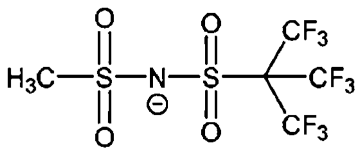,

(G22)

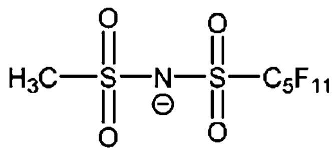,

(G23)

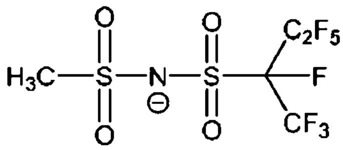,

(G24)

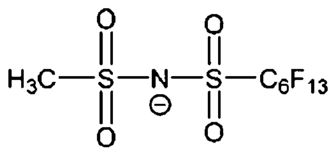,

(G25)

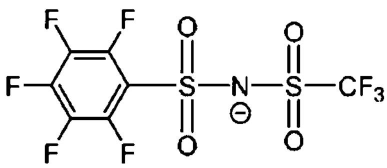,

(G26)

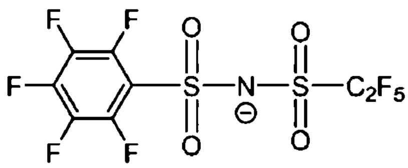,

(G27)

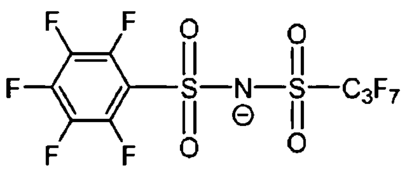,

(G28)

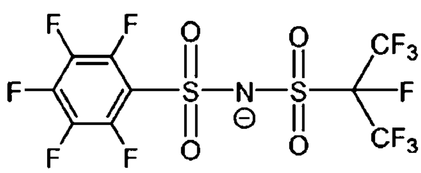,

(G29)

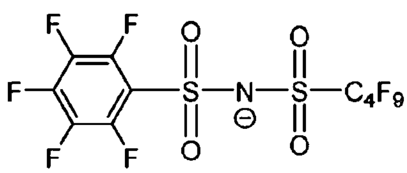,

(G30)

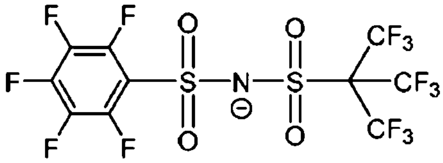,

(G31)

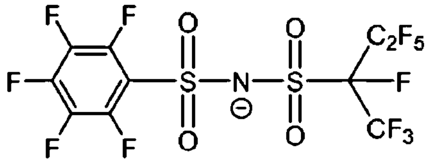,

(G32)

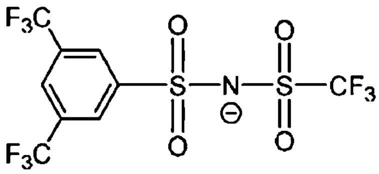,

(G33)

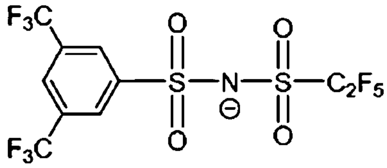,

(G34)

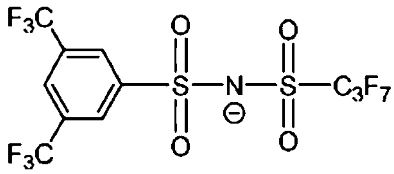,

(G35)

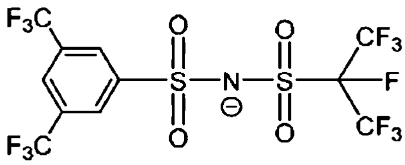,

(G36)

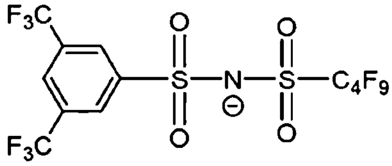,

(G37)

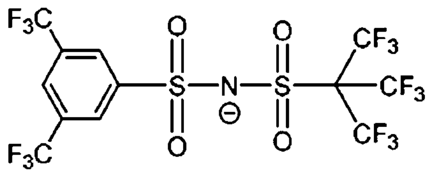,

(G38)

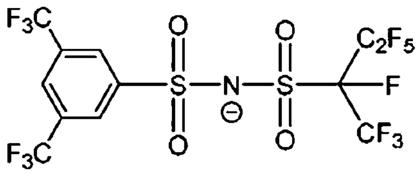,

(G39)

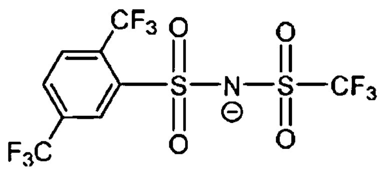,

(G40)

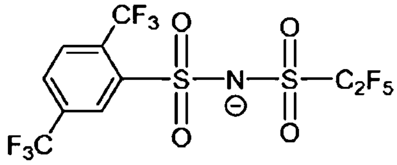,

(G41)

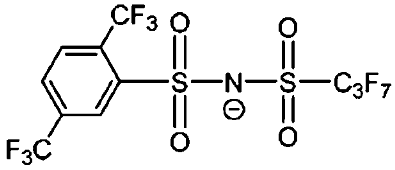,
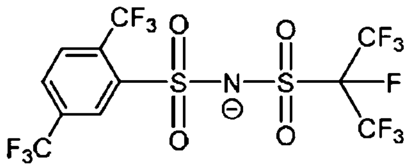,

(G42) (G43)

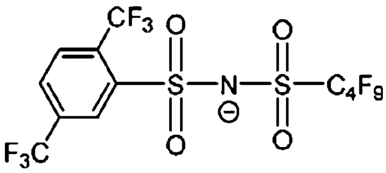,
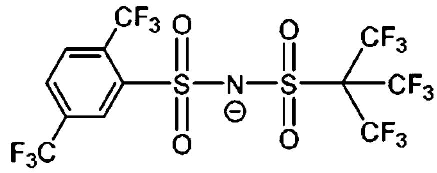

(G44) (G45)

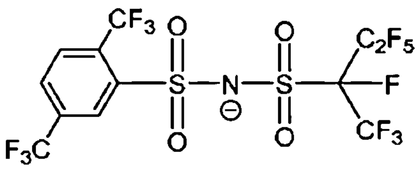,
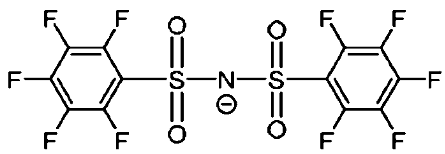

(G46) (G47)

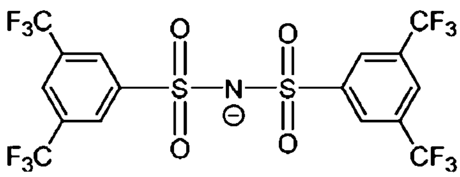,
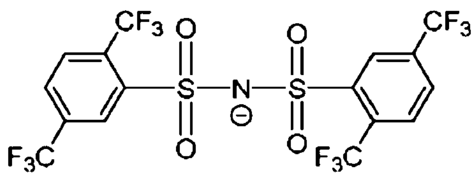

(G48) (G49)

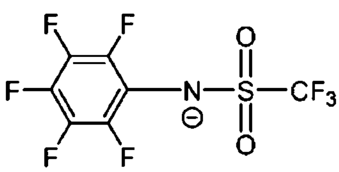,
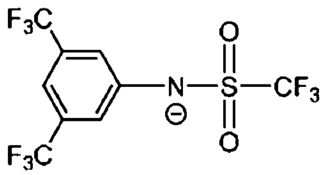,
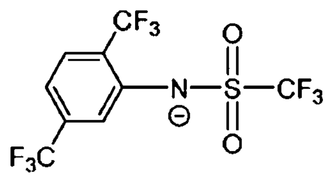,

(G50) (G51) (G52)

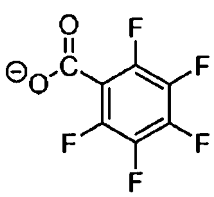,
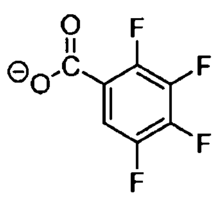,
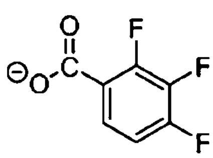,
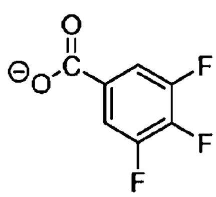,

(G53) (G54) (G55) (G56)

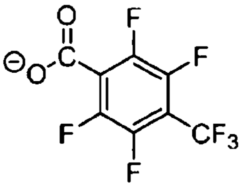,
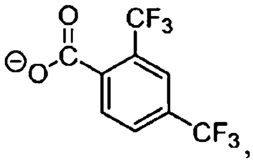,
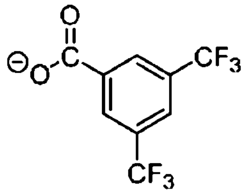,

(G57) (G58) (G59)

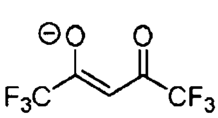,
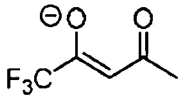,
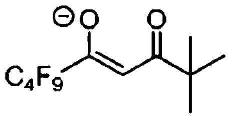,

(G60) (G61) (G62)

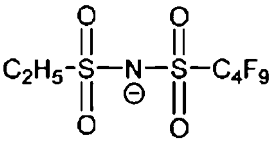,
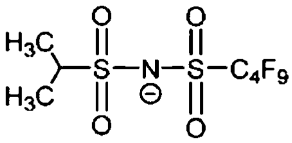,
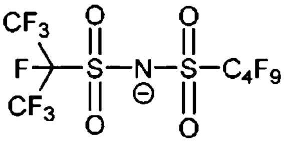,

(G63) (G64) (G65)

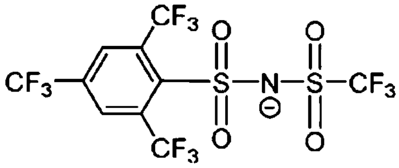,
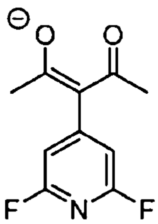,
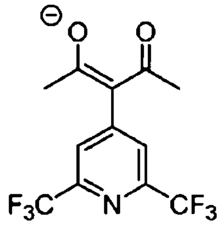,

(G66) (G67) (G68)

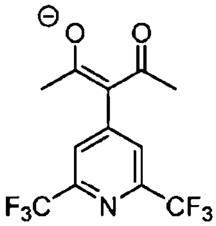 (G69),
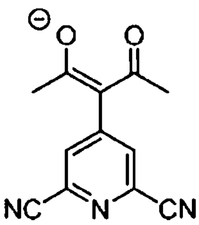 (G70),
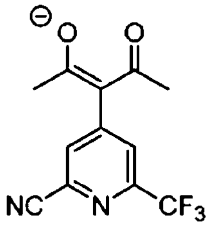 (G71),
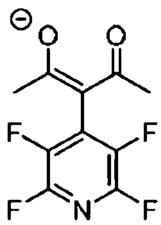 (G72),

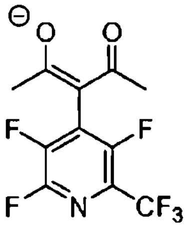 (G73),
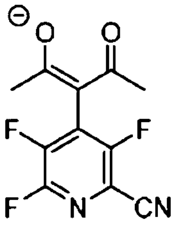 (G74),
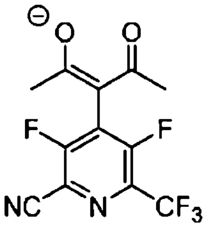 (G75),
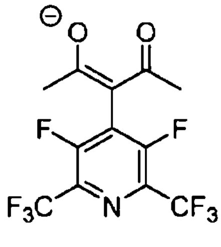 (G76),

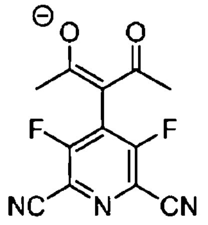 (G77), 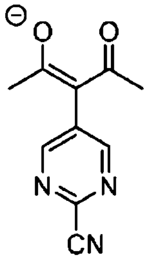 (G78), 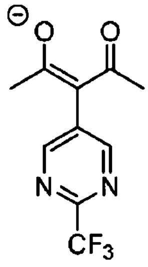 (G79), 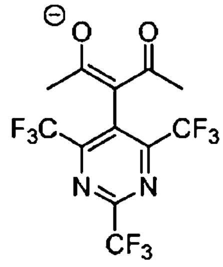 (G80),

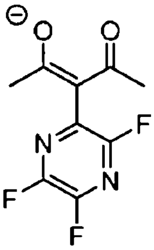 (G81), 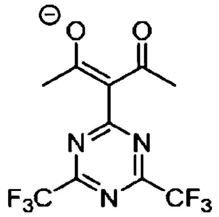 (G82), 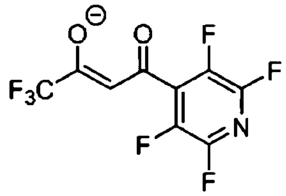 (G83),

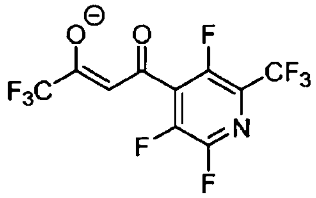 (G84), 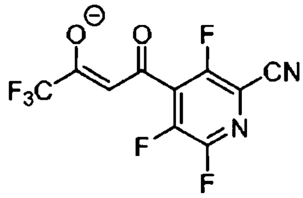 (G85), 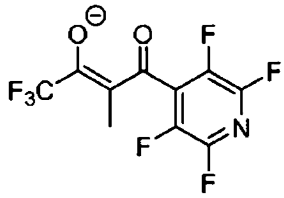 (G86),

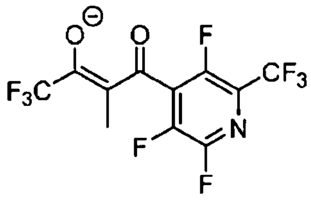 (G87), 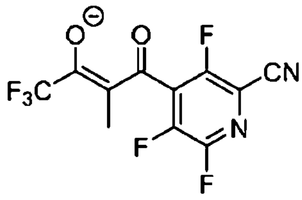 (G88), 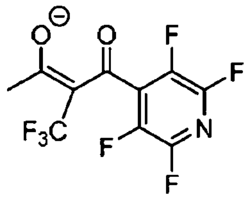 (G89),

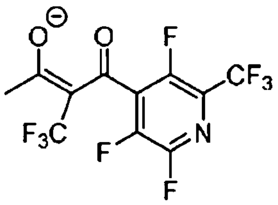 (G90), 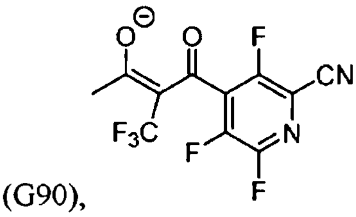 (G91), 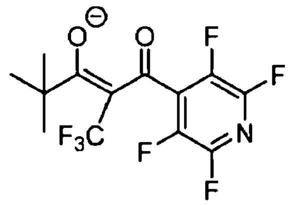 (G92),

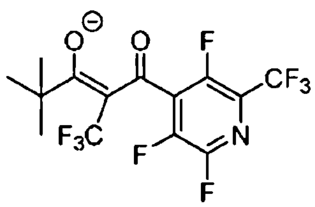 (G93), 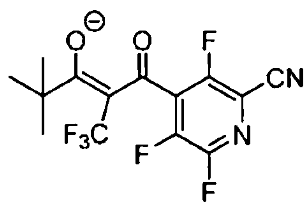 (G94),

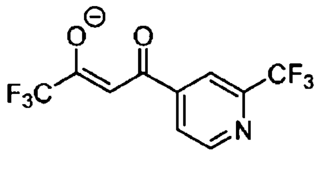 (G95), 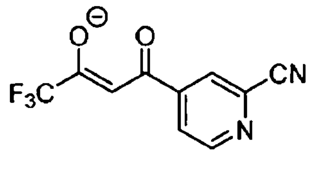 (G96),

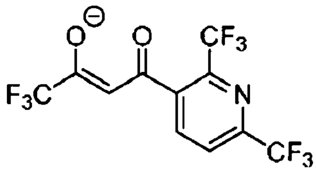 (G97), 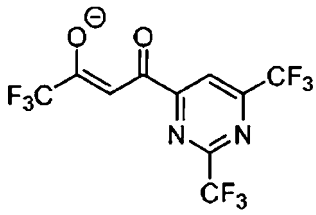 (G98),

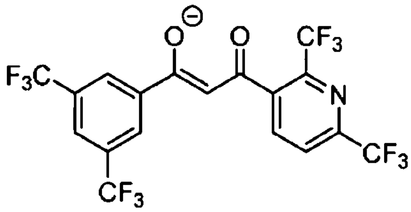 (G99), 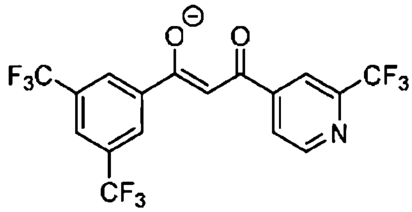 (G100),

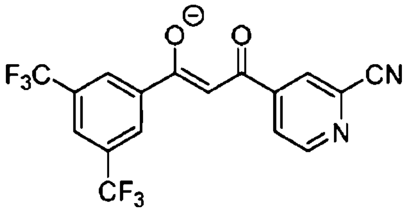 (G101), 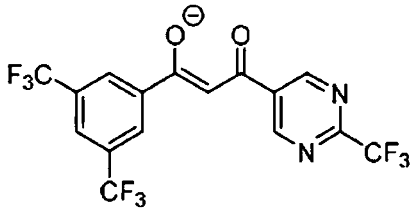 (G102),

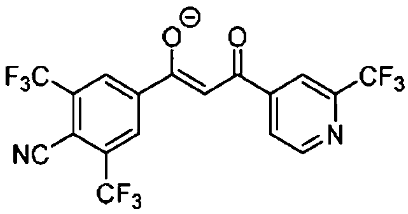 (G103),

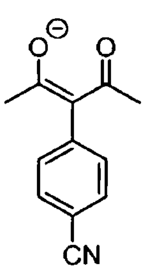 (G104), 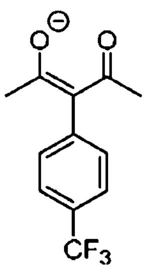 (G105), 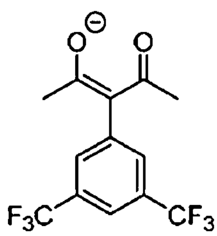 (G106), 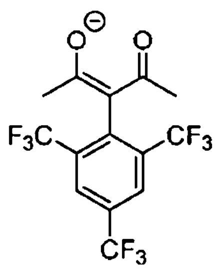 (G107),

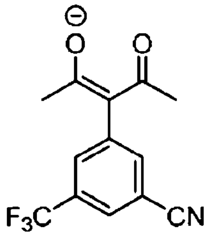 (G108), 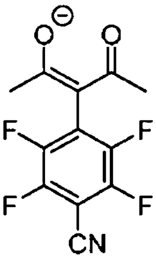 (G109), 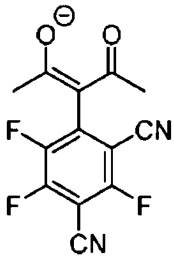 (G110), 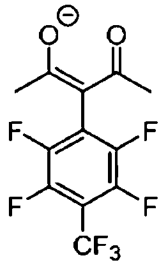 (G111),

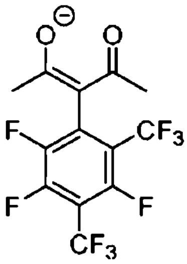 (G112), 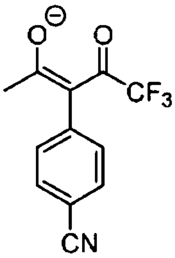 (G113), 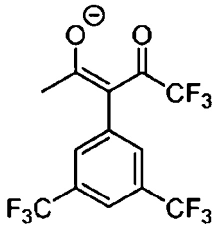 (G114),

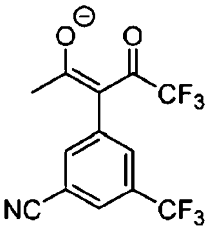 (G115), 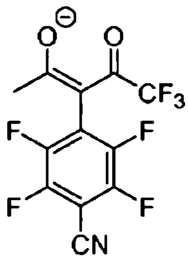 (G116), 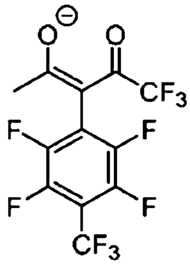 (G117),

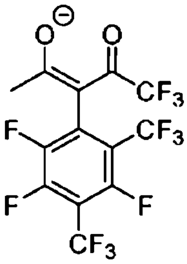 (G118),

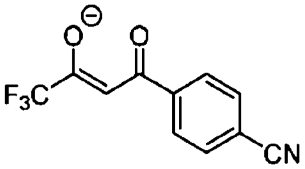 (G119), 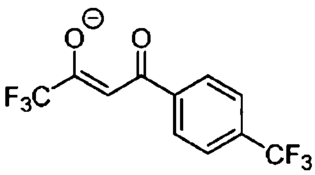 (G120),

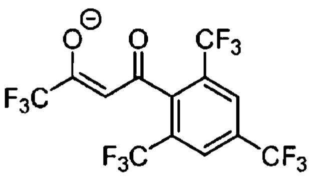 (G121), 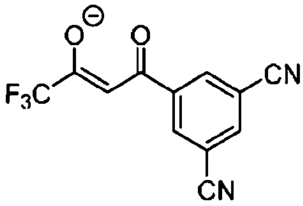 (G122),

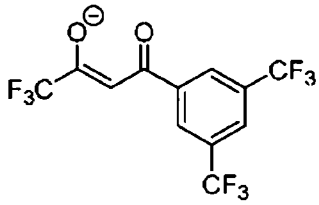 (G123), 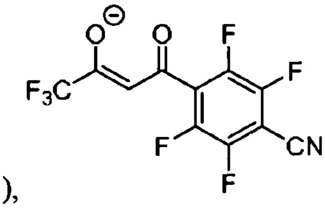 (G124),

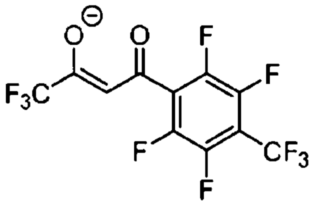 (G125), 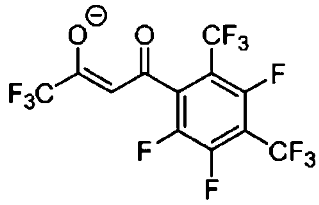 (G126),

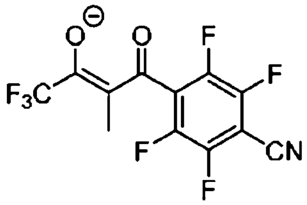 (G127), 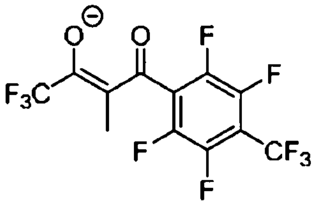 (G128),

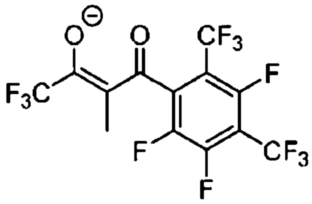 (G129), 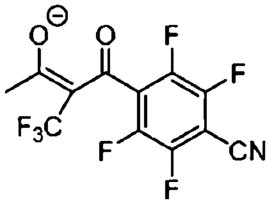 (G130), 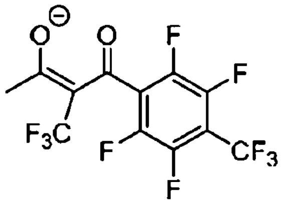 (G131),

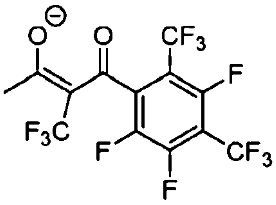 (G132), 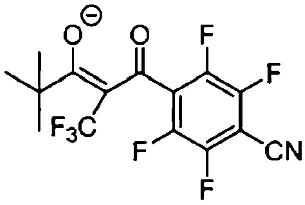 (G133),

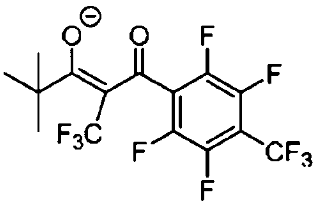 (G134), 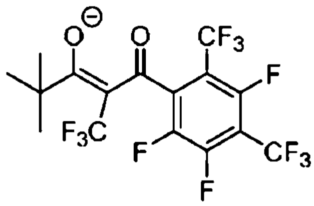 (G135),

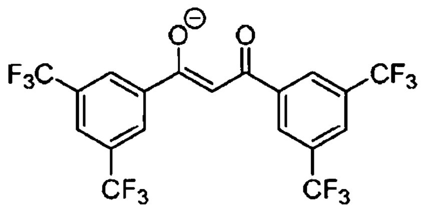 (G135), 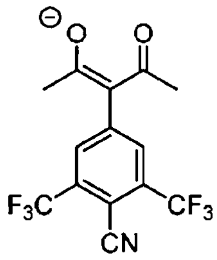 (G136), 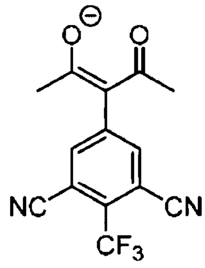 (G137),

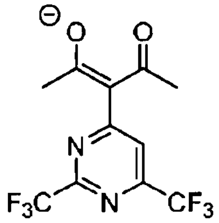 (G138), 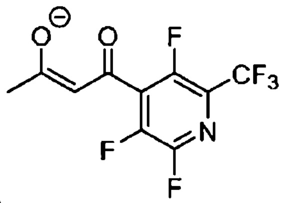 (G139) und 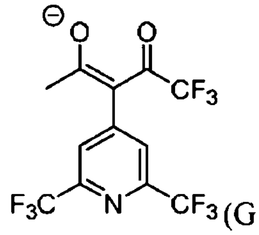 (G140).

**10.** Organische elektronische Vorrichtung (100) nach einem der Ansprüche 1 oder 9, wobei die Halbleiterschicht eine im Wesentlichen kovalente Matrixverbindung aufweist.

**11.** Organische elektronische Vorrichtung (100) nach einem der Ansprüche 1 oder 10, wobei die Halbleiterschicht in direktem Kontakt mit der Anodenschicht (120) steht.

**12.** Organische elektronische Vorrichtung (100) nach einem der Ansprüche 1 bis 11, wobei die Halbleiterschicht eine Lochinjektionsschicht (130) ist.

**13.** Organische elektronische Vorrichtung (100) nach einem der Ansprüche 1 bis 12, wobei die Anodenschicht (120) der organischen elektronischen Vorrichtung (100) außerdem eine dritte Anoden-Teilschicht (123) aufweist; wobei die dritte Anoden-Teilschicht (123) vorzugsweise ein transparentes leitfähiges Oxid aufweist, wobei die erste Anoden-Teilschicht (121) zwischen der dritten Anoden-Teilschicht (123) und der zweiten Anoden-Teilschicht (122) angeordnet ist.

**14.** Organische elektronische Vorrichtung (100) nach einem der Ansprüche 1 bis 13, wobei die organische elektronische Vorrichtung (100) ferner eine Lochtransportschicht (140) aufweist, wobei die Lochtransportschicht (140) zwischen der Halbleiterschicht und der mindestens einen fotoaktiven Schicht angeordnet ist.

**15.** Organische elektronische Vorrichtung (100) gemäß einem der vorhergehenden Ansprüche 1 bis 14, wobei die organische elektronische Vorrichtung (100) eine lichtemittierende Vorrichtung oder eine Anzeigevorrichtung ist.

## Revendications

**1.** Dispositif électronique organique (100) comprenant une couche d'anode (120), une couche de cathode (190), au moins une couche photoactive, et une couche semi-conductrice,

dans lequel la couche photoactive et la couche semi-conductrice sont disposées entre la couche d'anode (120) et la couche de cathode (190), dans lequel la couche semi-conductrice est disposée entre la couche photoactive et la couche d'anode (120);
dans lequel la couche d'anode (120) comprend une première sous-couche d'anode et une deuxième sous-couche d'anode, dans lequel la première sous-couche d'anode (121) comprend un premier métal ayant une fonction de travail dans la plage comprise entre ≥ 4 et ≤ 6 eV, et la deuxième sous-couche d'anode (122) comprend un oxyde conducteur transparent (TCO);
dans lequel la deuxième sous-couche d'anode (122) est disposée plus près de la couche semi-conductrice que la première sous-couche d'anode (121)
dans lequel la couche semi-conductrice comprend au moins un complexe métallique, dans lequel le complexe métallique comprend un cation métallique et au moins un ligand anionique, dans lequel le ligand anionique

comprend au moins quatre atomes liés de manière covalente, et
**caractérisé en ce que** la couche semi-conductrice comprend le complexe métallique dans une plage comprise entre ≥ 31 pour cent en poids et < 100 pour cent en poids, sur la base du poids total de la couche semi-conductrice;
dans lequel la couche semi-conductrice est exempte de phtalocyanine de cuivre.

**2.** Dispositif électronique organique (100) selon la revendication 1, dans lequel la couche semi-conductrice comprend le complexe métallique dans une plage comprise entre ≥ 31 pour cent en poids et ≤ 90 pour cent en poids, sur la base du poids total de la couche semi-conductrice.

**3.** Dispositif électronique organique (100) selon l'une quelconque des revendications 1 ou 2, dans lequel le complexe métallique est représenté par la formule (I)

$$Q_rM^{s\oplus}\,(L^{\ominus})_s \qquad (I)$$

dans laquelle

M est un cation métallique,
s est la valence de M;
L est un ligand anionique comprenant au moins 4 atomes liés de manière covalente, dans lequel le ligand anionique comprend au moins deux atomes choisis parmi les atomes de carbone,
s est un nombre entier compris entre 1 et 4;
Q est un ligand de charge neutre qui se coordonne au cation métallique M,
r est un nombre entier compris entre 0 et 2.

**4.** Dispositif électronique organique (100) selon la revendication 3, dans lequel le cation métallique M est choisi parmi les métaux alcalins, alcalino-terreux, de transition, de terres rares ou les métaux des groupes III à V.

**5.** Dispositif électronique organique (100) selon l'une quelconque des revendications 3 ou 4, dans lequel le ligand de charge neutre Q est choisi dans le groupe comprenant $H_2O$, les éthers mono- ou multidentés en $C_2$ à $C_{40}$ et les thioéthers en $C_2$ à $C_{40}$, les amines en $C_2$ à $C_{40}$, la phosphine en $C_2$ à $C_{40}$, le nitrile alkyle en $C_2$ à $C_{20}$ ou le nitriles aryle en $C_2$ à $C_{40}$, ou un composé selon la formule (II);

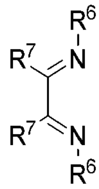
(II),

dans laquelle $R^6$ et $R^7$ sont choisis indépendamment parmi un alkyle en $C_1$ à $C_{20}$, un hétéroalkyle en $C_1$ à $C_{20}$, un aryle en $C_6$ à $C_{20}$, un hétéroaryle avec 5 à 20 atomes formant un cycle, un alkyle en $C_1$ à $C_{20}$ halogéné ou perhalogéné, un hétéroalkyle en $C_1$ à $C_{20}$ halogéné ou perhalogéné, un aryle en $C_6$ à $C_{20}$ halogéné ou perhalogéné, un hétéroaryle halogéné ou perhalogéné avec 5 à 20 atomes formant un cycle, ou au moins un $R^6$ et $R^7$ sont pontés et forment un cycle de 5 à 20 chaînons, ou les deux $R^6$ et/ou les deux $R^7$ sont pontés et forment un cycle de 5 à 40 chaînons ou forment un cycle de 5 à 40 chaînons comprenant une phénanthroline en $C_1$ à $C_{12}$ non substituée ou substituée.

**6.** Dispositif électronique organique (100) selon l'une quelconque des revendications 3 à 5, dans lequel le ligand anionique L est choisi à partir de la formule (III)

$$(R^1)_a\text{—}(A^1)_m\text{—}Z\text{—}(A^2)_n\text{—}(R^2)_b \qquad (III)$$

dans laquelle

m, et n sont choisis indépendamment parmi 0 et 1;

m + n≥1;
a et b sont choisis indépendamment parmi 0 et 1;
a+b≥1;
Z est choisi parmi $CR^3$, N, ou O;
if Z vaut O alors a vaut 0 lorsque m vaut 0 ou b vaut o lorsque n vaut 0;
$A^1$ et $A^2$ sont choisis indépendamment parmi C=O, C-O, SO, or $SO_2$;
$A^1$ et $A^2$ peuvent former ensemble un cycle avec Z;
$R^1$ et $R^2$ sont choisis indépendamment parmi un aryle en $C_6$ à $C_{24}$ substitué ou non substitué, un hétéroaryle en $C_2$ à $C_{24}$ substitué ou non substitué, un alkyle en $C_1$ à $C_{12}$ substitué ou non substitué, un carbocyclyle en $C_3$ à $C_{24}$ substitué ou non substitué, ou un hétérocyclyle en $C_2$ à $C_{24}$,
dans laquelle, dans le cas où $A^1$ et $A^2$ sont choisis parmi C=O ou C-O, $R^1$ et $R^2$ peuvent également être choisis parmi D et H,
dans laquelle les substituants sur $R^1$ et $R^2$ ont choisis indépendamment parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,
et dans lequel les substituants de l'alkyle en $C_1$ à $C_{12}$ substitué ou non substitué, de l'alcoxy en $C_1$ à $C_{12}$ substitué ou non substitué, de l'aryle en $C_6$ à $C_{18}$ substitué ou non substitué, et de l'hétéroaryle en $C_2$ à $C_{18}$ substitué ou non substitué sont choisis parmi un halogène, F, Cl, CN, un alkyle en $C_1$ à $C_6$, un alkyle en $C_1$ à $C_6$ partiellement ou totalement fluoré, $CF_3$, $OCH_3$, un alcoxy en $C_1$ à $C_6$ totalement fluoré, ou $OCF_3$;
et
$R^3$ est choisi parmi H, D, CN, un aryle en $C_6$ à $C_{24}$ substitué ou non substitué, un hétéroaryle en $C_2$ à $C_{24}$ substitué ou non substitué, un alkyle en $C_1$ à $C_{12}$ substitué ou non substitué, un carbocyclyle en $C_3$ à $C_{24}$ substitué ou non substitué, un hétérocyclyle en $C_2$ à $C_{24}$ substitué ou non substitué;
dans laquelle les substituants sur $R^3$ sont choisis parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,
et dans lequel les substituants de l'alkyle en $C_1$ à $C_{12}$ substitués ou non substitué, de l'alcoxy en $C_1$ à $C_{12}$ substitué ou non substitué, de l'aryle en $C_6$ à $C_{18}$ substitué ou non substitué, et de l'hétéroaryle en $C_2$ à $C_{18}$ substitué ou non substitué sont choisis parmi un halogène, F, Cl, CN, un alkyle en $C_1$ à $C_6$, un alkyle en $C_1$ à $C_6$ partiellement ou totalement fluoré, $CF_3$, $OCH_3$, un alcoxy en $C_1$ à $C_6$ totalement fluoré, ou, $OCF_3$.

**7.** Dispositif électronique organique (100) selon l'une quelconque des revendications 3 à 6, dans lequel le complexe métallique selon la formule (I) est choisi parmi l'une des formules (IVa) à (IVd):

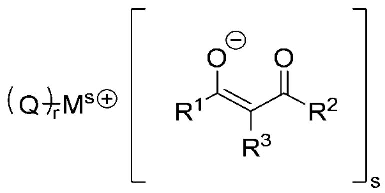
(IVa)

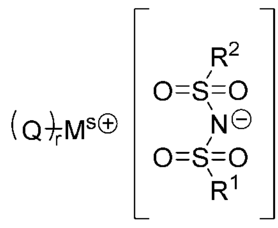
(IVb)

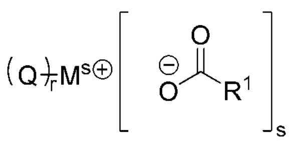
(IVc)

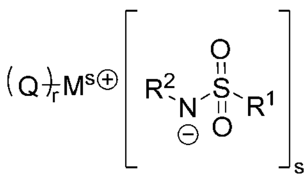
(IVd)

dans laquelle

$R^1$ et $R^2$ sont choisis indépendamment parmi un aryle en $C_6$ à $C_{24}$ substitué ou non substitué, un hétéroaryle en $C_2$ à $C_{24}$ substitué ou non substitué, un alkyle en $C_1$ à $C_{12}$ substitué ou non substitué, un carbocyclyle en $C_3$ à $C_{24}$ substitué ou non substitué, ou un hétérocyclyle en $C_2$ à $C_{24}$,
dans laquelle pour la formule (IVa) $R^1$ et $R^2$ peuvent également être choisis parmi D et H,

dans laquelle les substituants sur $R^1$ et $R^2$ sont choisis indépendamment parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,

et dans laquelle les substituants de l'alkyle en $C_1$ à $C_{12}$ substitué ou non substitué, de l'alcoxy en $C_1$ à $C_{12}$ substitué ou non substitué, de l'aryle en $C_6$ à $C_{18}$ substitué ou non substitué, et de l'hétéroaryle en $C_2$ to $C_{18}$ substitué ou non substitué sont choisis parmi un halogène, F, Cl, CN, un alkyle en $C_1$ à $C_6$, un alkyle en $C_1$ à $C_6$ partiellement ou totalement fluoré, $CF_3$, $OCH_3$, un alcoxy en $C_1$ à $C_6$ totalement fluoré, ou $OCF_3$;

et

$R^3$ est choisi parmi H, D, CN, un aryle en $C_6$ à $C_{24}$ substitué ou non substitué, un hétéroaryle en $C_2$ à $C_{24}$ substitué ou non substitué, un alkyle en $C_1$ à $C_{12}$ substitué ou non substitué, un carbocyclyle en $C_3$ à $C_{24}$ substitué ou non substitué, ou un hétérocyclyle en $C_2$ à $C_{24}$ substitué ou non substitué,

les substituants sur $R^3$ sont choisis parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,

et dans laquelle les substituants de l'alkyle en $C_1$ à $C_{12}$ substitué ou non substitué, de l'alcoxy en $C_1$ à $C_{12}$ substitué ou non substitué, de l'aryle $C_6$ à $C_{18}$ substitué ou non substitué, et de l'hétéroaryle en $C_2$ to $C_{18}$ substitué ou non substitué sont choisis parmi un halogène, F, Cl, CN, un alkyle en $C_1$ à $C_6$, un alkyle en $C_1$ to $C_6$ partiellement ou totalement fluoré, $CF_3$, $OCH_3$, un alcoxy en $C_1$ à $C_6$ totalement fluoré, or $OCF_3$.

**8.** Dispositif électronique organique (100) selon l'une quelconque des revendications 3 à 7, dans lequel le ligand anionique L est choisi parmi la formule (VIa) ou VIb):

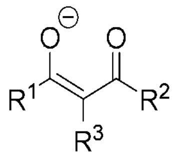 (VIa)

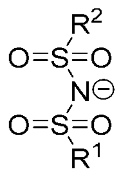 (VIb)

dans laquelle

$R^1$ and $R^2$ sont choisis indépendamment parmi un aryle en $C_6$ à $C_{24}$ substitué ou non substitué, un hétéroaryle en $C_2$ à $C_{24}$ substitué ou non substitué, un alkyle en $C_1$ to $C_{12}$ substitué ou non substitué, un carbocyclyle en $C_3$ à $C_{24}$ substitué ou non substitué, ou hétérocyclyle en $C_2$ à $C_{24}$,

dans laquelle pour la formule (VIa) $R^1$ et $R^2$ peuvent également être choisis parmi D ou H,

dans laquelle les substituants sur $R^1$ et $R^2$ sont choisis indépendamment parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,

et dans lequel les substituants de l'alkyle en $C_1$ à $C_{12}$ substitué ou non substitué, de l'alcoxy en $C_1$ à $C_{12}$ substitué ou non substitué, de l'aryle $C_6$ à $C_{18}$ substitué ou non substitué, et de l'hétéroaryle en $C_2$ to $C_{18}$ substitué ou non substitué sont choisis parmi un halogène, F, Cl, CN, un alkyle en $C_1$ à $C_6$, un alkyle en $C_1$ to $C_6$ partiellement ou totalement fluoré, $CF_3$, $OCH_3$, un alcoxy en $C_1$ à $C_6$ totalement fluoré, or $OCF_3$;

et

$R^3$ est choisi parmi H, D, CN, un aryle en $C_6$ à $C_{24}$ substitué ou non substitué, un hétéroaryle en $C_2$ à $C_{24}$ substitué ou non substitué, un alkyle en $C_1$ à $C_{12}$ substitué ou non substitué, un carbocyclyle en $C_3$ à $C_{24}$ substitué ou non substitué, ou un hétérocyclyle en $C_2$ à $C_{24}$ substitué ou non substitué,

les substituants sur $R^3$ sont choisis parmi un halogène, F, Cl, CN, un alkyle en $C_1$ à $C_{12}$ substitué ou non substitué, un alkyle en $C_1$ à $C_{12}$ partiellement ou totalement fluoré, un alcoxy en $C_1$ à $C_{12}$ substitué ou non substitué, un alcoxy en $C_1$ à $C_{12}$ partiellement ou totalement fluoré, un aryle en $C_6$ à $C_{18}$ substitué ou non substitué, et un hétéroaryle en $C_2$ à $C_{18}$ substitué ou non substitué,

et dans lequel les substituants de l'alkyle en $C_1$ à $C_{12}$ substitué ou non substitué, de l'alcoxy en $C_1$ à $C_{12}$ substitué ou non substitué, de l'aryle $C_6$ à $C_{18}$ substitué ou non substitué, et de l'hétéroaryle en $C_2$ to $C_{18}$ substitué ou non substitué sont choisis parmi un halogène, F, Cl, CN, un alkyle en $C_1$ à $C_6$, un alkyle en $C_1$ to $C_6$ partiellement ou totalement fluoré, $CF_3$, $OCH_3$, un alcoxy en $C_1$ à $C_6$ totalement fluoré, or $OCF_3$.

**9.** Dispositif électronique organique (100) selon l'une quelconque des revendications 1 à 8, dans lequel le ligand anionique L est choisi parmi l'une des formules suivantes G1 à G140:

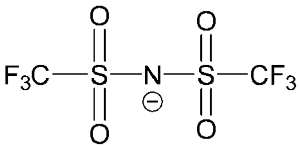
,
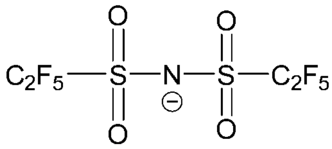
,
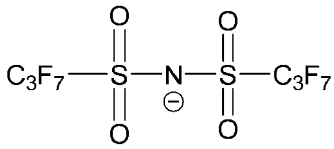
,

(G1) (G2) (G3)

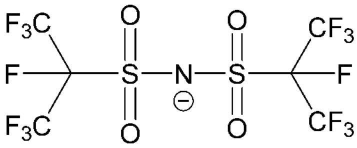
,
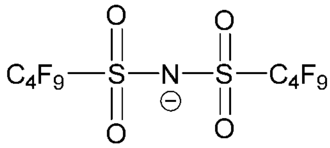
,
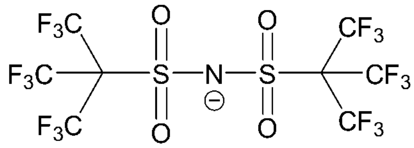
,

(G4) (G5) (G6)

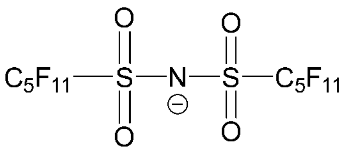
,
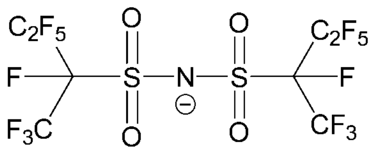
,
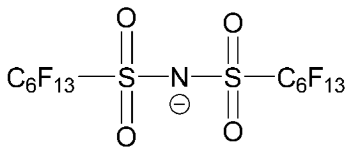
,

(G7) (G8) (G9)

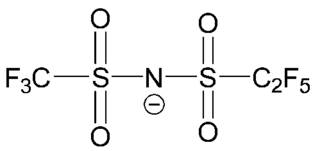
,
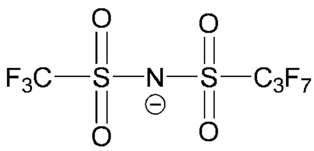
,
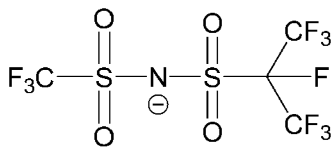
,

(G10) (G11) (G12)

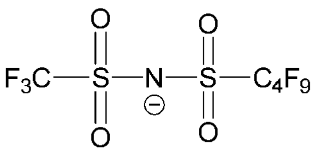
,
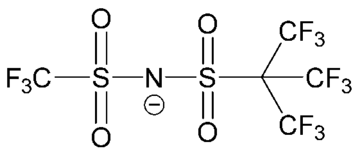
,
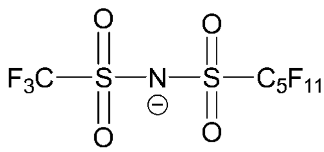
,

(G13) (G14) (G15)

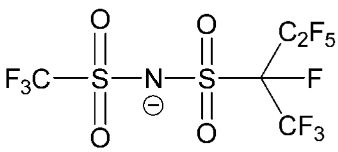
,
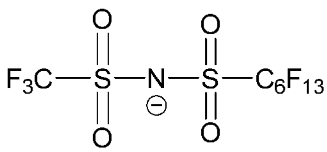
,

(G16) (G17)

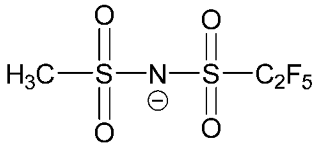,
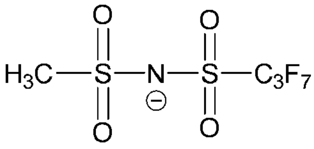,
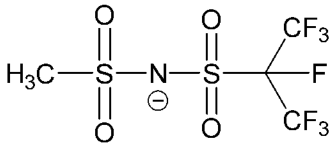,

(G18) (G19) (G20)

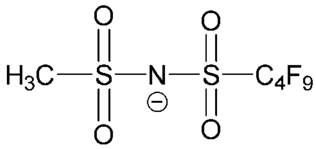,
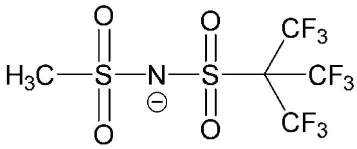,
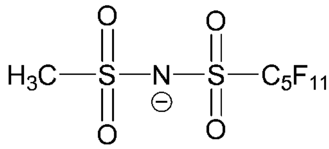,

(G21) (G22) (G23)

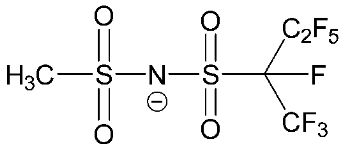,
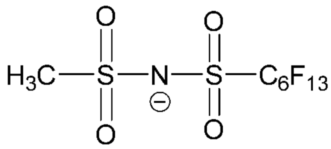,

(G24) (G25)

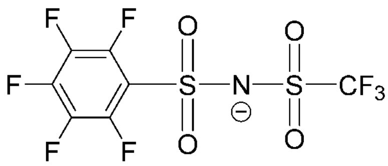,
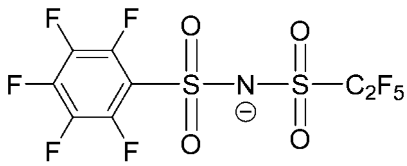,

(G26) (G27)

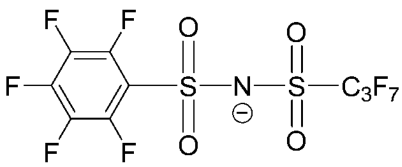,

(G28)

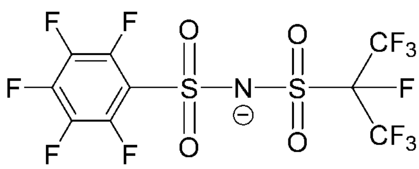,
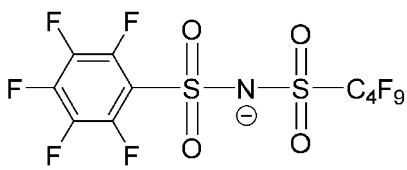,

(G29) (G30)

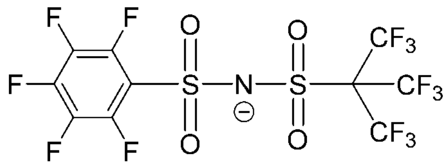, 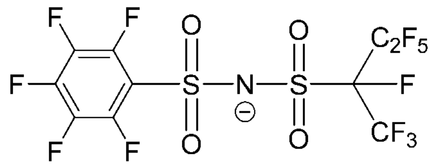,

(G31) (G32)

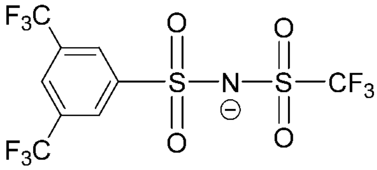, 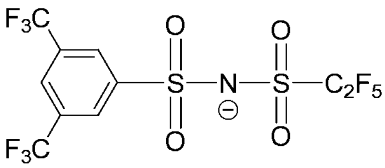, 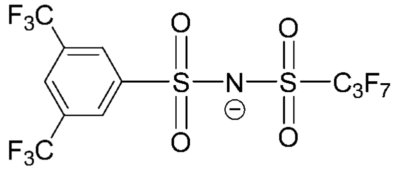,

(G33) (G34) (G35)

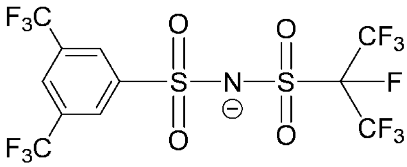, 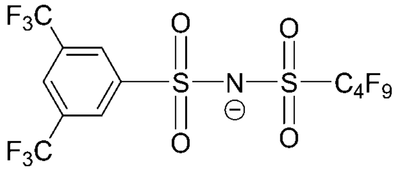,

(G36) (G37)

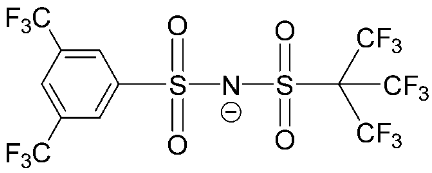,

(G38)

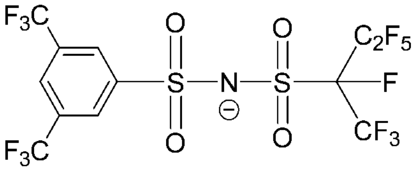, 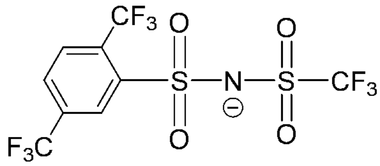,

(G39) (G40)

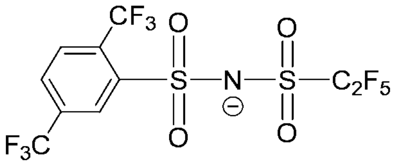,

(G41)

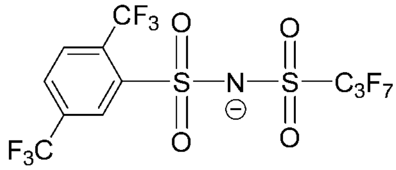,
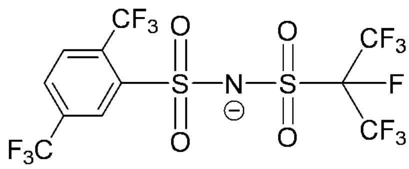,

(G42) (G43)

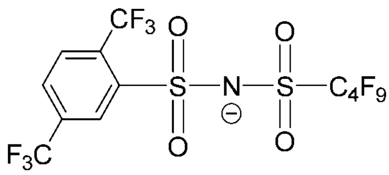,
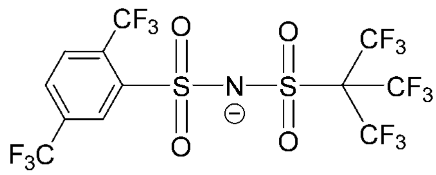

(G44) (G45)

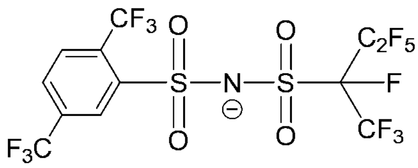,
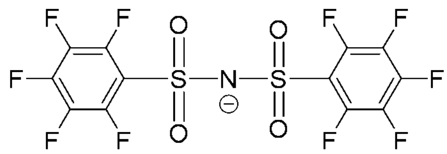

(G46) (G47)

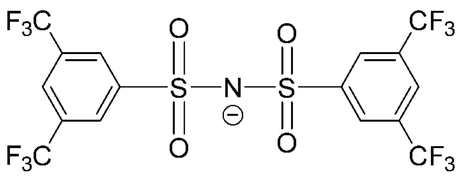,
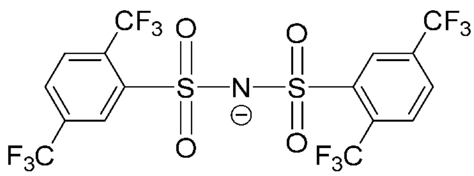

(G48) (G49)

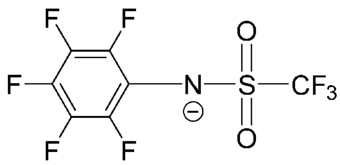,
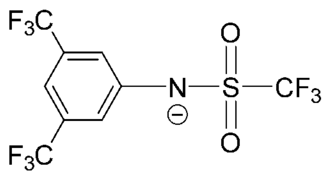,
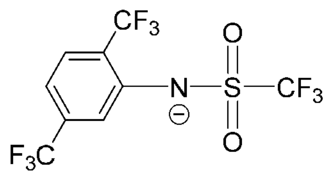,

(G50) (G51) (G52)

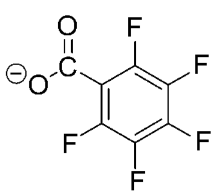,
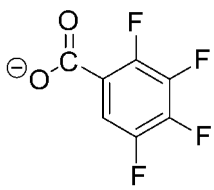,
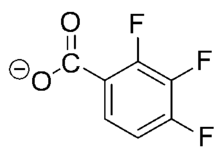,
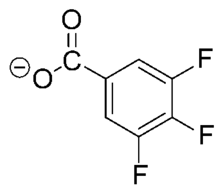,

(G53) (G54) (G55) (G56)

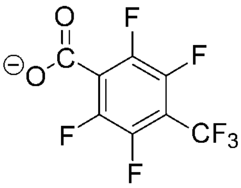,
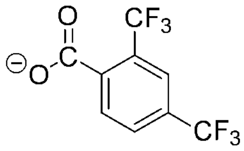,
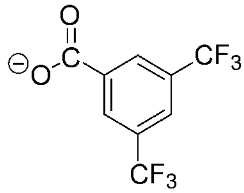,

(G57) (G58) (G59)

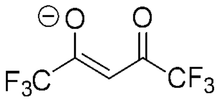,
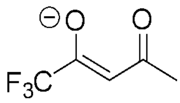,
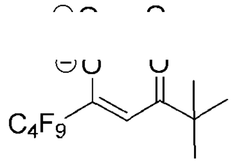,

(G60) (G61) (G62)

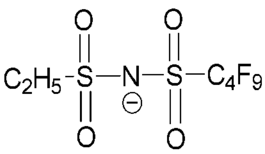,
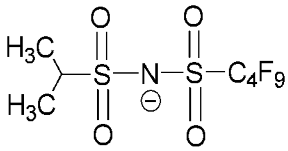,
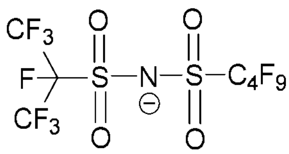,

(G63) (G64) (G65)

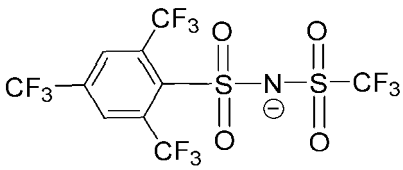,
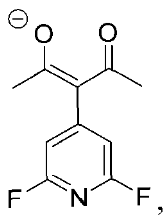,
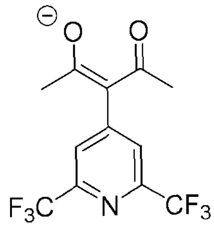,

(G66) (G67) (G68)

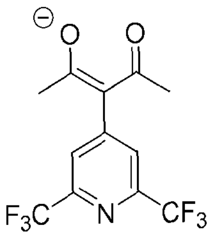 (G69),
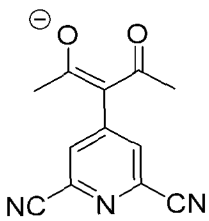 (G70),
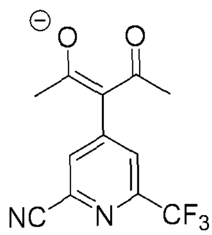 (G71),
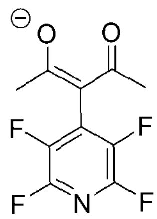 (G72),

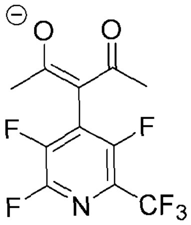 (G73),
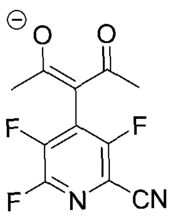 (G74),
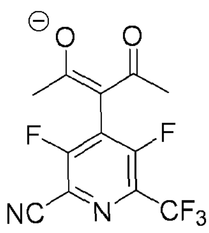 (G75),
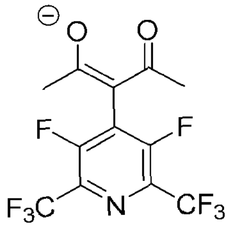 (G76),

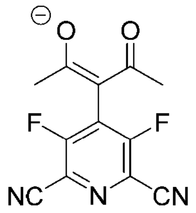 (G77), 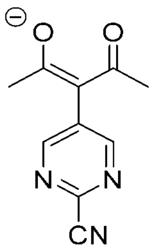 (G78), 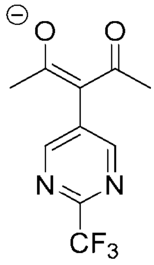 (G79), 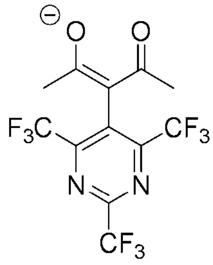 (G80),

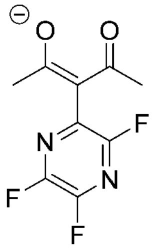 (G81), 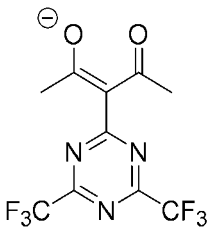 (G82), 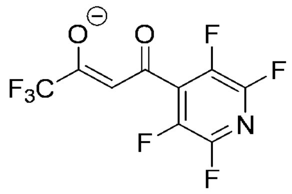 (G83),

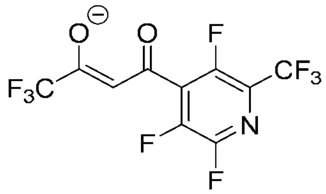 (G84), 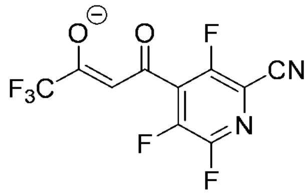 (G85), 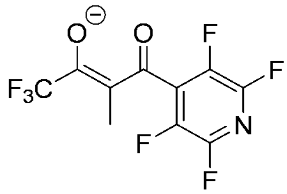

(G86),

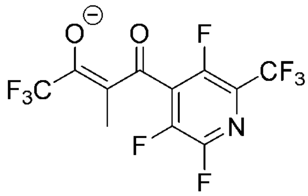 (G87), 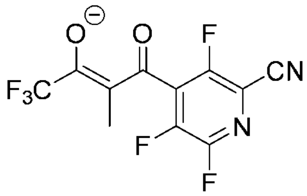 (G88), 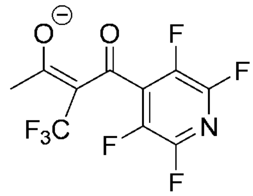 (G89),

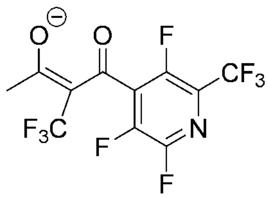 (G90), 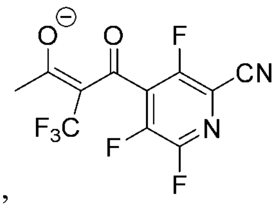 (G91), 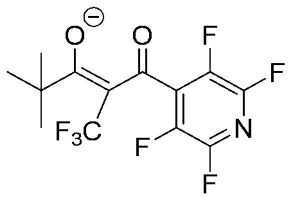 (G92),

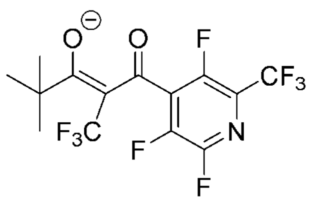 (G93), 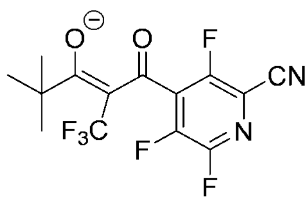 (G94),

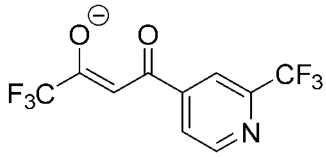 (G95), 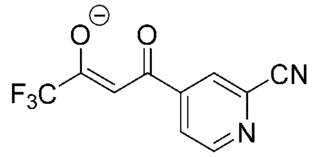 (G96),

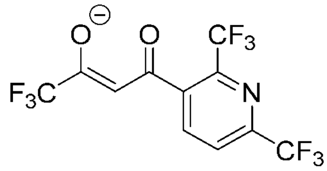 (G97), 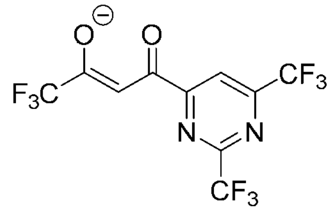 (G98),

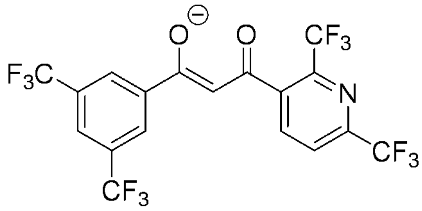 (G99), 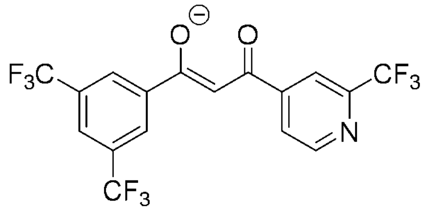 (G100),

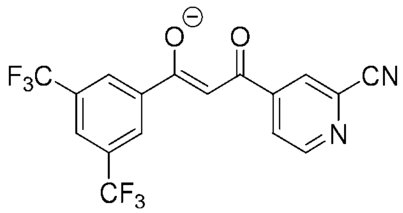 (G101), 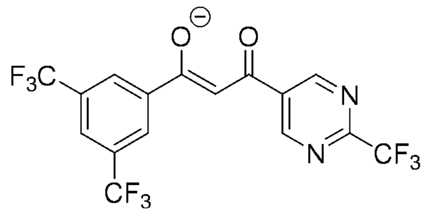 (G102),

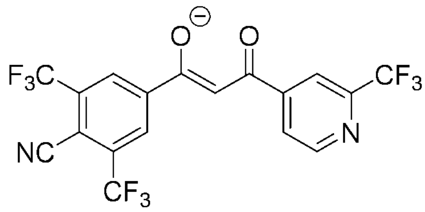 (G103),

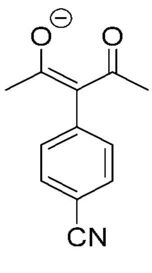 (G104), 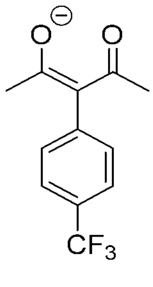 (G105), 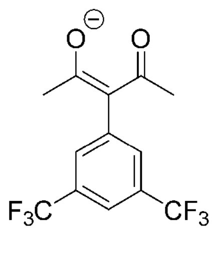 (G106), 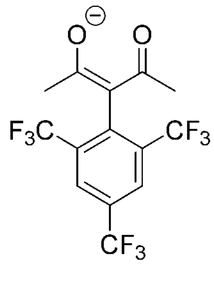 (G107),

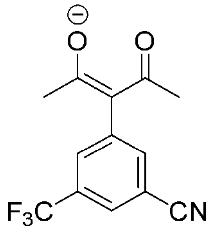 (G108), 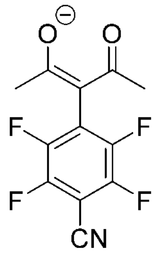 (G109), 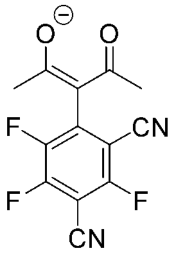 (G110), 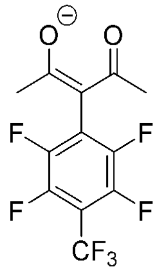 (G111),

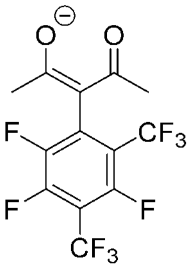 (G112), 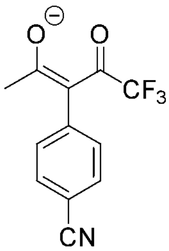 (G113), 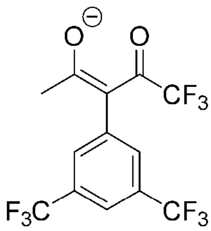 (G114),

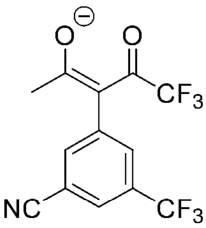 (G115), 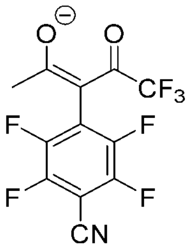 (G116), 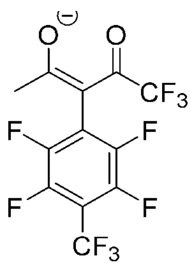 (G117),

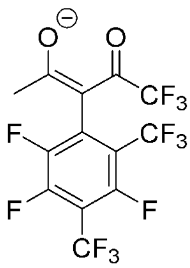 (G118),

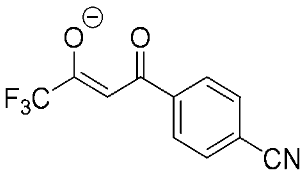 (G119), 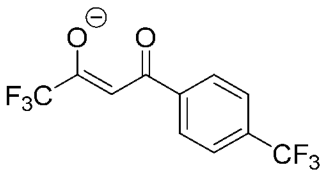 (G120),

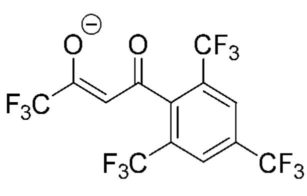 (G121), 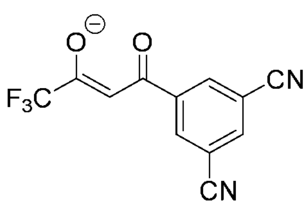 (G122),

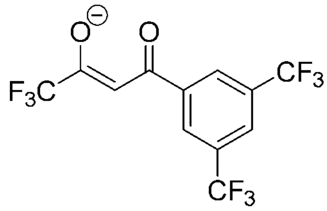 (G123), 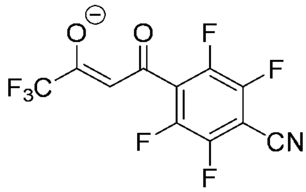 (G124),

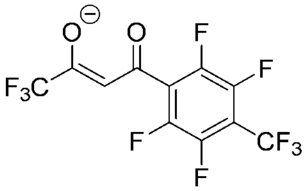 (G125), 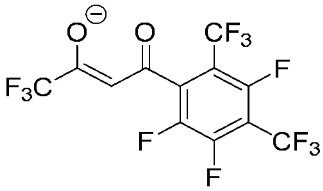 (G126),

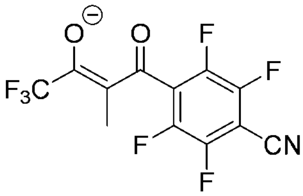 (G127), 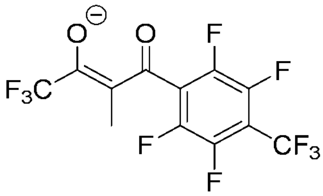 (G128),

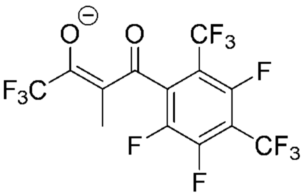 (G129), 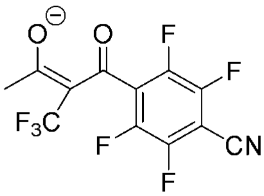 (G130), 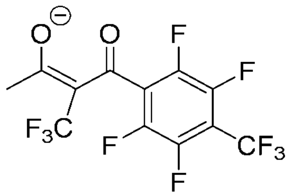 (G131),

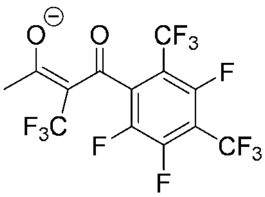 (G132), 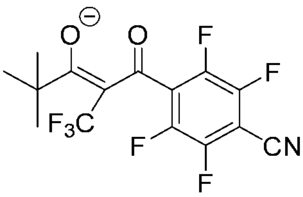 (G133),

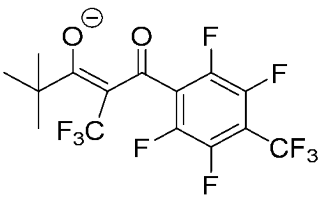 (G134), 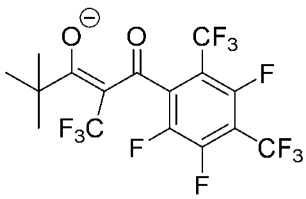 (G135),

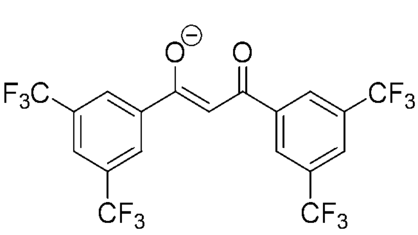 (G135), 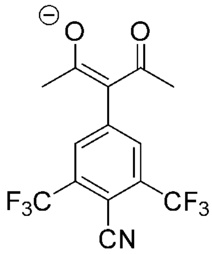 (G136), 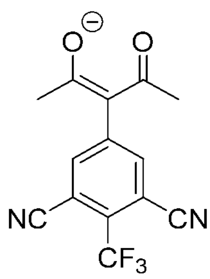 (G137),

et 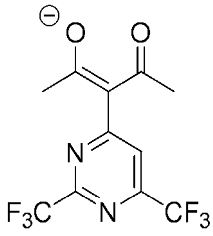 (G138) , 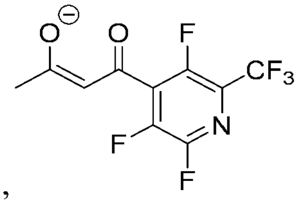 (G139), et. 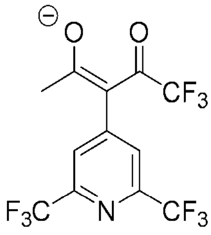 (G140).

**10.** Dispositif électronique organique (100) selon l'une quelconque des revendications 1 ou 9, dans lequel la couche semi-conductrice comprend un composé matriciel essentiellement covalent.

**11.** Dispositif électronique organique (100) selon l'une quelconque des revendications 1 ou 10, dans lequel la couche semi-conductrice est en contact direct avec la couche d'anode (120).

**12.** Dispositif électronique organique (100) selon l'une quelconque des revendications 1 à 11, dans lequel la couche semi-conductrice est une couche d'injection de trous (130).

**13.** Dispositif électronique organique (100) selon l'une quelconque des revendications 1 à 12, dans lequel la couche d'anode (120) du dispositif électronique organique (100) comprend en outre une troisième sous-couche d'anode (123); dans lequel la troisième sous-couche d'anode (123) comprend de préférence un oxyde conducteur transparent, dans lequel la première sous-couche d'anode (121) est disposée entre la troisième sous-couche d'anode (123) et la deuxième sous-couche d'anode (122).

**14.** Dispositif électronique organique (100) selon l'une quelconque des revendications 1 à 13, dans lequel le dispositif électronique organique (100) comprend en outre une couche de transport de trous (140), dans lequel la couche de transport de trous (140) est disposée entre la couche semi-conductrice et ladite au moins une couche photoactive.

**15.** Dispositif électronique organique (100) selon l'une des revendications précédentes 1 à 14, dans lequel le dispositif électronique organique (100) est un dispositif émetteur de lumière ou un dispositif d'affichage.

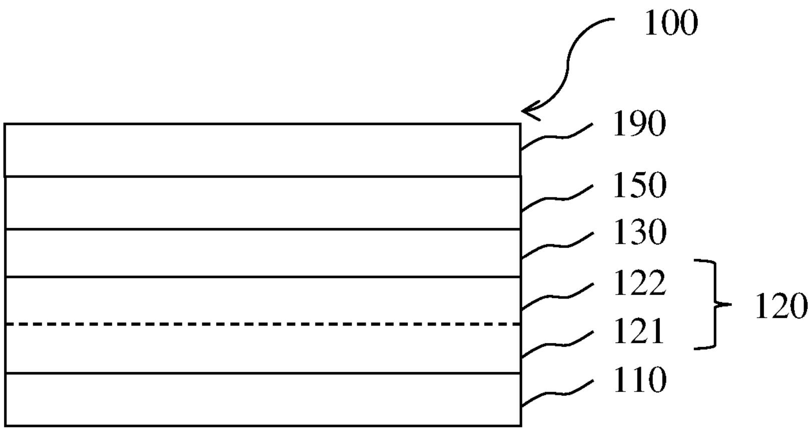
100
190
150
130
122
121
120
110

Fig.1

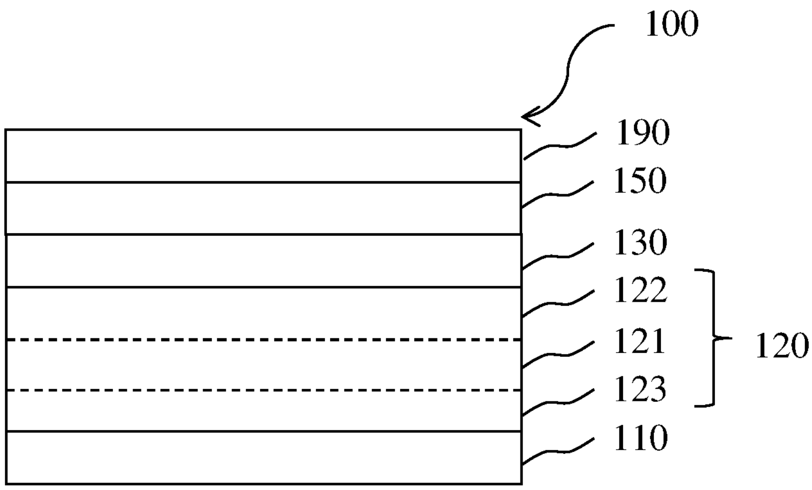
100
190
150
130
122
121
123
120
110

Fig.2

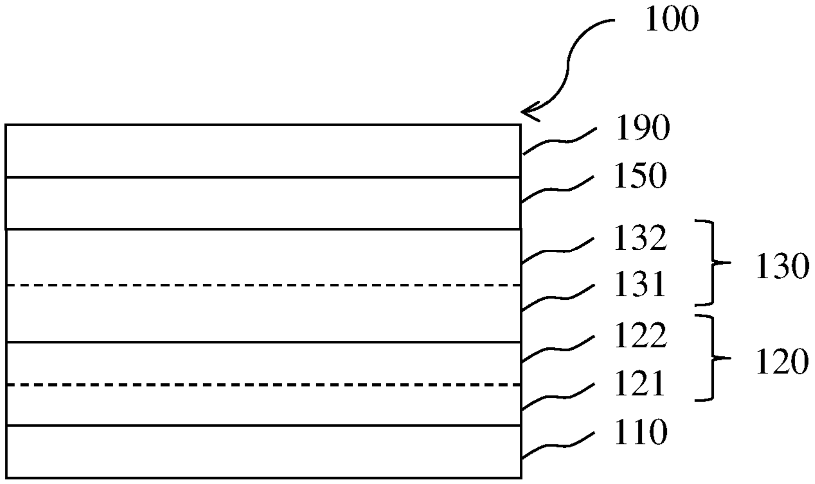
100
190
150
132
131
130
122
121
120
110

Fig.3

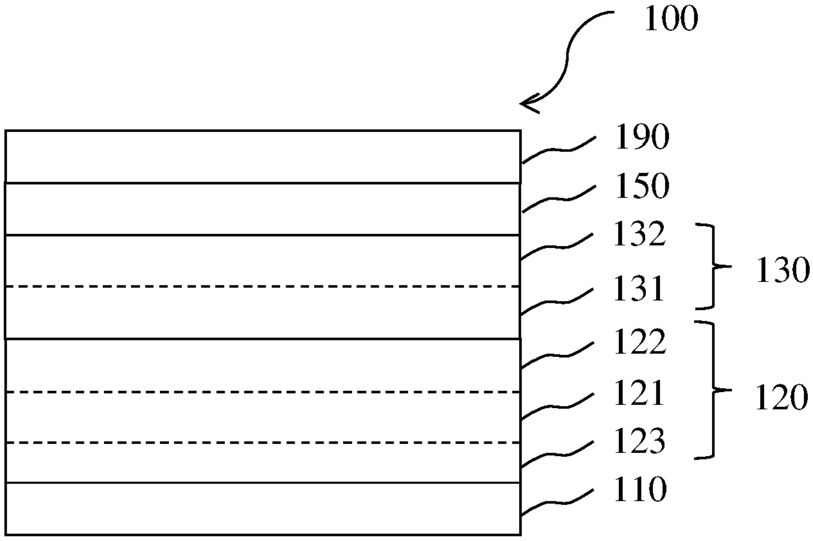
100
190
150
132
131
130
122
121
123
120
110

Fig.4

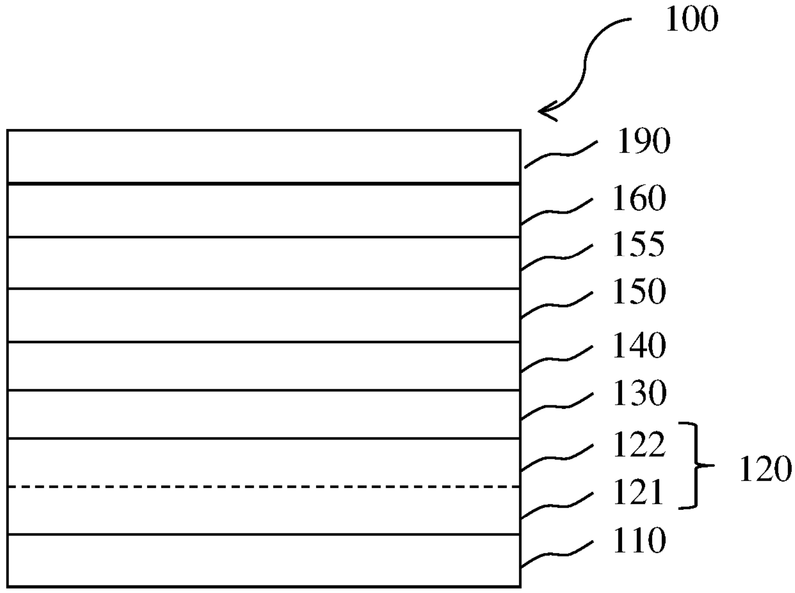
100
190
160
155
150
140
130
122
121
120
110

Fig.5

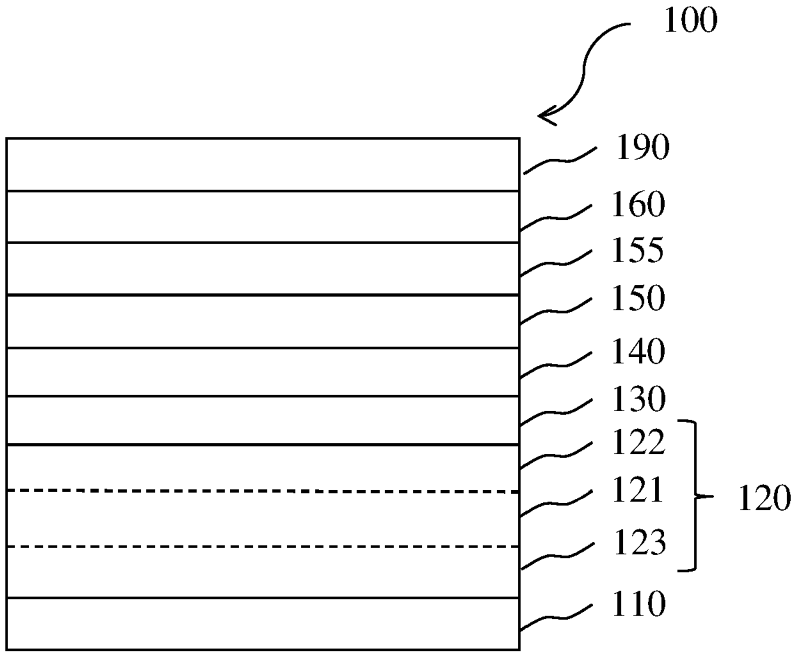
100
190
160
155
150
140
130
122
121
123
120
110

Fig.6

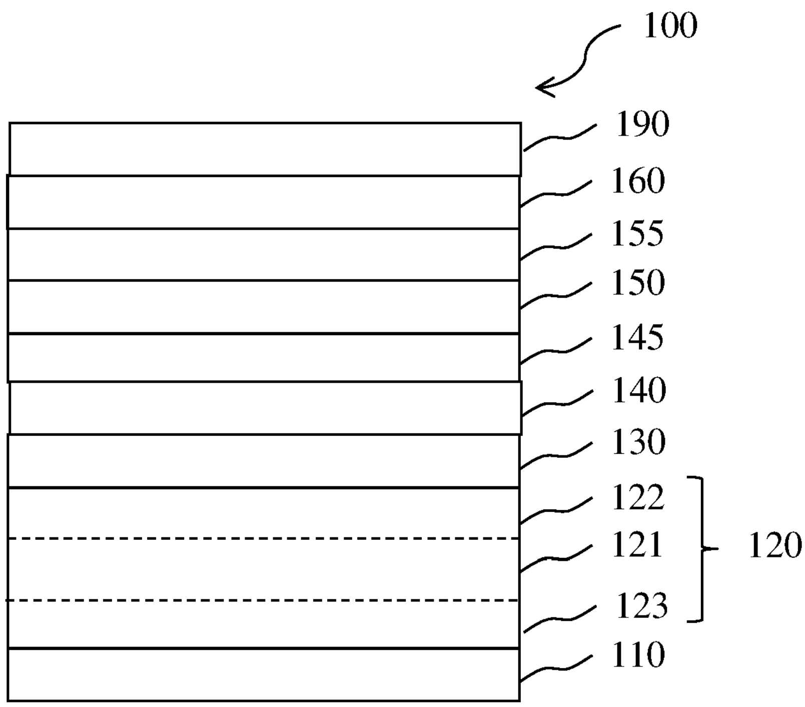


Fig.7

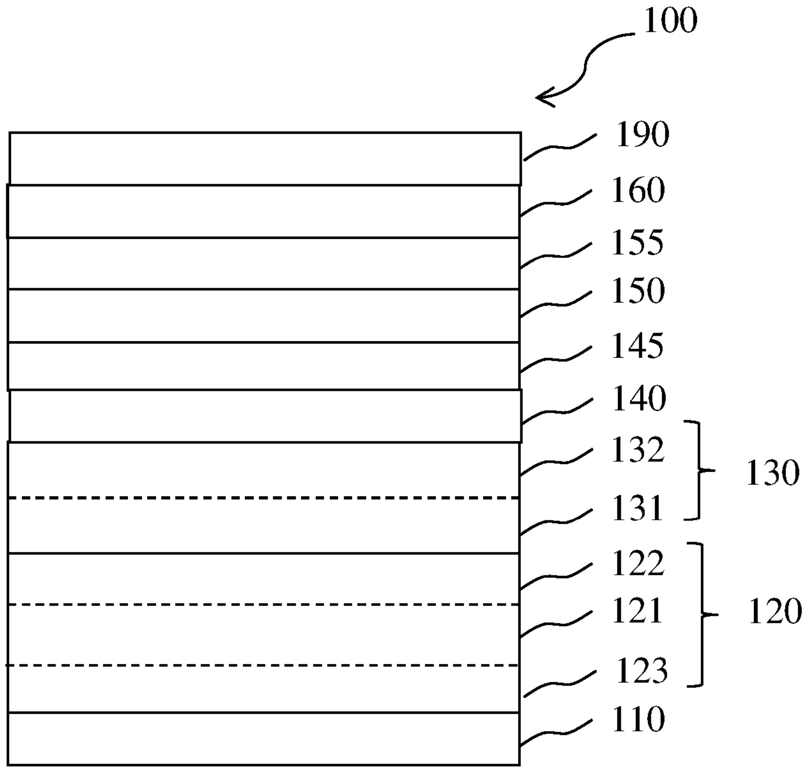


Fig.8

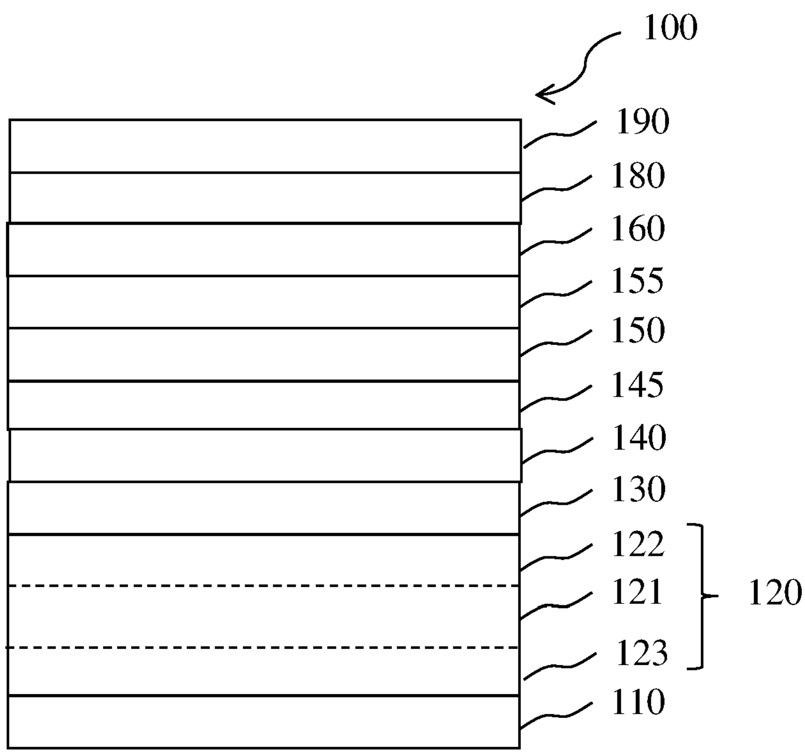


Fig.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3945090 A1
- EP 3945125 A1
- EP 3883003 A1
- EP 4064379 A1
- US 2011031876 A1
- EP 2722908 A1


### Non-patent literature cited in the description


- CRC Handbook of Chemistry and Physics. 2008, 12-114
- **YASUHIKO SHIROTA** ; **HIROSHI KAGEYAMA**. Chem. Rev.. 2007, vol. 107, 953-1010